# EUROPEAN PATENT SPECIFICATION

(11) **EP 1 755 002 B1**
(45) Date of publication and mention of the grant of the patent: **04.05.2016**
(21) Application number: 06017167.5
(22) Date of filing: 17.08.2006
(51) Int. Cl.: G03F 7/30, B41C 1/10

(54) **Manufacturing method of lithographic printing plates**
Verfahren zur Herstellung von Flachdruckplatten
Procédé pour la fabrication de plaques d'impression

(30) Priority: 18.08.2005 JP 2005237774; 18.05.2006 JP 2006139200
(43) Date of publication of application: 21.02.2007
(60) Divisional application: 10183496.8
(73) Proprietor: FUJIFILM Corporation, Minato-ku Tokyo (JP)
(72) Inventor: Adachi, Keiichi, Shizuoka (JP)
(74) Representative: Hoffmann Eitle

(56) References cited:
- EP-A- 1 298 495
- EP-A- 1 356 929
- EP-A- 1 388 760
- EP-A- 1 621 339
- EP-A2- 0 415 392
- EP-A2- 1 061 418
- EP-A2- 1 091 253
- US-A- 3 019 105

## Description

### Background of the Invention

### 1. Field of the Invention

The present invention relates to a method for manufacturing a lithographic printing plate and a manufacturing apparatus of the same.

### 2. Description of the Related Art

A lithographic printing plate generally comprises a lipophilic image area that receives ink and a hydrophilic non-image area that receives a fountain solution in printing. Lithographic printing is a printing method of making difference in ink-adhering property on the surface of a lithographic printing plate with the lipophilic image area of the lithographic printing plate as the ink-receptive area and the hydrophilic non-image area as the fountain solution-receptive area (ink-repellent area) by making use of the natures of water and printing ink of repelling to each other, adhering ink only on the image area, and transferring the ink to the material to be printed, e.g., paper.

For manufacturing such a lithographic printing plate, a lithographic printing plate precursor (a PS plate) comprising a hydrophilic support having provided thereon a lipophilic photosensitive resin layer (an image-recording layer) has so far been widely used. A lithographic printing plate is generally obtained by a plate-making method of exposing a lithographic printing plate precursor through an original image of a lith film and the like, and then dissolving and removing other unnecessary image-recording layer with an alkali aqueous solution or an organic solvent for leaving the area to become an image area of the image-recording layer to thereby bare a hydrophilic support surface to form a non-image area.

In a conventional plate-making process of a lithographic printing plate precursor, a process of dissolving and removing unnecessary image-recording layer with an aqueous solution and the like after exposure is necessary, but from environment and safety, processing with an aqueous solution nearer to neutrality and leaving less waste solutions is an object in the industry. Since the disposal of waste solutions discharged with wet processes is an especially great interest in the industry at large in recent years from the consideration of the global environment, the solution of the above problem is increasingly desired.

On the other hand, in late years, digitized techniques of electronically processing, accumulating and outputting image data using a computer have prevailed, and various image output systems corresponding to these digitized techniques have been put to practical use. Under such circumstances, a computer-to-plate technique directly making a printing plate is attracting public attention, which comprises scanning exposing a lithographic printing plate precursor with high convergent radiant rays such as laser beams carrying digitized image data without using a lith film. With such a tendency, it is an important technical subject to obtain a lithographic printing plate precursor well adapted to this purpose.

As has been described above, the reduction of alkalinity of aqueous solutions and simplification of treatment process have been increasingly strongly required from the aspects of global environmental protection, and the adaptation for space saving and low running costs. However, developing treatment processes generally comprise three processes of development with an alkali aqueous solution having pH of 10 or higher, washing out the alkali agent in a washing bath, and treatment with a gumming solution mainly comprising hydrophilic resins, and an automatic developing processor takes up much space, in addition, a developing waste solution, a washing waste solution and a gumming waste solution are discharged, so that there is left a problem in running costs.

In this connection, e.g., JP-A-2002-91016 (The term "JP-A" as used herein refers to an "unexamined published Japanese patent application".) proposes a developing method with an alkali solution containing a nonionic surfactant having pH of from 10 to 12.5, but the photosensitive composition in this method consists of an alkali-soluble polymer, so that development is impossible if the pH of a developing solution is lower than the above range. Further, in Japanese Patent No. 2938397, a lithographic printing plate precursor comprising a hydrophilic support having provided thereon an image-forming layer containing a hydrophobic thermoplastic polymer particles dispersed in a hydrophilic binder is disclosed. After the lithographic printing plate precursor is imagewise exposed with infrared lasers to thereby coalesce the hydrophobic thermoplastic polymer particles by heat to form an image, it is possible to mount the lithographic printing plate precursor on the cylinder of a printing press to be subjected to on-press development. However, a method of forming an image by coalescence by mere heat fusion shows good on-press developing property, but image strength (adhesion with the support) is extremely weak and press life is insufficient.

As a means to solve the above problem, JP-A-2003-316021 proposes a method, which comprises subjecting a lithographic printing plate precursor comprising a support having thereon a heat-sensitive layer containing fine particle polymer to image recording, and rubbing the recorded surface of the lithographic printing plate precursor with a rubbing member in the presence of an aqueous solution and removing the image-recording layer in the unexposed area with an automatic developing processor equipped with a rubbing member to thereby manufacture a lithographic printing plate.

### Summary of the Invention

Lowering of alkalinity and simplification of process apply a great load to a development treatment process. For example, a photosensitive layer can be easily dissolved and removed with an alkali aqueous solution but the removal of a photosensitive layer is very difficult with a low alkali aqueous solution. Accordingly, a photosensitive layer that is inevitably left undissolved adheres to the plate again to become scum on the plate, which causes inferiority in appearance and smear in printing. Further, in some cases, the inside of a processor is contaminated by the photosensitive layer remained, so that long time and a great deal of labor are taken for the maintenance.

With a tendency of lowering of alkalinity and simplification of a manufacturing process, processors of the type of transporting a lithographic printing plate precursor horizontally and supplying an aqueous solution by spraying have so far been used, not a makeup of immersing a lithographic printing plate precursor in an aqueous solution. However, with these horizontal transporting constitutions, a liquid is liable to splash and the splashed liquid dries and leaves scum. In the horizontal transporting constitutions, an aqueous solution is substantially liable to dry during non-operation time, and a rubbing member (a brush) and rollers, etc., are also liable to be soiled due to drying, and the problem of the occurrence of scum from contamination is unavoidable. Therefore, the design of a horizontal transporting system is technically very difficult

The invention has been done in view of the above circumstances, and an object of the invention is to provide a method of manufacturing a lithographic printing plate of high quality, as defined in claim 1.

### Brief Description of the Drawing

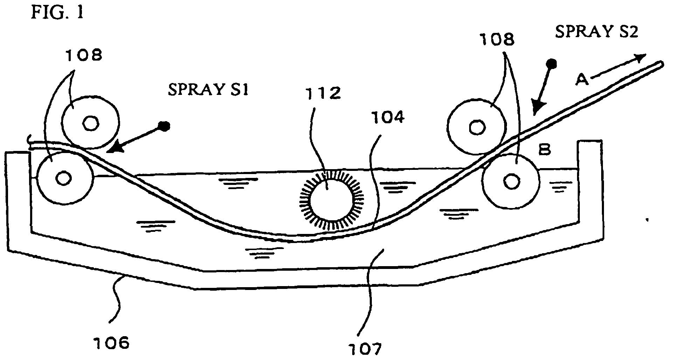

Fig. 1 is a view showing the outline of a structural example of an automatic developing processor for realizing the manufacture of a lithographic printing plate using the method of invention invention.

### Detailed Description of the Invention

Any automatic developing processors can be used in the development process of the method of the invention so long as they are processors equipped with a supplying means of an aqueous solution and a rubbing member. Automatic developing processors are sufficient if a rubbing member can be installed in a developing tank. A rotary brush is effective with ease as the rubbing member.

Fig. 1 is a view showing the outline of a structural example of an automatic developing processor for realizing the manufactured of a lithographic printing plate of the method of invention.

The automatic developing processor shown in Fig. 1 is equipped with developing tank 106, and two pairs of carrying rollers 108 provided at both ends of developing tank 106. Developing tank 106 is filled with aqueous solution 107, and rubbing member 112 is provided in aqueous solution 107. For manufacturing a lithographic printing plate, an image-recording layer of lithographic printing plate precursor 104 comprising a support having thereon an image-recording layer is in the first place subjected to image exposure with an exposing apparatus not shown in the figure, and lithographic printing plate precursor 104 after image exposure is development processed with the automatic developing processor. In the automatic developing processor, development processing is performed by rubbing the image-recording layer of lithographic printing plate precursor 104 passed carrying roller pair 108 on the light side in Fig. 1 with rubbing member 112 in the state of the image-recording layer being immersed in aqueous solution 107 to thereby remove the unexposed area of the image-recording layer of lithographic printing plate precursor 104. By performing rubbing in the state of being immersed in the reservoir, the aqueous solution hardly splashes. Accordingly, the contamination in the processor by splashing and the occurrence of scum can be prevented. In particular, in performing rubbing with rotary brush rollers, etc., in the state of immersion in the aqueous solution, in view of splashing of the liquid, it is preferred that one third or more of the diameter of the rubbing member is immersed in the aqueous solution, and more preferably the state of immersion of one half or more.

For forming a reservoir, a lithographic printing plate precursor is carried on the lower side of the horizon in the state of being immersed in the aqueous solution and carried in the aqueous solution.

It is required to perform the rubbing treatment with at least two rubbing brushers after a certain time has elapsed after immersion in the liquid. According to development by the method of the invention, in the first place, an aqueous solution osmoses the photosensitive layer of a lithographic printing plate precursor, so that the subsequent photosensitive layer removal in the non-image area comes to be easy. Accordingly, immersing a photosensitive layer in advance in an aqueous solution until the time of rubbing operation makes it possible to remove the photosensitive layer effectively. The elapsing time is 2 sec or more, more preferably 5 sec or more, and still more preferably 10 sec or more. Since development process is generally performed within 60 sec, the elapsing time is inevitably shorter than 50 sec.

Here, before immersion in an aqueous solution, it is possible to bring the photosensitive layer (the image-recording layer) of a lithographic printing plate into contact with the aqueous solution by means of spray tube S1 and the like. In this case, a longer time can be taken until rubbing in development in the aqueous solution from the contact with the aqueous solution, so that development can be performed more effectively. Further, by contact with the aqueous solution, the time required from immersion in the aqueous solution until rubbing and removing can be arbitrarily shortened. For accelerating the osmosis of the liquid, a method of vibrating the printing plate while maintaining the state of contact with the aqueous solution can be optionally used.

Accordingly, taking the time from the immersion of a lithographic printing plate precursor in an aqueous solution until coming from the aqueous solution as tsec, the rubbing treatment with the rubbing brushes preferably performed after t/2 see or after that Therefore, it is preferred to perform development at the intermediate or the latter half point of the reservoir. Of course it is possible to perform rubbing treatment at the first half point of the reservoir by making the developing tank long or making the carrying speed slow to elongate the immersion time in the aqueous solution, however, the rubbing treatment with the rubbing brushes is performed at the intermediate or the latter half of the reservoir in the method of the invention for always achieving stable development processing.

After development processing with the rubbing brushes, the lithographic printing plate precursor comes out of the aqueous solution. At this time, although it depends upon the use conditions, when the aqueous solution is fatigued, scum is liable to be adhered to the lithographic printing plate precursor in some cases. Even in such a cases, impurities such as scum adhered onto the printing plate can be got rid of by spraying an aqueous solution less fatigued than the aqueous solution used in immersion treatment onto the lithographic printing plate precursor from spray tube S2. As described above, the removing effect of scum by spraying is conspicuous when the degree of fatigue of the aqueous solution in reservoir is getting high. The liquid to be sprayed from spray tube S2 may be a fresh replenisher, or an aqueous solution containing some fresh replenisher may be used. In the circulation system discharged from spray tube S2, an especially fine filter can be arbitrarily used.

In this case, a lithographic printing plate free from contamination can be obtained only in the processing bath, so that the processes after the processing bath can be optionally omitted. When processing is performed with monobath, a drying zone is provided after the processing bath, and a plate subjected to desensitizing treatment simultaneously with development in the monobath is dried in the drying zone. When processing is completed with a monobath as above, the costs of apparatus can be reduced and at the same time space saving is possible.

When an automatic developing processor is used, a method of processing by transporting a lithographic printing plate precursor to a tank filled with an aqueous solution by means of guide rollers, is generally used. It is also possible to make a lithographic printing plate with an integrated type of apparatus consisting of an exposure apparatus and an automatic developing processor.

Incidentally, it is possible in the invention that a lithographic printing plate precursor (hereinafter referred to as a lithographic printing plate) after development process is subsequently subjected to washing and drying. Desensitizing treatment is performed simultaneously with development. The temperature of the aqueous solution can be arbitrarily selected, but is preferably from 10 to 50°C.

In exposure processing with an exposure apparatus, a lithographic printing plate precursor is exposed through a transparent original image having line images and dot images, or imagewise exposed by laser beam scanning by digital data. As preferred exposure light sources, a carbon arc lamp, a mercury lamp, a xenon lamp, a metal halide lamp, a stroboscope, ultraviolet rays, infrared rays, laser beams, etc., are exemplified. Laser beams are especially preferred, and solid state lasers and semiconductor lasers emitting Infrared rays of wavelengths of from 760 to 1.200 nm, semiconductor lasers emitting ultraviolet rays of wavelengths of from 250 to 420 nm, argon ion lasers emitting visible rays, FD-YAG lasers, etc., are exemplified. In view of simplicity in plate making, lasers emitting infrared rays or ultraviolet rays capable of working under a white lamp or a yellow lamp are preferred.

The materials of rubbing brushes for use in the invention are not especially restricted and any brushes can be used so long as they can rub the image-recording surface of a lithographic printing plate precursor, but it is preferred to use materials capable of rubbing the image-recording surface by turning on the rotation axis (e.g., well known channel brush, torsion brush, planted brush, carpet brush, molten roller, etc.).

As channel brushes, those manufactured by helically winding a long size so-called channel brush (a belt-like brush) around the surface of roller body as disclosed in JP-UM-A- 62-167253 (the term "JP-UM-A" as used herein means Japanese utility model application), JP-UM-A-4-63447, JP-UM-A-4-64128, and JP-A-6- 186751 are used.

As torsion brushes, those manufactured by inserting a torsion brush into a helical groove provided on a shaft to thereby helically wind on the shaft as disclosed in JP-A-3-87832 are used.

As planted brush, those manufactured by perforating shaft rollers and planting a brush material are used.

As carpet brushes, those manufactured by winding slender belt-like cloth interwoven with wool around shaft rollers as disclosed in JP-A-2001-5193 and JP-A-2001-66788 are used.

When rotating brushes are used as the rubbing member, the rotation speed of the rubbing brushes is preferably fast if possible for the purpose of improving the removing properties of the image-recording layer in the unexposed area of a lithographic printing plate precursor, but in view of the durability of an automatic developing processor, manufacturing costs, splashing of an aqueous solution, damage of the exposed area of the lithographic printing plate precursor, the rotation speed is from 30 to 1,000 rpm, and preferably from 50 to 500 rpm. The number of brushes is at least

two. When two or more brushes are used, one or more may be rotated in the reverse direction to the processing direction of a lithographic printing plate precursor. Further, when rotating rubbing brushes are used, development processing may be performed with vibrating the rubbing brushes in the rotation axis direction. By vibrating the rubbing brushes in the rotation axis direction, the non-image area of a lithographic printing plate precursor can be effectively removed and a lithographic printing plate of a higher quality can be manufactured.

As the materials of brushes for rubbing member, natural fibers, e.g., horse hair and pig hair, artificial fibers, and metallic fibers are known, and artificial fibers are preferred in the light of chemical resistance. As artificial fibers, polyamides, e.g., nylon 6, nylon 6,6, nylon 6,10, nylon 6,12, nylon 12, etc., polyesters, e.g., polyethylene terephthalate, polybutylene terephthalate (PBT), etc., polyacryls, e.g., polyacrylonitrile, alkyl poly(meth)crylate, etc., polyolefins, e.g., polyethylene, polypropylene, polystyrene, polyvinyl chloride, polyvinylidene chloride, etc., celluloses, e.g., acetyl cellulose, etc., polyurethanes, e.g., polyurethane, etc., and fluorine resins, e.g., polyphenylene sulfite, copolymers of ethylene/ethylene tetrafluoride, polyvinylidene fluoride, etc., are used, and considering elasticity, rigidity, abrasion resistance, heat resistance, chemical resistance, water absorption properties, and hygroscopicity, nylon 6, nylon 6,6, nylon 6,10, nylon 6,12, nylon 12, polypropylene, polybutylene terephthalate, and polyethylene terephthalate are preferred, and nylon 6,6, nylon 6,10, nylon 6,12, nylon 12, polybutylene terephthalate (PBT), and polypropylene are more preferably used. Of polyesters, polybutylene terephthalate (PBT) is especially preferred, and of polyolefins, polypropylene is especially preferred.

The hair diameter of brushes is not especially restricted, but from 0.01 to 1.0 mm is preferred, and from 0.1 to 0.5 mm is more preferred. When the diameter is thinner than 0.01 mm, the brush is inferior in rubbing properties, and when thicker than 1.0 mm, a printing plate is liable to be scratched. The length of hair of brushes is not especially restricted, but is generally from 3 to 50 mm. When the length is shorter than 3 mm, the touch against a lithographic printing plate precursor is irregular and a printing plate is liable to be scratched, while when it is longer than 50 mm, no advantage is found due to being long and economically disadvantageous. In the case of a molten roller, a cylindrical rubbing material comprising fibrous knitting is covered on a roller part, so that the prescription of the diameter and length of the wool is not necessary.

Incidentally, prior to the development processing, pre-heating and pre-washing with water can be arbitrarily used. Although the entire processor is disadvantageously enlarged by the introduction of these processes, qualities such as press life can be improved and stabilized. Both of these two processes may be introduced, or either one may be utilized.

### Example of non-alkali aqueous solution:

After a lithographic printing plate precursor in the invention is imagewise exposed with a light source of from 350 to 450 nm, a printing plate is rubbed with a rubbing member in the presence of a developing solution having pH of from 4 to 8 to remove a protective layer and a photosensitive layer in the unexposed area, and an image can be formed on the surface of an aluminum support.

The aqueous solution for use in the invention is an aqueous solution having pH of from 4 to 8 For instance, water alone, or an aqueous solution containing water as the main component (containing 60 mass% or more water) is preferred, an aqueous solution having the same composition as generally known fountain solution, an aqueous solution containing a surfactant (anionic, nonionic or cationic surfactant), and an aqueous solution containing a water-soluble polymer compound are especially preferred. (In this specification, mass ratio is equal to weight ratio.) In particular, an aqueous solution containing both a surfactant and a water-soluble polymer compound is preferred above all.

The examples of anionic surfactants for use in the invention include fatty acid salts, abietates, hydroxyalkane- sulfonates, alkanesulfonates, dialkylsulfosuccinates, straight chain alkylbenzenesulfonates, branched chain alkylbenzeaesulfonates, alkylnaphthalenesulfonates, alkylphenoxypolyoxyethylenepropylsulfonates, polyoxyethylene alkyl sulfophenyl ethers, sodium N-methyl-N-oleyl- taurine, monoamide disodium N-alkylsulfosuccinate, petroleum sulfonate, sulfated castor oil, sulfated beef tallow, sulfuric esters of fatty acid alkyl ester, alkylsulfuric esters, polyoxyethylene alkyl ether sulfuric esters, fatty acid monoglyceride sulfuric esters, polyoxyethylene alkyl phenyl ether sulfuric esters, polyoxyethylene styryl phenyl ether sulfuric esters, alkylphosphoric esters, polyoxyethylene alkyl ether phosphoric esters, polyoxyethylene alkyl phenyl ether phosphoric esters, partially saponified styrene/maleic anhydride copolymerization products, partially saponified olefin/maleic anhydride copolymerization products, naphthalenesulfonate formaldehyde condensation products, etc., are exemplified.

The cationic surfactants for use in the invention are not especially restricted and conventionally well known surfactants can be used, e.g., alkylamine salts, quaternary ammonium salts, polyoxyethyene alkylamine salts, and polyethylene polyamine derivatives are exemplified.

The examples of the nonionic surfactants for use in the invention include ethylene oxide adducts of polyethylene glycol type higher alcohol, ethylene oxide adducts of alkylphenol, ethylene oxide adducts of fatty acid, ethylene oxide adducts of polyhydric alcohol fatty acid ester, ethylene oxide adducts of higher alkylamine, ethylene oxide adducts of fatty acid amide, ethylene oxide adducts of fats and oils, ethylene oxide adducts of polypropylene glycol, dimethylsiloxane-ethylene oxide block copolymers, dimethylsiloxane-(propylene oxide-ethylene oxide) block copolymers, fatty acid esters of polyhydric alcohol type glycerol, fatty acid esters of pentaerythritol, fatty acid esters of sorbitol and sorbitan, fatty acid esters of sucrose, alkyl ethers of polyhydric alcohols, and fatty acid amide of alkanolamines.

These nonionic surfactants may be used alone, or two or more surfactants may be used as mixture. In the invention, ethylene oxide adducts of sorbitol and/or sorbitan fatty acid esters, ethylene oxide adducts of polypropylene glycol, dimethylsiloxane-ethylene oxide block copolymers, dimethylsiloxane-(propylene oxide-ethylene oxide) block copolymers, and fatty acid esters of polyhydric alcohols are more preferred.

In view of stable solubility in water or turbidity, HLB (Hydrophile-Lipophile Balance) value of nonionic surfactants for use in the aqueous solution of the invention is preferably 6 or more, and more preferably 8 or more. Further, the ratio of the nonionic surfactant contained in the aqueous solution is preferably from 0.01 to 10 wt%, and more preferably from 0.01 to 5 wt%. Further, acetylene glycol-based or acetylene alcohol-based oxyethylene adducts, and fluorine-containing or silicon-containing surfactants can also be used in the invention. The surfactants described above normally exhibit the effects when a total amount of the surfactants is about 1 mass% in the development processing solution of the invention. However, depending on the kinds of the surfactants, there is a case where the amount is an allowed level, but not a satisfactory level. Therefore, the addition of 3 mass% or more is preferred, and the addition of 5 mass% or more is more preferred.

The aqueous solution in the invention may contain an organic solvent. The examples of organic solvents that can be contained include aliphatic hydrocarbons (e.g., hexane, heptane, "Isopar® E, H, G" (manufactured by Exxon Chemicals), gasoline, kerosene, etc.), aromatic hydrocarbons (e.g., toluene, xylene, etc.), halogenated hydrocarbons (e.g., methylene dichloride, ethylene dichloride, trichlene, monochlorobenzene, etc.), and polar solvents shown below.

The examples of polar solvents include alcohols (e.g., methanol, ethanol, propanol, isopropanol, benzyl alcohol, ethylene glycol monomethyl ether, 2-ethoxyethanol, diethylene glycol monoethyl ether, diethylene glycol monohexyl ether, triethylene glycol monomethyl ether, propylene glycol monoethyl ether, dipropylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, methylphenylcarbinol, n-amyl alcohol, methylamyl alcohol, etc.), ketones (e.g., acetone, methyl ethyl ketone, ethyl butyl ketone, methyl isobutyl ketone, cyclohexanone, etc.), esters (e.g., ethyl acetate, propyl acetate, butyl acetate, amyl acetate, benzyl acetate, methyl lactate, butyl lactate, ethylene glycol monobutyl acetate, propylene glycol monomethyl ether acetate, diethylene glycol acetate, diethyl phthalate, butyl levulinate, etc.), and others (e.g., triethyl phosphate, tricresyl phosphate, N-phenylethanolamine, N-phenyldiethanolamine, etc.). When the organic solvents are insoluble in water, the organic solvent may be solubilized in water with a surfactant and the like and then used. In the case where an organic solvent is used in the aqueous solution, from the point of view of safety and flammability, the concentration of the solvent is preferably less than 40 wt%.

The aqueous solution for use in the present invention may contain water-soluble polymer compounds, and the examples of the water-soluble polymer compounds include soybean polysaccharides, denatured starch, gum arabic, dextrin, cellulose derivatives (e.g., carboxymethyl cellulose, carboxyethyl cellulose, methyl cellulose, etc.), and denatured products thereof, pullulan, polyvinyl alcohols and derivatives thereof, polyvinylpyrrolidone, polyacrylamide and acrylamide copolymers, vinyl methyl ether/maleic anhydride copolymers, vinyl acetate/maleic anhydride copolymers, styrene/maleic anhydride copolymers, etc.

As for the soybean polysaccharides, well-known compounds may be used. For example, SOYAFIBE® (trade name, manufactured by Fuji Oil Co., Ltd.) is commercially available, and various grades of products can be used. Products having a viscosity of a 10 mass% aqueous solution of from 10 to 100 mPa/sec are preferably used.

As the denatured starches, well-known compounds can also be used. The denatured starch can be manufactured by a method of decomposing starch such as com, potato, tapioca, rice, wheat or the like with an acid, an enzyme, etc., in the range of a glucose residue number of from 5 to 30 per a molecule, and further adding oxypropylene in an alkali.

The water-soluble polymer compounds can also be used in combination of two or more. The content of the water-soluble polymer compounds in the aqueous solution is preferably from 0.1 to 20 mass%, and more preferably from 0.5 to 10 mass%.

In addition to the above components, the aqueous solution in the invention may contain an antiseptic, a chelate compound, a defoaming agent, an organic acid, an inorganic acid, an inorganic salt and the like.

The examples of antiseptics that can be preferably used in the invention include phenol and derivatives thereof, formaldehyde, imidazole derivatives, sodium dehydroacetate, 4-isothiazolin-3-one derivatives, benzisothiazolin-3-one, benzotriazole derivatives, amidine guanidine derivatives, quaternary ammonium salts, derivatives of pyridine, quinoline, guanidine, etc., derivatives of diazine and triazole, derivatives of oxazole and oxazine, and nitrobromoalcohol- based compounds, e.g., 2-bromo-2-nitropropane-1,3-diol,1,1-dibromo-1-nitro-2-ethanol, 1,1-dibromo-1-nitro-2-propanol, etc.

The examples of the chelate compounds include organic phosphonic acids and phosphonoalkanetricarboxylic acids, e.g., ethylenediaminetetraacetic acid, and potassium salts and sodium salts thereof; diethylenetriaminepentaacetic acid, and potassium salts and sodium salts thereof; triethylene- tetraminehexaacetic acid, and potassium salts and sodium salts thereof; hydroxyethylethylenediaminetriacetic acid, and potassium salts and sodium salts thereof; nitrilotriacetic acid and sodium salts thereof; 1-hydroxyethane-1,1-diphosphonic acid, and potassium salts and sodium salts thereof; and aminotri(methylenephosphonic acid), and potassium salts and sodium salts thereof. In place of the sodium salts and potassium salt of these chelating agents, organic amine salts are also effective.

As the defoaming agents, silicon-based self-emulsifying, and emulsifying surfactants of general types, and nonionic compounds having an HLB of 5 or less can be used. Silicon defoaming agents are preferred. Of these defoaming agents, any type such as an emulsion-dispersing type and a solubilizing type can be used.

As the examples of the organic acids, citric acid, acetic acid, oxalic acid, malonic acid, salicylic acid, caprylic acid, tartaric acid, malic acid, lactic acid, levulinic acid, p-toluenesulfonic acid, xylenesulfonic acid, phytic acid, and organic phosphonic acid are exemplified. The organic acids may be used in the form of their alkali metal salts or ammonium salts.

The examples of the inorganic acids and inorganic salts include phosphoric acid, metaphosphoric acid, ammonium primary phosphate, ammonium secondary phosphate, sodium primary phosphate, sodium secondary phosphate, potassium primary phosphate, potassium secondary phosphate, sodium tripolyphosphate, potassium pyrophosphate, sodium hexametaphosphate, magnesium nitrate, sodium nitrate, potassium nitrate, ammonium nitrate, sodium sulfate, potassium sulfate, ammonium sulfate, sodium sulfite, ammonium sulfite, sodium hydrogensulfate, and nickel sulfate.

### Lithographic printing plate precursor.

Lithographic printing plate precursors for use in the invention are described in the first place.

### Photosensitive layer:

A lithographic printing plate precursor for use in the plate-making method of the invention has a negative photosensitive layer that is hardened in the exposed area. The negative photosensitive layer is a radical polymerizable photosensitive layer containing a hydrophobic binder polymer, a polymerization initiator and a polymerizable compound and is capable of obtaining easy developability and good press life. The constitutional components of the photosensitive layer are described below.

### Hydrophobic binder polymer:

The hydrophobic binder polymers that are used in the photosensitive layer of the invention are preferably nonaqueous polymers. Further, it is preferred for the hydrophobic binder polymers usable in the invention not to substantially contain acid groups such as a carboxyl group, a sulfonic acid group and a phosphoric acid group. The acid value of the binder polymers (the value of acid content per g of a polymer expressed in chemical equivalent) is preferably 0.3 meq/g or less, and more preferably 0.1 meq/g or less.

That is, the hydrophobic binder polymers usable in the invention are preferably insoluble in water or an aqueous solution of pH 10 or more, and the solubility of the hydrophobic binder polymers in water or an aqueous solution of pH 10 or more is preferably 0.5 mass% or less, and more preferably 0.1 mass% or less. By using such a hydrophobic binder polymer, the film strength, water resistance and ink adhesion property of the photosensitive layer are improved and enhanced press life can be obtained.

As the hydrophobic binder polymers, conventionally known hydrophobic binder polymers, preferably having solubility in the above range, can be used without any restriction, so long as the performances of lithographic printing plates of the invention are not impaired, and linear organic polymers having a film property are preferably used.

The preferred examples of such hydrophobic binder polymers include polymers selected from among acrylic resin, polyvinyl acetal resin, polyurethane resin, polyamide resin, epoxy resin, methacrylic resin, styrene-based resin, and polyester resin. Of these resins, acrylic resin is preferred, and (meth)acrylic ester copolymers are more preferred. More specifically, copolymers of (meth)acrylic acid alkyl or aralkyl ester with (meth)acrylic ester containing a -CH₂CH₂O- unit or a -CH₂CH₂NH- unit in R of the ester residue (-COOR) of the (meth)acrylic ester are especially preferred. The alkyl group in the (meth)acrylic acid alkyl ester is preferably an alkyl group having from 1 to 5 carbon atoms, and more preferably a methyl group. As the preferred example of the (meth)acrylic acid aralkyl ester, benzyl (meth)acrylate is exemplified.

The hydrophobic binder polymers may have a crosslinking property to improve film strength in the image area.

A crosslinking property may be imparted to the binder polymers by the introduction of a crosslinking functional group such as an ethylenic unsaturated bond into the main chain or side chain of the polymers. The crosslinking functional group may be introduced by copolymerization or high molecular reaction.

The crosslinking group here means a group capable of crosslinking a polymer binder during the course of radical polymerization reaction that occurs in a photosensitive layer when a lithographic printing plate precursor is subjected to exposure. The crosslinking groups are not especially restricted so long as they are groups having such a function, and as functional groups capable of addition polymerization reaction, an ethylenic unsaturated bond group, an amino group and an epoxy group are exemplified. The crosslinking groups may be functional groups capable of becoming radicals upon irradiation with light, e.g., a thiol group, a halogen group, an onium salt structure, etc., are exemplified as such groups. An ethylenic unsaturated bond group is preferred above all, and a functional group represented by any of the following formulae (1) to (3) is especially preferred.

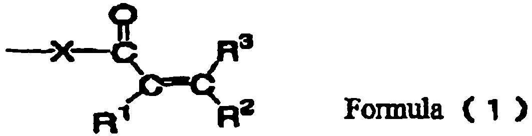

In formula (1), R¹, R² and R³ each represents a monovalent organic group. R¹ preferably represents a hydrogen atom, or an alkyl group that may have a substituent, and a hydrogen atom and a methyl group are especially preferred for high radical reactivity. R² and R³ each represents a hydrogen atom, a halogen atom, an amino group, a carboxyl group, an alkoxy- carbonyl group, a sulfo group, a nitro group, a cyano group, an alkyl group that may have a substituent, an aryl group that may have a substituent, an alkoxyl group that may have a substituent, an aryloxy group that may have a substituent, an alkylamino group that may have a substituent, an arylamino group that may have a substituent, an alkylsulfonyl group that may have a substituent, an arylsulfonyl group that may have a substituent, or the like, and a hydrogen atom, a carboxyl group, an alkoxycarbonyl group, an alkyl group that may have a substituent, or an aryl group that may have a substituent is preferred for high radical reactivity.

X represents an oxygen atom, a sulfur atom, or N(R¹²)-, R¹² represents a hydrogen atom or a monovalent organic group. As R¹², an alkyl group that may have a substituent or the like is exemplified, and a hydrogen atom, a methyl group, an ethyl group, or an isopropyl group is preferred for high radical reactivity.

As introducible substituents, an alkyl group, an alkenyl group, an alkynyl group, an aryl group, an alkoxyl group, an aryloxy group, a halogen atom, an amino group, an alkylamino group, an arylamino group, a carboxyl group, an alkoxycarbonyl group, a sulfo group, a nitro group, a cyano group, an amido group, an alkylsulfonyl group, an arylsulfonyl group, etc., can be exemplified.

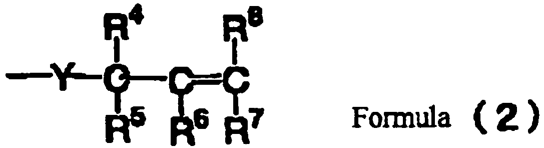

In formula (2), R⁴, R⁵, R⁶, R⁷ and R⁸ each represents a monovalent organic group, and preferably a hydrogen atom, a halogen atom, an amino group, a dialkylamino group, a carboxyl group, an alkoxycarbonyl group, a sulfo group, a nitro group, a cyano group, an alkyl group that may have a substituent, an aryl group that may have a substituent, an alkoxyl group that may have a substituent, an aryloxy group that may have a substituent, an alkylamino group that may have a substituent, an arylamino group that may have a substituent, an alkyl- sulfonyl group that may have a substituent, an arylsulfonyl group that may have a substituent, etc., are exemplified, and a hydrogen atom, a carboxyl group, an alkoxycarbonyl group, an alkyl group that may have a substituent, and an aryl group that may have a substituent are preferred above all.

As introducible substituents, the same groups as in formula (1) are exemplified. Y represents an oxygen atom, a sulfur atom, or N(R¹²)-. R¹² has the same meaning as R¹² in formula (1), and preferred examples are also the same.

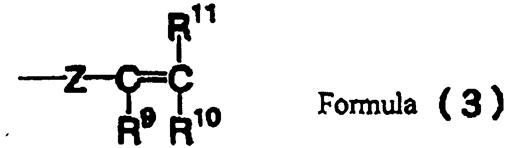

In formula (3), R⁹ preferably represents a hydrogen atom or an alkyl group that may have a substituent, and above all a hydrogen atom and a methyl group are preferred for their high radical reactivity. R¹⁰ and R¹¹ each represents a hydrogen atom, a halogen atom, an amino group, a dialkylamino group, a carboxyl group, an alkoxycarbonyl group, a sulfo group, a nitro group, a cyano group, an alkyl group that may have a substituent, an aryl group that may have a substituent, an alkoxyl group that may have a substituent, an aryloxy group that may have a substituent, an alkylamino group that may have a substituent, an arylamino group that may have a substituent, an alkyl- sulfonyl group that may have a substituent, an arylsulfonyl group that may have a substituent, or the like, and a hydrogen atom, a carboxyl group, an alkoxycarbonyl group, an alkyl group that may have a substituent, or an aryl group that may have a substituent is preferred for high radical reactivity.

As the examples of introducible substituents, the same groups as in formula (1) can be exemplified. Z represents an oxygen atom, a sulfur atom, N(R¹³)-, or a phenylene group that may have a substituent. As R¹³, an alkyl group that may have a substituent or the like is exemplified, and a methyl group, an ethyl group, or an isopropyl group is preferred for high radical reactivity.

Of the above groups, (meth)acrylic acid copolymers having a crosslinking group on the side chain and polyurethane are more preferred.

When free radicals (polymerization initiation radicals or the grown radicals of a polymerizable compound in the polymerization process) are added to the crosslinkable functional groups of a hydrophobic binder polymer having a crosslinking property, addition polymerization occurs directly between the polymers or via the polymerization chains of the polymerizable compound, as a result, crosslinking is formed between the polymer molecules and the binder polymer is hardened. Alternatively, the atoms in the polymer (e.g., the hydrogen atoms on the carbon atoms contiguous to the crosslinkable functional groups) are extracted by free radicals and polymer radicals are grown, and the polymer radicals are bonded to each other, whereby crosslinking is formed between the polymer molecules, whereby the binder polymer is hardened.

The content of crosslinkable groups in a hydrophobic binder polymer (the content of radical polymerizable unsaturated double bonds determined by iodometric titration) is preferably from 0.1 to 10.0 mmol per gram of the hydrophobic binder polymer, more preferably from 1.0 to 7.0 mmol, and most preferably from 2.0 to 5.5 mmoL

From the viewpoint of the enhancement of developing property with an aqueous solution, the binder polymer is preferably hydrophilic, and in the light of the improvement of press life, it is important that the binder polymer has good compatibility with the polymerizable compound contained in a photosensitive layer, i.e., the binder polymer is preferably lipophilic. From these aspects, it is also effective in the invention to copolymerize a hydrophilic group and a lipophilic group in the hydrophobic binder polymer for the purpose of the improvement of developing property and press life. As the examples of binder polymers having a hydrophilic group, those having a hydroxyl group, e.g., a hydroxyl group, a carboxylate group, a hydroxyethyl group, an ethyleneoxy group, a hydroxypropyl group, a polyoxyethyl group, a polyoxypropyl group, an amino group, an aminoethyl group, an aminopropyl group, an ammonium group, an amido group, a carboxymethyl group, etc., are preferably exemplified.

The hydrophobic binder polymer preferably has a weight average molecular weight of 5,000 or more, more preferably from 10,000 to 300,000, and a number average molecular weight of 1,000 or more, more preferably from 2,000 to 250,000. The polydisperse degree (weight average molecular weight/number average molecular weight) is preferably from 1.1 to 10.

The hydrophobic binder polymer may be any of a random polymer, a block polymer, a graft polymer, and the like, but a random polymer is preferred.

The hydrophobic binder polymers may be used alone, or two or more kinds of hydrophobic binder polymers may be used as mixture.

The content of the hydrophobic binder polymer is from 5 to 90 mass% based on the total solids content of the photosensitive layer, preferably from 10 to 70 mass%, and more preferably from 10 to 60 mass%. Within this range, good strength of the image area and good image forming property can be obtained.

### Polymerization initiator.

Polymerization initiators for use in the invention are a compound capable of generating radicals by the action of light or heat, and initiating and accelerating the polymerization of a compound having a polymerizable unsaturated group. The radical generators can be appropriately selected from known polymerization initiators and compounds having a bond with small bond-dissociating energy.

As such compounds capable of generating radicals, e.g., an organohalogen compound, a carbonyl compound, an organo- peroxide, an azo-based polymerization initiator, an azide compound, a metallocene compound, a hexaarylbiimidazole compound, an organoboron compound, a disulfone compound, an oxime ester compound, and an onium salt compound are exemplified.

As the organohalogen compounds, specifically, the compounds described in Wakabayashi et al., Bull. Chem. Soc. Japan, 42, 2924 (1969), U.S. Patent 3,905,815, JP-B-46-4605 (the term "JP-B" as used herein refers to an "examined Japanese patent publication"), JP-A-48-36281, JP-A-53-133428, JP-A- 55-32070, JP-A-60-239736, JP-A-61-169835, JP-A-61-169837, JP-A-62-58241, JP-A-62-212401, JP-A-63-70243, JP-A-63-298339, and M.P. Hutt, Journal of Heterocyclic Chemistry, 1 (No. 3) (1970) are exemplified. Of these compounds, oxazole compounds substituted with a trihalomethyl group and S-triazine compounds are preferably used.

More preferably, s-triazine derivatives in which at least one mono-, di- or tri-halogen-substituted methyl group is bonded to the s-triazine ring, and oxadiazole derivatives having an oxadiazole ring to which at least one mono-, di- or tri-halogen-substituted methyl group is bonded are exemplified. Specifically, 2,4,6-tris(monochloromethyl)- s-triazine, 2,4,6-tris(dichloromethyl)-s-triazine, 2,4,6-tris(trichloromethyl)-s-triazine, 2-methyl-4,6-bis- (trichloromethyl)-s-triazine, 2-n-propyl-4,6-bis(trichloro- methyl)-s-triazine, 2-(α,α,β-trichloroethyl)-4,6-bis-(trichloromethyl)-s-triazine, 2-(3,4-epoxyphenyl)-4,6-bis- (trichloromethyl)-s-triazine, 2-[1-(p-methoxyphenyl)-2,4- butadienyl]-4,6-bis(trichloromethyl)-s-triazine, 2-styryl-4,6-bis(trichloromethyl)-s-triazine, 2-(p-methoxystyryl)- 4,6-bis(trichloromethyl)-s-triazine, 2-(p-i-propyloxy- styryl)-4,6-bis(trichloromethyl)-s-triazine, 2-(p-tolyl-4,6-bis(trichloromethyl)-s-triazine, 2-(4-methoxynaphthyl)-4,6-bis(trichloromethyl)-s-triazine, 2-phenylthio-4,6-bis- (trichloromethyl)-s-triazine, 2-benzylthio-46,-bis- (trichloromethyl)-s-triazine, 2,4,6-tris(dibromomethyl)-s- triazine, 2,4,6-tris(tribromomethyl)-s-triazine, 2-methyl- 4,6-bis(tribromomethyl)-s-triazine, 2-methoxy-4,6-bis- (tribromomethyl)-s-triazine, and the following compounds are exemplified.

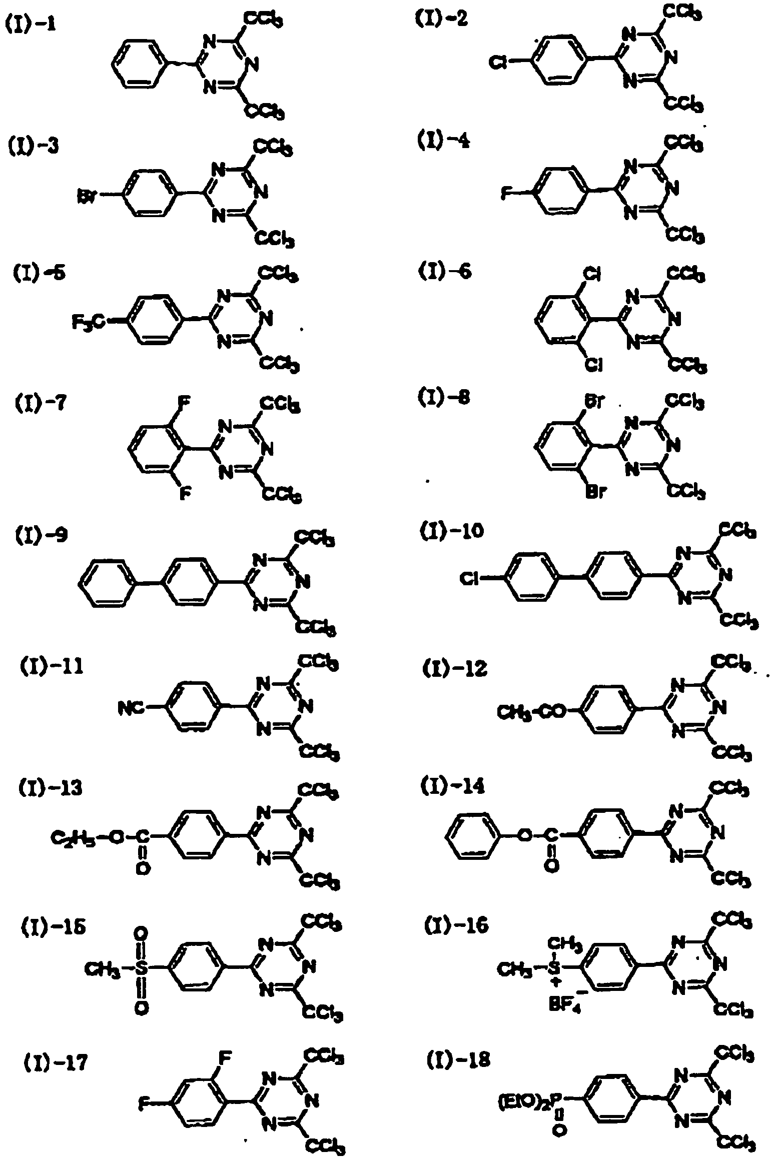

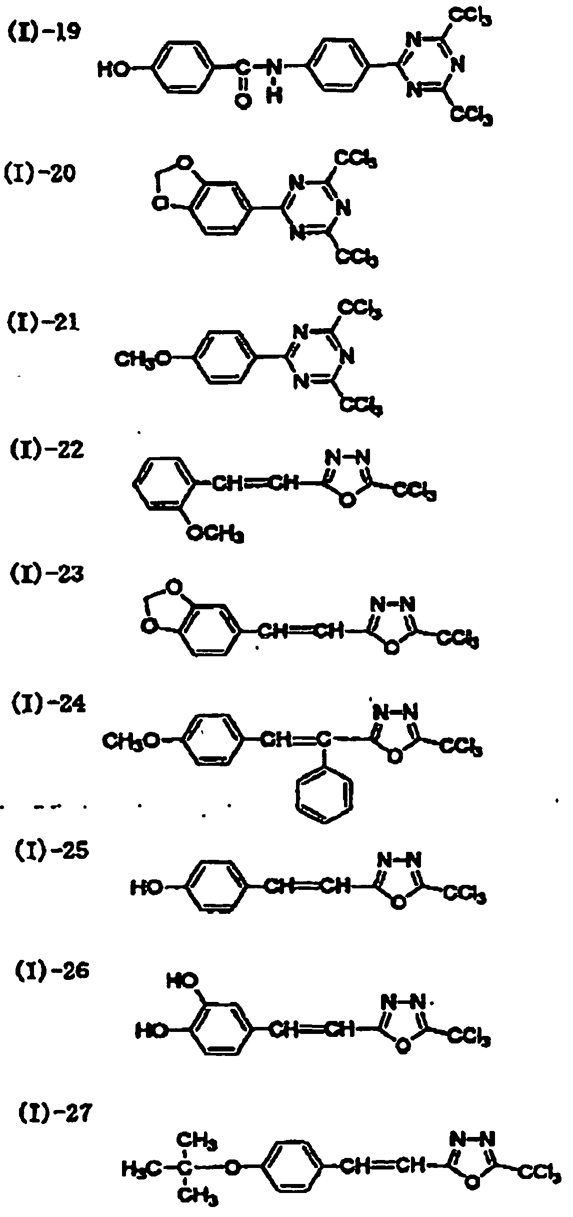

As the carbonyl compounds, benzophenone derivatives, e.g., benzophenone, Michler's ketone, 2-methylbenzophenone, 3-methylbenzophenone, 4-methylbenzophenone, 2-chlorobenzo- phenone, 4-bromobenzophenone, 2-carboxybenzophenone, etc., acetophenone derivatives, e.g., 2,2-dimethoxy-2-phenyl- acetophenone, 2,2-diethoxyacetophenone, 1-hydroxycyclohexyl phenyl ketone, α-hydroxy-2-methylphenylpropanone, 1-hydroxy- 1-methylethyl-(p-isopropylphenyl) ketone, 1-hydroxy-1-(p- dodecylphenyl) ketone, 2-methyl-[4'-(methylthio)phenyl]-2-morpholino-1-propanone, 1,1,1-trichloromethyl-(p-butyl- phenyl) ketone, etc., thioxanthone derivatives, e.g., thioxanthone, 2-ethylthioxanthone, 2-isopropylthioxanthone, 2-chlorothioxanthone, 2,4-dimethylthioxanthone, 2,4- diethylthioxanthone, 2,4-diisopropylthioxanthone, etc., and benzoate derivatives, e.g., ethyl p-dimethylaminobenzoate, ethyl p-diethylaminobenzoate, etc., are exemplified.

As the azo compounds, the azo compounds disclosed in JP-A-8-108621 can be used.

As the organoperoxides, e.g., trimethylcyclohexanone peroxide, acetylacetone peroxide,1,1-bis(tert-butylperoxy)- 3,3,5-trimethylcyclohexane, 1,1-bis(tert-butylperoxy)cyclo- hexane, 2,2-bis(tert-butylperoxy)butane, tert-butyl hydro-peroxide, cumene hydroperoxide, diisopropylbenzene hydro- peroxide, 2,5-dimethylhexane-2,5-dihydroperoxide, 1,1,3,3- tetramethylbutyl hydroperoxide, tert-butylcumyl peroxide, dicumyl peroxide, 2,5-dimethyl-2,5-di(tert-butylperoxy)- hexane, 2,5-oxanoyl peroxide, succinic acid peroxide, benzoyl peroxide, 2,4-dichlorobenzoyl peroxide, diisopropylperoxy dicarbonate, di-2-ethylhexylperoxy dicarbonate, di-2-ethoxy-ethyiperoxy dicarbonate, dimethoxyisopropylperoxy carbonate, di(3-methyl-3-methoxybutyl)peroxy dicarbonate, tert-butyl- peroxy acetate, tert-butylperoxy pivalate, tert-butylperoxy neodecanoate, tert-butylperoxy octanoate, tert-butylperoxy laurate, tertiary carbonate, 3,3',4,4'-tetra(t-butylperoxy-carbonyl)benzopbenone, 3,3',4,4'-tetra(t-hexylperoxy- carbonyl)benzophenone, 3,3',4,4'-tetra(p-isopropylcumyl- peroxycarbonyl)benzophenone, carbonyldi(t-butylperoxy dihydrogendiphthalate), carbonyldi(t-hexylperoxydihydrogen- diphthalate), etc., are exemplified.

As the metallocene compounds, various titanocene compounds disclosed in JP-A-59-152396, JP-A-61-151197, JP-A-63-41484, JP-A-2-249, JP-A-2-4705 and JP-A-5-83588, e.g., dicyclopentadienyl-Ti-bis-phenyl, dicyclopentadienyl-Ti-bis-2,6-difluorophen-1-yl, dicyclopentadienyl-Ti-bis- 2,4-difluorophen-1-yl, dicyclopentadienyl-Ti-bis-2,4,6- trifluorophen-1-yl, dicyclopentadienyl-Ti-bis-2,3,5,6-tetrafluorophen-1-yl, dicyclopentadienyl-Ti-bis-2,3,4,5,6- pentafluorophen-1-yl, dimethylcyclopentadienyl-Ti-bis-2,6- difluorophen-1-yl, dimethylcyclopentadienyl-Ti-bis-2,4,6- trifluorophen-1-yl, dimethylcyclopentadienyl-Ti-bis- 2,3,5,6-tetrafluorophen-1-yl, dimethylcyclopentadienyl-Ti- bis-2,3,4,5,6-pentafluorophen-1-yl, bis(cyclopentadienyl)-bis[2,6-difluoro-3-(pyr-1-yl)phenyl]titanium, and the iron-allene complexes disclosed in JP-A-1-304453 and JP-A-1-152109 are exemplified.

As the hexaarylbiimidazole compounds, various compounds disclosed in JP-B-6-29285, U.S. Patents 3,479,185, 4,311,783 and 4,622,286, specifically, e.g., 2,2'-bis(o-chlorophenyl)- 4,4',5,5'-tetraphenylbiimidazole, 2,2'-bis(o-bromophenyl)-4,4',5,5'-tetraphenylbiimidazole, 2,2'-bis(o,p-dichlorophenyl)-4,4',5,5'-tetraphenylbiimidazole, 2,2'-bis-(o-chlorophenyl)-4,4',5,5'-tetra(m-methoxyphenyl)biimidazole, 2,2'-bis(o,o'-dichlorophenyl)-4,4',5,5'-tetraphenyl- biimidazole, 2,2'-bis(o-nitrophenyl)-4,4',5,5'-tetraphenyl- biimidazole, 2,2'-bis(o-methylphenyl)-4,4,5,5'-tetra- phenylbiimidazole, 2,2'-bis(o-trifluorophenyl)-4,4',5,5'-tetraphenylbiimidazole, etc., are exemplified.

As the organoboron compounds, e.g., the organoborates disclosed in JP-A-62-143044, JP-A-62-150242, JP-A-9-188685, JP-A-9-188686, JP-A-9-198710, JP-A-2000-131837, JP-A-2002- 107916, Japanese Patent No. 2764769, JP-A-2002-116539, and Kunz, Martin, "Rad Tech '98 Proceeding April 19-22,1998, Chicago", the organoboron sulfonium complexes and the organo- boron oxosulfonium complexes disclosed in JP-A-6-157623, JP-A-6-175564 and JP-A-6-175561, the organoboron iodonium complexes disclosed in JP-A-6-175554 and JP-A-6-175553, the organoboron phosphonium complexes disclosed in JP-A-9-188710, and organoboron transition metal coordination complexes disclosed in JP-A-6-348011, JP-A-7-128785, JP-A-7-140589, JP-A-7-306527 and JP-A-7-292014 are exemplified.

As the disulfone compounds, the compounds disclosed in JP-A-61-166544 and JP-A-2003-328465 are exemplified.

As the oxime ester compounds, the compounds described in J.C.S. Perkin II, 1653-1660 (1979), J.C.S. Perkin II,156-162 (1979), Journal of Photopolymer Science and Technology,pp. 202-232 (1995), JP-A-2000-66385, the compounds disclosed in JP-A-2000-80068, and specifically the compounds represented by the following formulae are exemplified are exemplified.

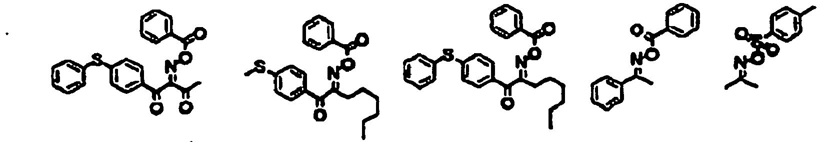

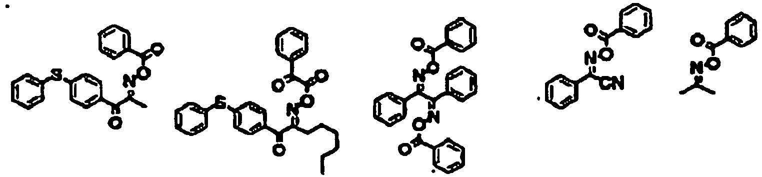

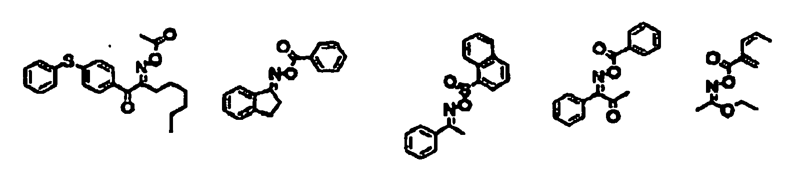

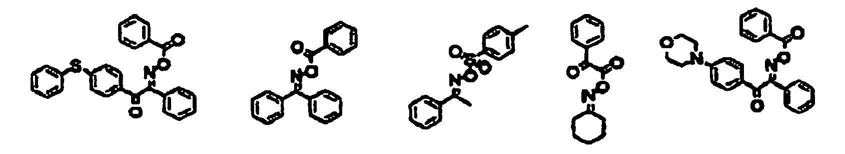

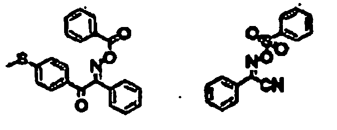

As the onium salt compounds, onium salts, e.g., the diazonium salts described in S.I Schlesinger, Photogr. Sci. Eng., 18, 387 (1974), and T.S. Bal et al., Polymer, 21, 423 (1980), the ammonium salts disclosed in U.S. Patent 4,069,055 and JP-A-4-365049, the phosphonium salts disclosed in U.S. Patents 4,069,055 and 4,069,056, the iodonium salts disclosed in EP 104,143, U.S. Patents 339,049,410,201, JP-A-2-150848 and JP-A-2-296514, the sulfonium salts disclosed in EP 370,693, EP 390,214, EP 233,567, EP 297,443, EP 297,442, U.S. Patents 4,933,377, 161,811, 410,201, 339,049, 4,760,013, 4,734,444,2,833,827, German Patents. 2,904,626, 3,604,580 and 3,604,581, the selenonium salts described in J.V. Crivello et al., Macromolecules, 10 (6), 1307 (1977), and J.V. Crivello et al., J. Polymer Sci., Polymer Chem. Ed., 17,1047 (1979), the arsonium salts described in C.S. Wen et al., Teh. Proc. Conf. Rad. Curing ASIA, p. 478, Tokyo, Oct (1988), etc., are exemplified.

In the invention, these onium salts function as ionic radical polymerization initiators not acid generators.

The onium salts preferably used in the invention are onium salts represented by the following formulae (RI-I) to (RI-III).

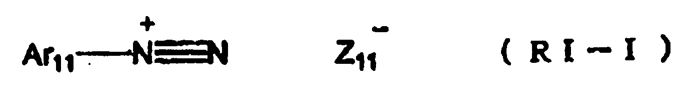

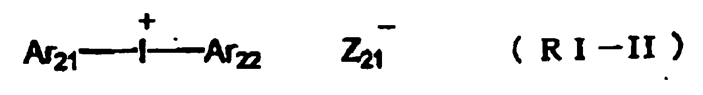

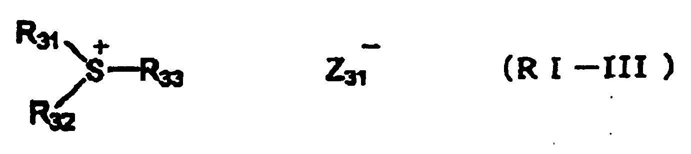

In formula (RI-I), Ar₁₁ represents an aryl group having 20 or less carbon atoms, which may have from 1 to 6 substituents, and as the preferred substituents, an alkyl group having from 1 to 12 carbon atoms, an alkenyl group having from 1 to 12 carbon atoms, an alkynyl group having from 1 to 12 carbon atoms, an aryl group having from I to 12 carbon atoms, an alkoxyl group having from 1 to 12 carbon atoms, an aryloxy group having from 1 to 12 carbon atoms, a halogen atom, an alkylamino group having from 1 to 12 carbon atoms, a dialkylamino group having from 1 to 12 carbon atoms, an alkylamido or arylamido group having from 1 to 12 carbon atoms, a carbonyl group, a carboxyl group, a cyano group, a sulfonyl group, a thioalkyl group having from 1 to 12 carbon atoms, and a thioaryl group having from 1 to 12 carbon atoms are exemplified. Z₁₁⁻ represents a monovalent anion, and specifically a halogen ion, a perchlorate ion, a hexafluorophosphate ion, a tetrafluoroborate ion, a sulfonate ion, a sulfinate ion, a thiosulfonate ion, and a sulfate ion are exemplified. In view of stability, a perchlorate ion, a hexafluorophosphate ion, a tetrafluoroborate ion, a sulfonate ion and a sulfinate ion are especially preferred.

In formula (RI-II), Ar₂₁ and Ar₂₁ each represents an aryl group having 20 or less carbon atoms, which may have from 1 to 6 substituents, and as the preferred substituents, an alkyl group having from 1 to 12 carbon atoms, an alkenyl group having from 1 to 12 carbon atoms, an alkynyl group having from 1 to 12 carbon atoms, an aryl group having from 1 to 12 carbon atoms, an alkoxyl group having from 1 to 12 carbon atoms, an aryloxy group having from 1 to 12 carbon atoms, a halogen atom, an alkylamino group having from 1 to 12 carbon atoms, a dialkyl- amino group having from 1 to 12 carbon atoms, an alkylamido or arylamido group having from 1 to 12 carbon atoms, a carbonyl group, a carboxyl group, a cyano group, a sulfonyl group, a thioalkyl group having from 1 to 12 carbon atoms, and a thioaryl group having from 1 to 12 carbon atoms are exemplified. Z₂₁⁻ represents a monovalent anion, and specifically a halogen ion, a perchlorate ion, a hexafluorophosphate ion, a tetrafluoro- borate ion, a sulfonate ion, a sulfinate ion, a thiosulfonate ion, and a sulfate ion are exemplified. In view of stability and reactivity, a perchlorate ion, a hexafluorophosphate ion, a tetrafluoroborate ion, a sulfonate ion, a sulfinate ion, and a carboxylate ion are especially preferred.

In formula (RI-III), R₃₁, R₃₂ and R₃₃ each represents an aryl, alkyl, alkenyl or alkynyl group having 20 or less carbon atoms, which may have from 1 to 6 substituents. Above all, in view of reactivity and stability, an aryl group is preferred. As the substituents, an alkyl group having from 1 to 12 carbon atoms, an alkenyl group having from 1 to 12 carbon atoms, an alkynyl group having from 1 to 12 carbon atoms, an aryl group having from 1 to 12 carbon atoms, an alkoxyl group having from 1 to 12 carbon atoms, an aryloxy group having from 1 to 12 carbon atoms, a halogen atom, an alkylamino group having from 1 to 12 carbon atoms, a dialkylamino group having from 1 to 12 carbon atoms, an alkylamido or arylamido group having from 1 to 12 carbon atoms, a carbonyl group, a carboxyl group, a cyano group, a sulfonyl group, a thioalkyl group having from 1 to 12 carbon atoms, and a thioaryl group having from 1 to 12 carbon atoms are exemplified. Z₃₁⁻ represents a monovalent anion, and specifically a halogen ion, a perchlorate ion, a hexafluoro- phosphate ion, a tetrafluoroborate ion, a sulfonate ion, a sulfinate ion, a thiosulfonate ion, and a sulfate ion are exemplified. In view of stability and reactivity, a perchlorate ion, a hexafluorophosphate ion, a tetrafluoro- borate ion, a sulfonate ion, a sulfinate ion, and a carboxylate ion are especially preferred. The carboxylate ion disclosed in JP-A-2001-343742 is more preferred, and the carboxylate ion disclosed in JP-A-2002-148790 is especially preferred.

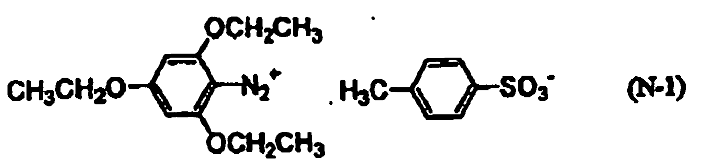

PF₆⁻ (N-2)

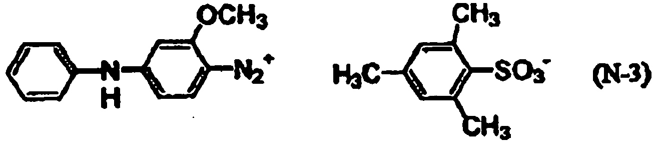

ClO₄⁻ (N-4)

PF₆⁻ (N-5)

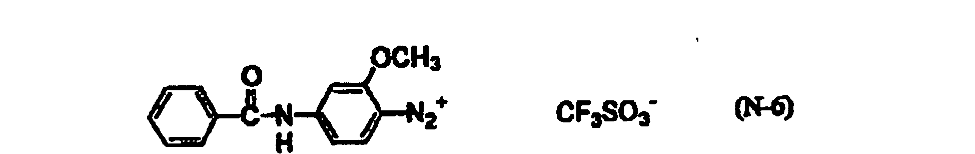

BF₄⁻ (N-7)

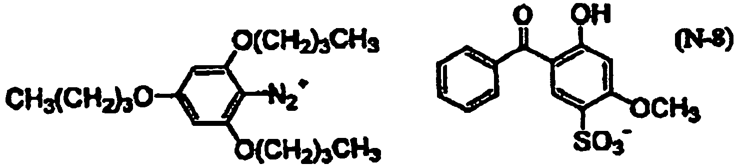

ClO₄⁻ (N-9)

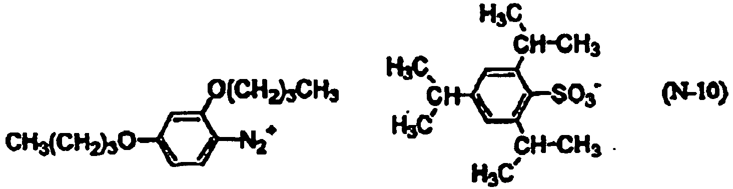

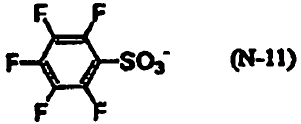

PF₆⁻ (N-12)

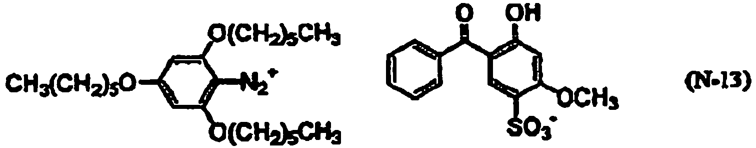

ClO₄⁻ (N-14)

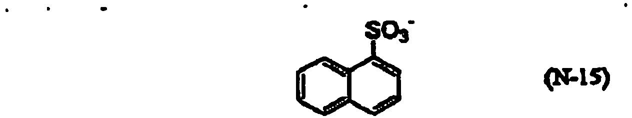

PF₆⁻ (N-16)

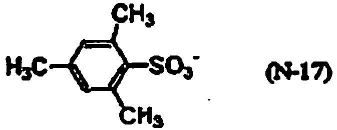

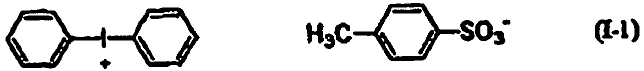

PF₆⁻ (I-2)

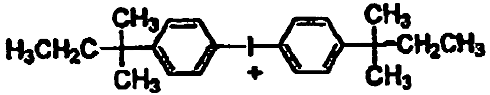

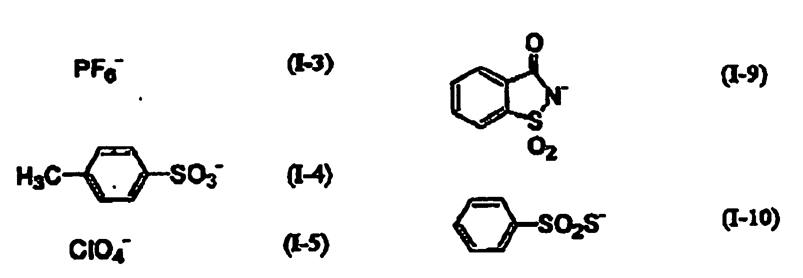

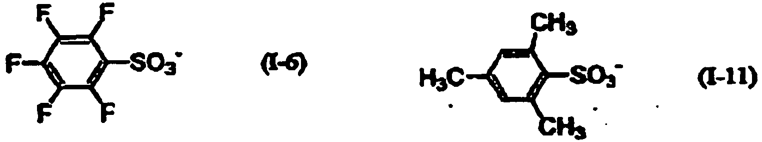

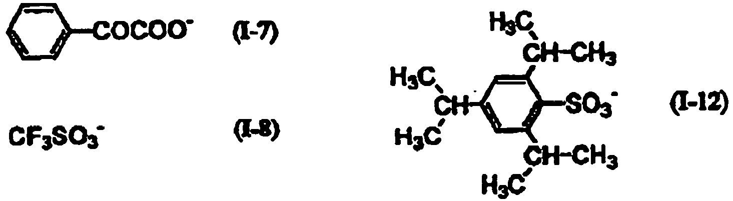

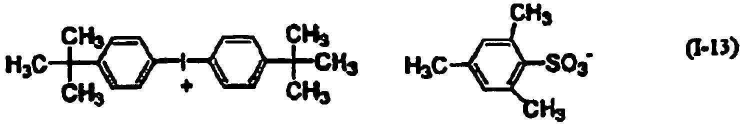

ClO₄⁻ **(I-14)**

PF₆⁻ (I-15)

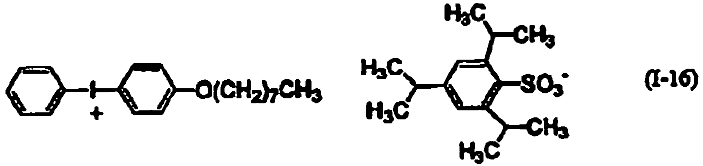

CF₃COO⁻ (I-17)

CF₃SO₃⁻ (I-18)

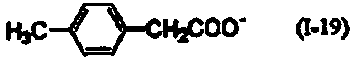

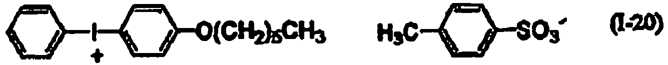

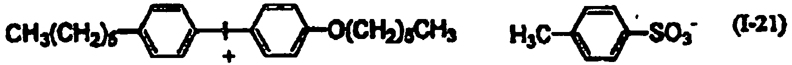

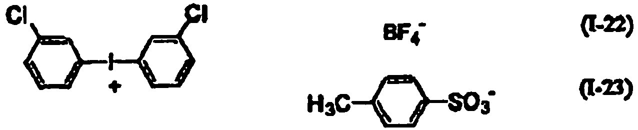

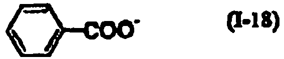

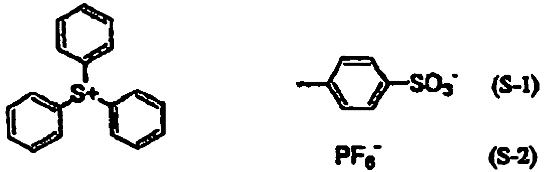

ClO₄⁻ (S-3)

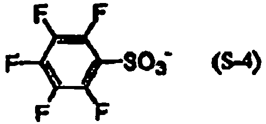

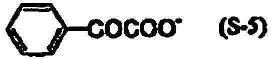

CF₃SO₃⁻ (S-6)

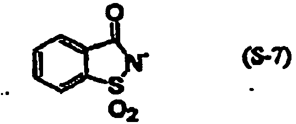

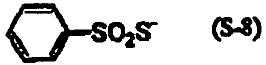

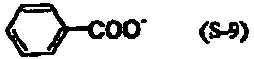

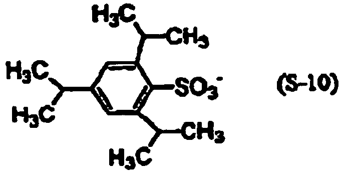

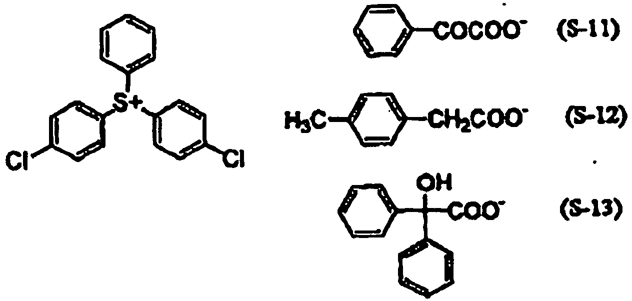

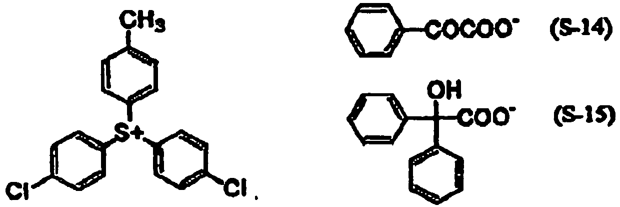

BF₄⁻ (S-16)

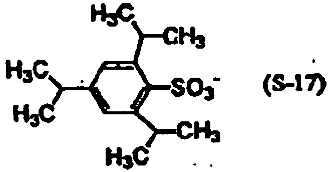

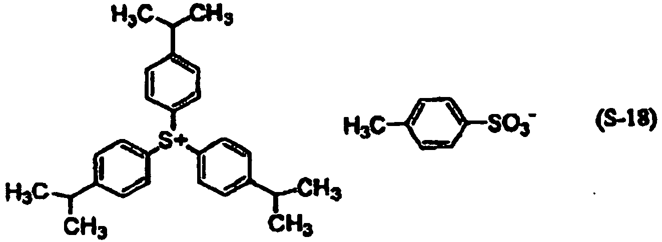

Polymerization initiators are not restricted to the above compounds, but from the aspects of reactivity and stability, a triazine-based initiator, an organohalogen compound, an oxime ester compound, a diazonium salt, an iodonium salt, and a sulfonium salt are more preferred.

These polymerization initiators may be used alone, or two or more may be used in combination. The polymerization initiators may be added to the same layer with other components, or other layer may be provided and added thereto. The polymerization initiators can be added in a ratio of preferably from 0.1 to 50 mass% based on all the solids content constituting the photosensitive layer, more preferably from 0.5 to 30 mass%, and especially preferably from 0.8 to 20 mass%.

### Infrared absorber:

In the photosensitive layer of a lithographic printing plate precursor that is imagewise exposed with light sources of emitting infrared rays, infrared absorbers may be used in combination with the polymerization initiators. Infrared absorbers generally have a function of converting the absorbed infrared rays to heat. A radical is generated by the thermal decomposition of the polymerization initiator by the heat generated at this time. The infrared absorbers for use in the invention are preferably dyes or pigments having an absorption maximum between wavelengths of from 760 to 1,200 nm.

As dyes for this purpose, commercially available dyes and known dyes described in literatures, e.g., in Senryo Binran (Dye Handbook), compiled by Yuki Gosei Kagaku Kyokai (1970) and the like can be used. Specifically, azo dyes, metal complex azo dyes, pyrazolone azo dyes, naphthoquinone dyes, anthraquinone dyes, phthalocyanine dyes, carbonium dyes, quinoneimine dyes, methine dyes, cyanine dyes, squarylium dyes, pyrylium salts, and metal thiolate complexes are exemplified.

As preferred dyes, e.g., the cyanine dyes disclosed in JP-A-58-125246, JP-A-59-84356, and JP-A-60-78787, the methine dyes disclosed in JP-A-58-173696, JP-A-58-181690, and JP-A-58-194595, the naphthoquinone dyes disclosed in JP-A-58-112793, JP-A-58-224793, JP-A-59-48187, JP-A-59-73996, JP-A- 60-52940, and JP-A-60-63744, the squarylium dyes disclosed in JP-A-58-112792, and the cyanine dyes disclosed in British Patent 434,875 are exemplified.

Further, the near infrared absorbing sensitizers disclosed in U.S. Patent 5,156,938 are also preferably used, in addition, the substituted arylbenzo(thio)pyrylium salts disclosed in U.S. Patent 3,881,924, the trimethine thiapyrylium salts disclosed in JP-A-57-142645 (corresponding to U.S. Patent 4,327,169), the pyrylium-based compounds disclosed in JP-A-58-181051, JP-A-58-220143, JP-A-59-41363, JP-A-59-84248, JP-A-59-84249, JP-A-59-146063 and JP-A-59-146061, the cyanine dyes disclosed in JP-A-59-216146, the pentamethine thiopyrylium salts disclosed in U.S. Patent 4,283,475, and the pyrylium compounds disclosed in JP-B-5-13514 and JP-B-5-19702 can also be preferably used. As other examples of preferred dyes, the near infrared absorbing dyes disclosed in U.S. Patent 4,756,993 as the compounds represented by formulae (I) and (II) can be exemplified.

Of these dyes, a cyanine dyestuff, a squarylium dyestuff, a pyrylium salt, a nickel thiolate complex and an indolenine cyanine dyestuff are very preferred. A cyanine dyestuff and an indolenine cyanine dyestuff are more preferred, and a cyanine dyestuff represented by the following formula (I) is exemplified as an especially preferred example.

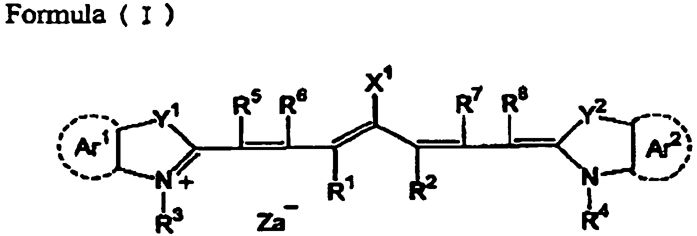

In formula (I), X¹ represents a hydrogen atom, a halogen atom, -NPh₂, X²-L¹, or the following shown group.

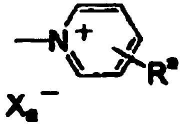

X² in formula (I) represents an oxygen atom, a nitrogen atom, or a sulfur atom; and L¹ represents a hydrocarbon group having from 1 to 12 carbon atoms, an aromatic ring having a hetero atom, or a hydrocarbon group having from 1 to 12 carbon atoms and containing a hetero atom. The hetero atom here means N, S, O, a halogen atom or Se. Xₐ⁻ is defined as the same with the later-described Zₐ⁻, R^{a} represents a substituent selected from a hydrogen atom, an alkyl group, an aryl group, a substituted or unsubstituted amino group, and a halogen atom.

R¹ and R² in formula (I) each represents a hydrocarbon group having from 1 to 12 carbon atoms. In view of the preservation stability of a recording layer coating solution, R¹ and R² each preferably represents a hydrocarbon group having 2 or more carbon atoms, and especially preferably R¹ and R² are bonded to each other to form a 5- or 6-membered ring.

Ar¹ and Ar², which may be the same or different, each represents an aromatic hydrocarbon group that may have a substituent. The examples of preferred aromatic hydrocarbon groups include a benzene ring and a naphthalene ring. The preferred examples of the substituents include a hydrocarbon group having 12 or less carbon atoms, a halogen atom, and an alkoxyl group having 12 or less carbon atoms. Y¹ and Y², which may be the same or different, each represents a sulfur atom or a dialkylmethylene group having 12 or less carbon atoms. R³ and R⁴, which may be the same or different, each represents a hydrocarbon group having 20 or less carbon atoms that may have a substituent. The preferred examples of the substituents include an alkoxyl group having 12 or less carbon atoms, a carboxyl group and a sulfo group. R⁵, R⁶, R⁷ and R⁸, which may be the same or different, each represents a hydrogen atom or a hydrocarbon group having 12 or less carbon atoms, preferably a hydrogen atom because of easy availability of the material. Zₐ⁻ represents a counter anion, provided that when a cyanine dyestuff represented by formula (I) has an anionic substituent within the structure and the neutralization of the electric charge is not necessary, Zₐ⁻ is not necessary. Zₐ⁻ preferably represents a halogen ion, a perchlorate ion, a tetrafluoroborate ion, a hexafluorophosphate ion, or a sulfonate ion for the preservation stability of the recording layer coating solution, and particularly preferably, a perchlorate ion, a hexafluorophosphate ion or an arylsulfonate ion.

As the specific examples of cyanine dyestuffs represented by formula (I) that can be preferably used in the invention, those disclosed in JP-A-2001-133969, paragraphs [0017] to [0019] are exemplified.

Further, as especially preferred other examples, the indolenine cyanine dyestuffs disclosed in JP-A-2002-278057 are exemplified.

As the pigments for use in the invention, commercially available pigments and the pigments described in Color Index (C.I.) Binran (Color Index Bulletin), Shaishin Ganryo Binran (The Latest Pigment Handbook), compiled by Nippon Ganryo Gijutsu Kyokai (1977), Shaishin Ganryo Oyo Gijutsu (The Latest Pigment Applied Techniques), CMC Publishing Co. Ltd. (1986), and Insatsu Ink Gijutsu (Printing Ink Techniques), CMC Publishing Co. Ltd. (1984) can be used.

Various kinds of pigments can be used in the invention, e.g., black pigments, yellow pigments, orange pigments, brown pigments, red pigments, purple pigments, blue pigments, green pigments, fluorescent pigments, metallic powder pigments, and polymer-bond pigments can be exemplified. Specifically, insoluble azo pigments, azo lake pigments, condensation azo pigments, chelate azo pigments, phthalocyanine pigments, anthraquinone pigments, perylene and perinone pigments, thioindigo pigments, quinacridone pigments, dioxazine pigments, isoindolinone pigments, quinophthalone pigments, dyed lake pigments, azine pigments, nitroso pigments, nitro pigments, natural pigments, fluorescent pigments, inorganic pigments, and carbon black can be used. Of these pigments, carbon black is preferably used.

These pigments can be used without surface treatment or may be surface-treated. As the methods of surface treatments, a method of coating the surfaces of pigments with resins and waxes, a method of adhering surfactants, and a method of bonding reactive substances (e.g., silane coupling agents, epoxy compounds, or polyisocyanate) on the surfaces of pigments can be exemplified. These surface treatment methods are described in Kinzoku Sekken no Seishitsu to Oyo (Natures and Applications of Metal Soaps), Saiwai Shobo Co., Ltd., Insatsu Ink Gijutsu (Printing Ink Techniques), CMC Publishing Co., Ltd. (1984), and Shaishin Ganryo Oyo Gijutsu (The Latest Pigment Applied Techniques), CMC Publishing Co., Ltd. (1986).

The particle size of pigments is preferably from 0.01 to 10 µm, more preferably from 0.05 to 1 µm, and especially preferably from 0.1 to 1 µm. When the particle size of pigments is in this range, good stability of the pigment dispersion in a photosensitive layer coating solution and good uniformity of a photosensitive layer can be obtained.

Well-know dispersing methods used in the manufacture of inks and toners can be used as the dispersing methods of the pigments. The examples of dispersing apparatus include an ultrasonic disperser, a sand mill, an attritor, a pearl mill, a super-mill, a ball mill, an impeller, a disperser, a KD mill, a colloid mill, a dynatron, a three-roll mill and a pressure kneader, and details are described in Shaishin Ganryo Oyo Gijutsu (The Latest Pigment Applied Techniques), CMC Publishing Co., Ltd. (1986).

It is preferred that the addition amount of infrared absorbers to a photosensitive layer be the necessary minimum amount for restraining the side reactions hindering the polymerization reaction.

These infrared absorbers can be used in a ratio of from 0.001 to 50 mass% to the total solids content of the photosensitive layer, preferably from 0.005 to 30 mass%, and especially preferably from 0.01 to 10 mass%. When the amount is in this range, high sensitivity can be obtained without adversely affecting the uniformity and film strength of the photosensitive layer.

### Sensitizing dyestuff:

In the photosensitive layer of a lithographic printing plate precursor that is imagewise exposed with light sources of emitting rays of from 250 to 420 nm, by using sensitizing dyestuffs in combination with the polymerization initiators, a radical generating effect can also be enhanced.

The specific examples of the sensitizing dyestuffs include benzoin, benzoin methyl ether, benzoin ethyl ether, 9-fluorenone, 2-chloro-9-fluorenone, 2-methyl-9-fluorenone, 9-anthrone, 2-bromo-9-anthrone, 2-ethyl-9-anthrone, 9,10- anthraquinone, 2-ethyl-9,10-anthraquinone, 2-t-butyl-9,10- anthraquinone, 2,6-dichloro-9,10-anthraquinone, xanthone, 2-methylxanthone, 2-methoxyxanthone, thioxanthone, benzyl, dibenzalacetone, p-(dimethylamino)phenyl styryl ketone, p-(dimethylamino)phenyl p-methyl styryl ketone, benzophenone, p-(dimethylamino)benzophenone (or Michler's ketone), p-(diethylamino)benzophenone, benzanthrone, 2,5-bis(4-diethylaminophenyl)-1,3,4-oxadiazole, etc..

Further, as a sensitizing dyestuff preferably used in the invention, a compound represented by formula (II) disclosed in JP-B-51-48516 is exemplified.

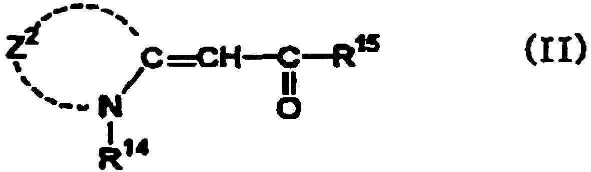

In formula (II), R¹⁴ represents an alkyl group (e.g., a methyl group, an ethyl group, a propyl group, etc.), or a substituted alkyl group (e.g., a 2-hydroxyethyl group, a 2-methoxyethyl group, a carboxymethyl group, a 2-carboxyethyl group, etc.); R¹⁵ represents an alkyl group (e.g., a methyl group, an ethyl group, etc.), or an aryl group (e.g., a phenyl group, a p-hydroxyphenyl group, a naphthyl group, a thienyl group, etc.).

Z² represents a nonmetallic atomic group necessary to form a nitrogen-containing heterocyclic nucleus generally used in cyanine dyestuffs, such as benzothiazoles (e.g., benzothiazole, 5-chlorobenzothiazole, 6-chlorobenzo- thiazole, etc.), naphthothiazoles (e.g., α-naphthothiazole, β-naphthothiazole, etc.), benzoselenazoles (e.g., benzo- selenazole, S-chlorobenzoselenazole, 6-methoxybenzo- selenazole, etc.), naphthoselenazoles (e.g., α-naphtho- selenazole, β-naphthoselenazole, etc.), benzoxazoles (e.g., benzoxazole, 5-methylbenzoxazole, 5-phenylbenzoxazole, etc.), and naphthoxazoles (e.g., α-naphthoxazole, β-naphthoxazole, etc.).

The specific examples of the compounds represented by formula (II) have chemical structures in which Z², R¹⁴ and R¹⁵ are variously combined, and many compounds are present as well-known compounds. Accordingly, the compounds represented by formula (II) can be arbitrarily selected from well-known compounds. As the preferred sensitizing dyestuffs in the invention, the merocyanine dyestuffs disclosed in JP-B-5- 47095 and the ketocoumarin-based compounds represented by the following formula (III) are also exemplified.

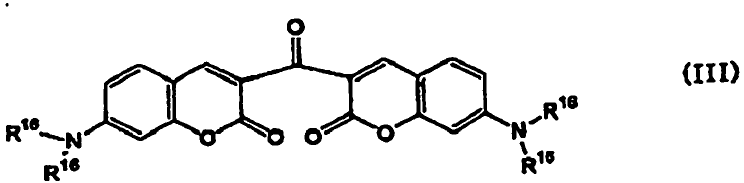

In formula (III), R¹⁶ represents an alkyl group, e.g., a methyl group or an ethyl group.

The merocyanine dyestuffs disclosed in JP-A-2000-147763 can also be used as the sensitizing dyestuffs. The sensitizing dyestuffs disclosed in JP-A-2001-100412 can also be preferably used.

Of the sensitizing dyestuffs having absorption maximum in the wavelength region of from 360 to 450 nm, a dyestuff represented by the following formula (IX) is preferably used from the viewpoint of high sensitivity.

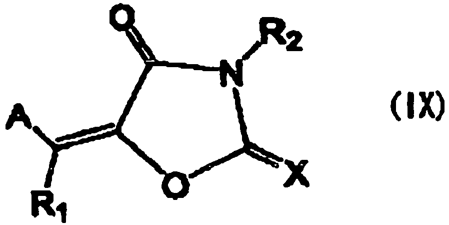

In formula (IX), A represents an aromatic ring or a heterocyclic ring that may have a substituent; X represents an oxygen atom, a sulfur atom, or N-(R₃); R₁, R₂ and R₃ each represents a hydrogen atom or a monovalent nonmetallic atomic group, and A and R₁, and R₂ and R₃ may be bonded to each other to form an aliphatic or aromatic ring.

Formula (IX) is described in further detail. R¹, R² and R³ each represents a hydrogen atom or a monovalent nonmetallic atomic group, and preferably represents a substituted or unsubstituted alkyl group, a substituted or unsubstituted alkenyl group, a substituted or unsubstituted aryl group, a substituted or unsubstituted aromatic heterocyclic residue, a substituted or unsubstituted alkoxyl group, a substituted or unsubstituted alkylthio group, a hydroxyl group, or a halogen atom.

The preferred examples of R¹, R² and R³ are specifically described. As the preferred examples of the alkyl groups, straight chain, branched or cyclic alkyl groups having from 1 to 20 carbon atoms can be exemplified, and the specific examples include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eicosyl group, an isopropyl group, an isobutyl group, an s-butyl group, a t-butyl group, an isopentyl group, a neopentyl group, a 1-methylbutyl group, an isohexyl group, a 2-ethylhexyl group, a 2-methylhexyl group, a cyclohexyl group, a cyclopentyl group, and a 2-norbomyl group. Of these alkyl groups, straight chain alkyl groups having from 1 to 12 carbon atoms, branched alkyl groups having from 3 to 12 carbon atoms, and cyclic alkyl groups having from 5 to 10 carbon atoms are more preferred.

As the substituents of the substituted alkyl groups, monovalent nonmetallic atomic groups exclusive of hydrogen are used, and the preferred examples thereof include a halogen atom (-F, -Br, -Cl, -I), a hydroxyl group, an alkoxyl group, an aryloxy group, a mercapto group, an alkylthio group, an arylthio group, an alkyldithio group, an aryldithio group, an amino group, an N-alkylamino group, an N,N-dialkylamino group, an N-arylamino group, an N,N-diarylamino group, an N-alkyl- N-arylamino group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbamoyloxy group, an alkylsulfoxy group, an arylsulfoxy group, an acylthio group, an acylamino group, an N-alkylacylamino group, an N-arylacylamino group, a ureido group, an N'-alkylureido group, an N',N'-dialkyl- ureido group, an N'-arylureido group, an N',N'-diarylureido group, an N'-alkyl-N'-arylureido group, an N-alkylureido group, an N-arylureido group, an N'-alkyl- N-alkylureido group, an N'-alkyl-N-arylureido group, an N',N'-dialkyl-N-alkyl- ureido group, an N',N'-dialkyl-N-arylureido group, an N'-aryl-N-alkylureido group, an N'-aryl- N-arylureido group, an N',N'-diaryl-N-alkylureido group, an N',N'-diaryl-N-aryl- ureido group, an N'-alkyl-N'-aryl-N- alkylureido group, an N'-alkyl-N'-aryl-N-arylureido group, an alkoxycarbonylamino group, an aryloxycarbonylamino group, an N-alkyl-N-alkoxy-carbonylamino group, an N-alkyl-N-aryloxycarbonylamino group, an N-aryl-N-alkoxycarbonylamino group, an N-aryl-N-aryloxy- carbonylamino group, a formyl group, an acyl group, a carboxyl group, an alkoxycarbonyl group, an aryloxycarbonyl group, a carbamoyl group, an N-alkylcarbamoyl group, an N,N-dialkyl-carbamoyl group, an N-arylcarbamoyl group, an N,N-diaryl- carbamoyl group, an N-alkyl-N-arylcarbamoyl group, an alkylsulfinyl group, an arylsulfinyl group, an alkylsulfonyl group, an arylsulfonyl group, a sulfo group (-SO₃H) and a conjugate base group thereof (hereinafter referred to as a sulfonato group), an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, a phosphono group (-PO₃H₂) and a conjugate base group thereof (hereinafter referred to as a phosphonato group), a dialkylphosphono group (-PO₃(alkyl)₂), a diarylphosphono group (-PO₃(aryl)₂), an alkylarylphosphono group (-PO₃(alkyl)- (aryl)), a monoalkylphosphono group (-PO₃H(alkyl)) and a conjugate base group thereof (hereinafter referred to as an alkylphosphonato group), a monoarylphosphono group (-PO₃H(aryl)) and a conjugate base group thereof (hereinafter referred to as an arylphosphonato group), a phosphonoxy group (-OPO₃H₂) and a conjugate base group thereof (hereinafter referred to as a phosphonatoxy group), a dialkylphosphonoxy goup (-OPO₃(alkyl)₂), a diarylphosphonoxy group (-OPO₃(aryl)2), an alkylarylphosphonoxy group (-OPO₃(alkyl)- (aryl)), a monoalkylphosphonoxy group (-OPO₃H(alkyl)) and a conjugate base group thereof (hereinafter referred to as an alkylphosphonatoxy group), a monoarylphosphonoxy group (-OPO₃H(aryl)) and a conjugate base group thereof (hereinafter referred to as an arylphosphonatoxy group), a cyano group, a nitro group, an aryl group, a heteroaryl group, an alkenyl group, and an alkynyl group.

As the specific examples of the alkyl groups in these substituents, the above alkyl groups are exemplified. The specific examples of the aryl groups include a phenyl group, a biphenyl group, a naphthyl group, a tolyl group, a xylyl group, a mesityl group, a cumenyl group, a chlorophenyl group, a bromophenyl group, a chloromethylphenyl group, a hydroxy- phenyl group, a methoxyphenyl group, an ethoxyphenyl group, a phenoxyphenyl group, an acetoxyphenyl group, a benzoyloxy- phenyl group, a methylthiophenyl group, a phenylthiophenyl group, a methylaminophenyl group, a dimethylaminophenyl group, an acetylaminophenyl group, a carboxyphenyl group, a methoxy- carbonylphenyl group, an ethoxycarbonylphenyl group, a phenoxycarbonylphenyl group, an N-phenylcarbamoylphenyl group, a phenyl group, a cyanophenyl group, a sulfophenyl group, a sulfonatophenyl group, a phosphonophenyl group, a phosphonatophenyl group, etc..

As the preferred heteroaryl groups represented by R₁, R₂ and R₃, monocyclic or polycyclic aromatic rings containing at least one of nitrogen, oxygen and sulfur atoms are used. The examples of especially preferred heteroaryl groups include, e.g., thiophene, thiathrene, furan, pyran, isobenzofuran, chromene, xanthene, phenoxazine, pyrrole, pyrazole, isothiazole, isoxazole, pyrazine, pyrimidine, pyridazine, indolizine, isoindolizine, indoyl, indazole, purine, quinolizine, isoquinoline, phthalazine, naphthyridine, quinazoline, cinnoline, pteridine, carbazole, carboline, phenanthrine, acridine, perimidine, phenanthroline, phthalazine, phenarsazine, phenoxazine, furazane, etc.. These heteroaryl rings may further be benzo-condensed or may have a substituent.

As the examples of the preferred alkenyl groups represented by R₁, R₂ and R₃, a vinyl group, a 1-propenyl group, a 1-butenyl group, a cinnamyl group, a 2-chloro-1-ethenyl group, etc., are exemplified, and as the examples of the alkynyl groups, an ethynyl group, a 1-propynyl group, a 1-butynyl group, a trimethylsilylethynyl group, etc., are exemplified. As G₁ in the acyl group (G₁CO-), a hydrogen atom and the above alkyl groups and aryl groups can be exemplified. Of these substituents, the more preferred examples include a halogen atom (-F, -Br, -Cl, -I), an alkoxyl group, an aryloxy group, an alkylthio group, an arylthio group, an N-alkylamino group, an N,N-dialkylamino group, an acyloxy group, an N-alkyl- carbamoyloxy group, an N-arylcarbamoyloxy group, an acylamino group, a formyl group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N-alkyl-N-arylcarbamoyl group, a sulfo group, a sulfonato group, a sulfamoyl group, an N-alkylsulfamoyl group, an N,N-dialkylsulfamoyl group, an N-arylsulfamoyl group, an N-alkyl-N-arylsulfamoyl group, a phosphono group, a phosphonato group, a dialkylphosphono group, a diarylphosphono group, a monoalkylphosphono group, an alkyl- phosphonato group, a monoarylphosphono group, an aryl- phosphonato group, a phosphonoxy group, a phosphonatoxy group, an aryl group, and an alkenyl group.

On the other hand, as alkylene groups in the substituted alkyl groups, divalent organic residues obtained by removing any one hydrogen atom on the above alkyl groups having from 1 to 20 carbon atoms can be exemplified, preferably straight chain alkylene groups having from 1 to 12 carbon atoms, branched alkylene groups having from 3 to 12 carbon atoms, and cyclic alkylene groups having from 5 to 10 carbon atoms are exemplified.

The specific examples of the preferred substituted alkyl groups represented by R₁, R₂ or R₃ obtained by combining any of the above substituents and an alkylene group include a chloromethyl group, a bromomethyl group, a 2-chloroethyl group, a trifluoromethyl group, a methoxymethyl group, a methoxy- ethoxyethyl group, an allyloxymethyl group, a phenoxymethyl group, a methylthiomethyl group, a tolylthiomethyl group, an ethylaminoethyl group, a diethylaminopropyl group, a morpholinopropyl group, an acetyloxymethyl group, a benzoyloxymethyl group, an N-cyclohexylcarbamoyloxyethyl group, an N-phenylcarbamoyloxyethyl group, an acetylamino- ethyl group, an N-methylbenzoylaminopropyl group, a 2-oxo- ethyl group, a 2-oxopropyl group, a carboxypropyl group, a methoxycarbonylethyl group, an allyloxycarbonylbutyl group, a chlorophenoxycarbonylmethyl group, a carbamoylmethyl group, an N-methylcarbamoylethyl group, an N,N-dipropylcarbamoyl- methyl group, an N-(methoxyphenyl)carbamoylethyl group, an N-methyl-N-(sulfophenyl)carbamoylmethyl group, a sulfobutyl group, a sulfonatobutyl group, a sulfamoylbutyl group, an N-ethylsulfamoylmethyl group, an N,N-dipropylsulfamoyl- propyl group, an N-tolylsulfamoylpropyl group, an N-methyl-N- (phosphonophenyl)sulfamoyloctyl group, a phosphonobutyl group, a phosphonatohexyl group, a diethylphosphonobutyl group, a diphenylphosphonopropyl group, a methylphosphono- butyl group, a methylphosphonatobutyl group, a tolyl- phosphonohexyl group, a tolylphosphonatohexyl group, a phosphonoxypropyl group, a phosphonatoxybutyl group, a benzyl group, a phenethyl group, an α-methylbenzyl group, a 1-methyl-1-phenylethyl group, a p-methylbenzyl group, a cinnamyl group, an allyl group, a 1-propenylmethyl group, a 2-butenyl group, a 2-methylallyl group, a 2-methylpropenyl- methyl group, a 2-propynyl group, a 2-butynyl group, a 3-butynyl group, etc.

As the specific examples of preferred aryl groups represented by R₁, R₂ or R₃, rings formed by condensation of from 1 to 3 benzene rings, and rings formed by condensation of benzene rings and 5-membered unsaturated rings are exemplified. Specifically, a phenyl group, a naphthyl group, an anthryl group, a phenanthryl group, an indenyl group, an acenaphthenyl group, and a fluorenyl group can be exemplified, and of these groups, a phenyl group and a naphthyl group are more preferred.

As the specific examples of preferred substituted aryl groups represented by R¹, R² or R³, aryl groups having monovalent nonmetallic atomic groups exclusive of a hydrogen atom as the substituents on the above ring-forming carbon atoms of the aryl groups are exemplified. As the examples of preferred substituents, the above alkyl groups, substituted alkyl groups, and the groups described above as the substituents of the substituted alkyl groups can be exemplified. As the specific examples of preferred substituted aryl groups, a biphenyl group, a tolyl group, a xylyl group, a mesityl group, a cumenyl group, a chlorophenyl group, a bromophenyl group, a fluorophenyl group, a chloromethylphenyl group, a trifluoromethylphenyl group, a hydroxyphenyl group, a methoxyphenyl group, a methoxyethoxy- phenyl group, an allyloxyphenyl group, a phenoxyphenyl group, a methylthiophenyl group, a tolylthiophenyl group, an ethylaminophenyl group, a diethylaminophenyl group, a morpholinophenyl group, an acetyloxyphenyl group, a benzoyloxyphenyl group, an N-cyclohexylcarbamoyloxyphenyl group, an N-phenylcarbamoyloxyphenyl group, an acetylamino- phenyl group, an N-methylbenzoylaminophenyl group, a carboxy- phenyl group, a methoxycarbonylphenyl group, an allyloxy- carbonylphenyl group, a chlorophenoxycarbonylphenyl group, a carbamoylphenyl group, an N-methylcarbamoylphenyl group, an N,N-dipropylcarbamoylphenyl group, an N-(methoxyphenyl)- carbamoylphenyl group, an N-methyl-N-(sulfophenyl)carbamoyl- phenyl group, a sulfophenyl group, a sulfonatophenyl group, a sulfamoylphcnyl group, an N-ethylsulfamoylphenyl group, an N,N-dipropylsulfamoylphenyl group, an N-tolylsulfamoylphenyl group, an N-methyl-N-(phosphonophenyl)sulfamoylphenyl group, a phosphonophenyl group, a phosphonatophenyl group, a diethylphosphonophenyl group, a diphenylphosphonophenyl group, a methylphosphonophenyl group, a methylphosphonato- phenyl group, a tolylphosphonophenyl group, a tolyl- phosphonatophenyl group, an allyl group, a 1-propenylmethyl- phenyl group, a 2-butenylphenyl group, a 2-methylallylphenyl group, a 2-methylpropenylphenyl group, a 2-propynylphenyl group, a 2-butynylphenyl goup, a 3-butynylphenyl group, etc., can be exemplified.

In the next place, A in formula (IX) is described. A represents an aromatic ring or a heterocyclic ring that may have a substituent, and as the specific examples of the aromatic rings or heterocyclic rings that may have a substituent, the same examples as described in R₁, R₂ and R₃ in formula (IX) can be exemplified.

The sensitizing dyestuff represented by formula (IX) is obtained by a condensation reaction of the above acidic nucleus or an acidic nucleus having an active methylene group with a substituted or unsubstituted aromatic ring or heterocyclic ring, and JP-B-59-28329 can be referred to in the synthesis.

The preferred specific examples (D1) to (D75) of the compounds represented by formula (IX) are shown below. With respect to the isomers by a double bond bonding an acidic nucleus and a basic nucleus, they are not restricted to either isomer.

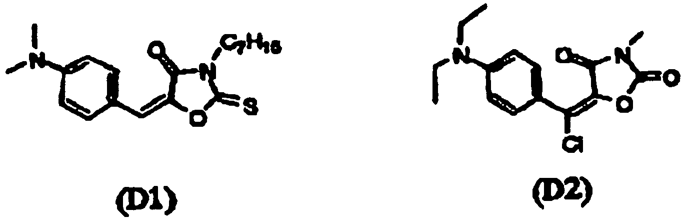

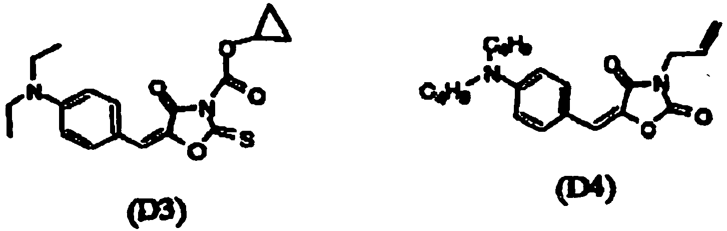

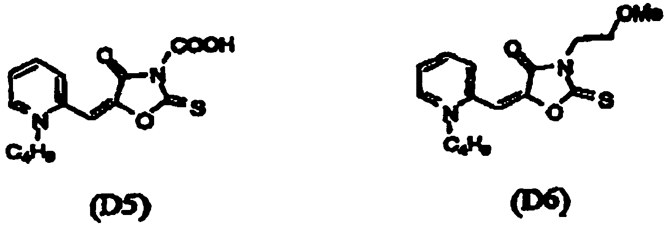

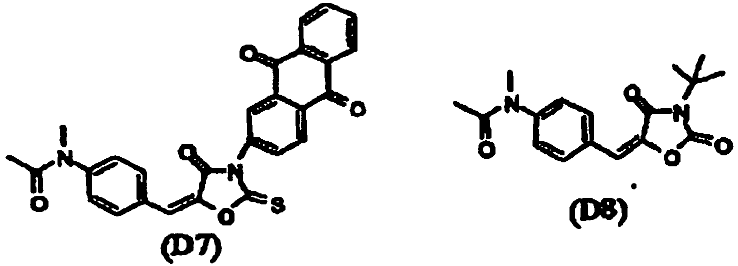

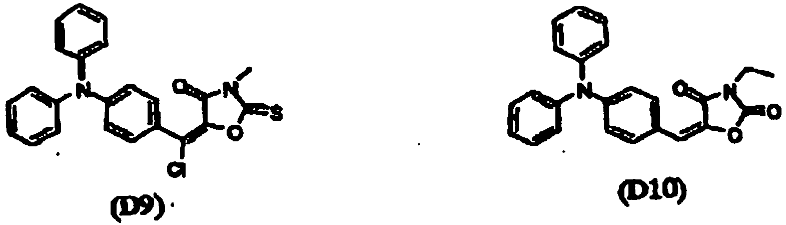

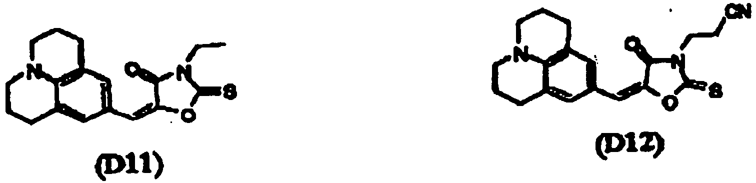

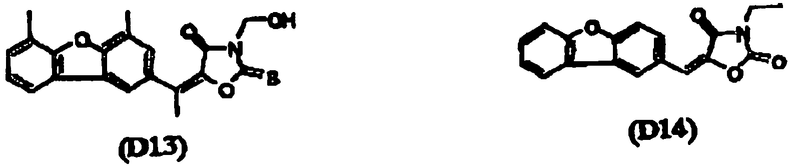

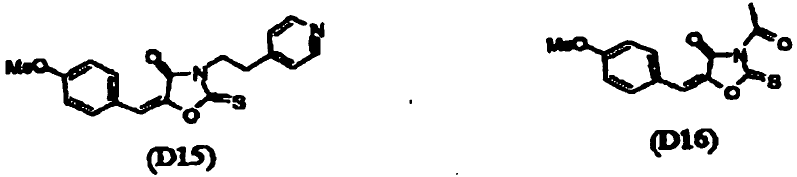

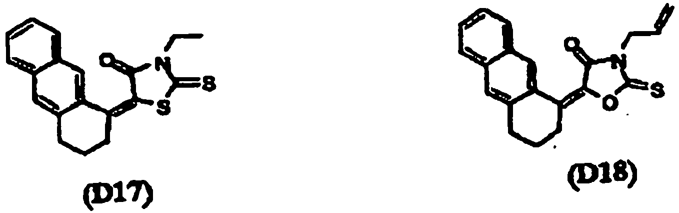

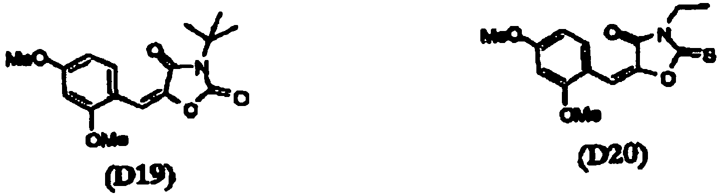

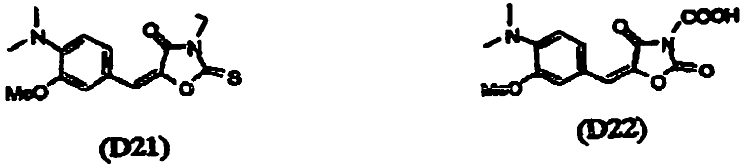

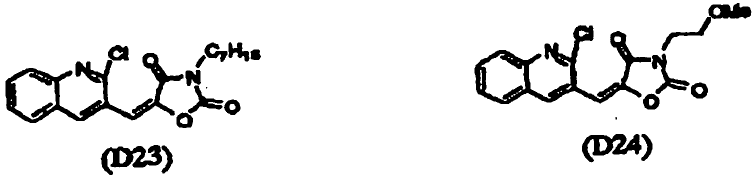

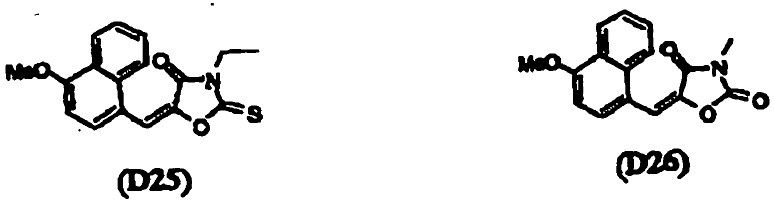

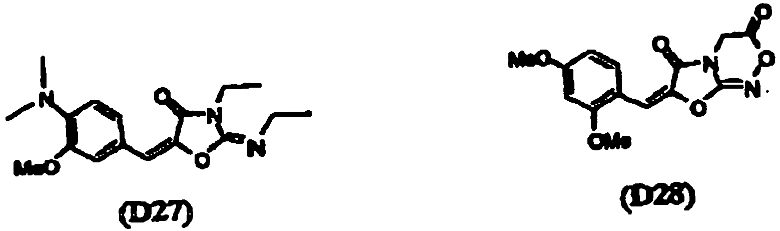

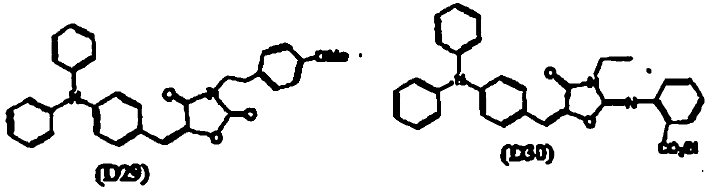

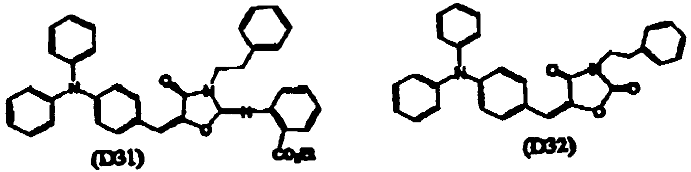

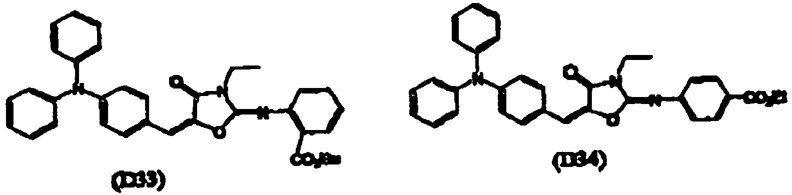

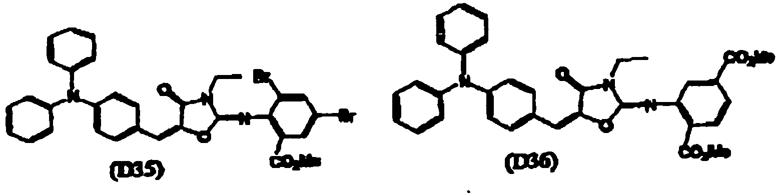

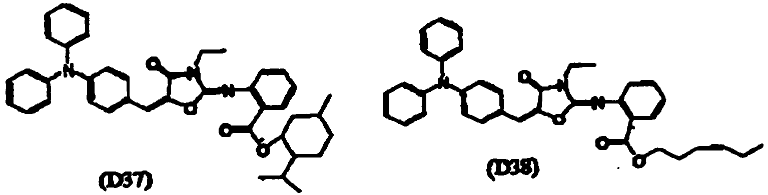

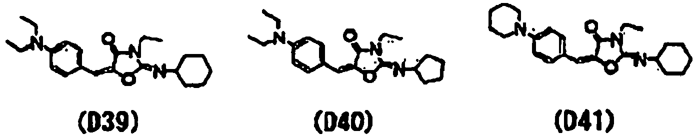

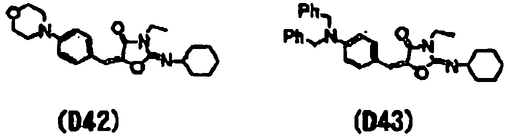

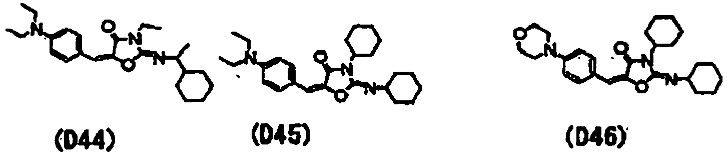

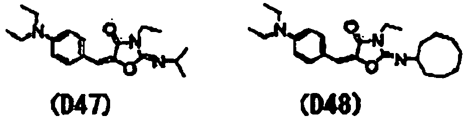

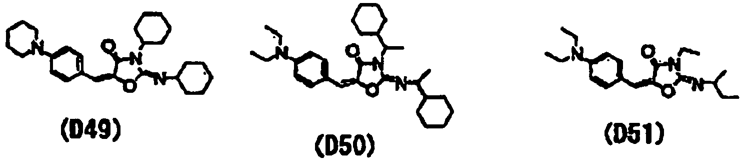

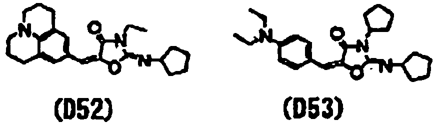

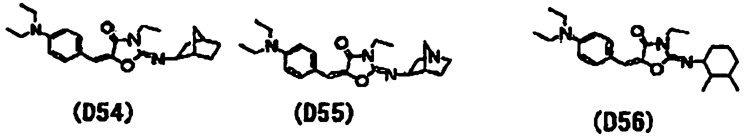

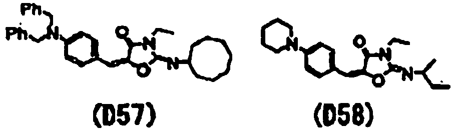

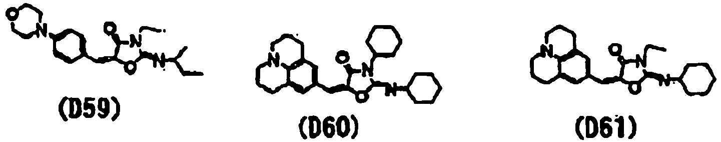

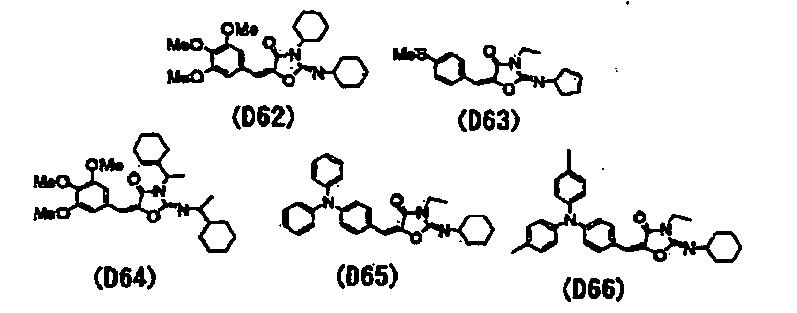

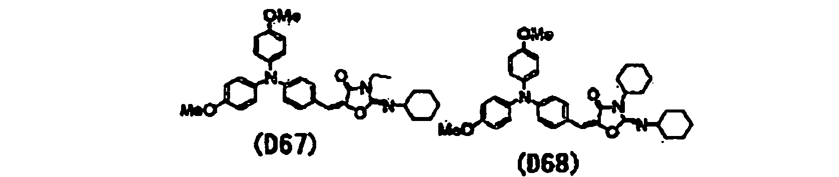

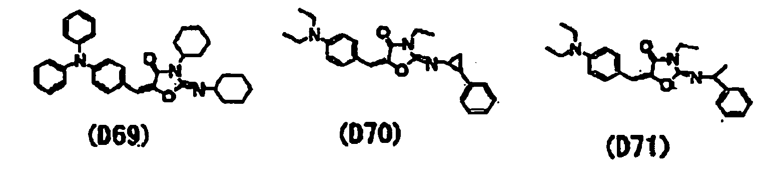

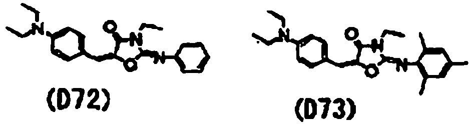

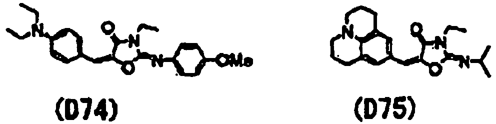

The details in usage of the dyestuffs, e.g., what a structure of dyestuffs is to be used, whether the sensitizing dyestuff is to be used alone or two or more kinds are to be used, and what an amount is to be used, can be arbitrarily set up according to the final design of the performances of the photosensitive material.

For example, the compatibility with the layer containing a photosensitive composition can be heightened by the use of two or more kinds of sensitizing dyestuffs in combination. In the selection of sensitizing dyestuffs, the molar extinction coefficient at the emission wavelength of the light source to be used is an important factor, in addition to photosensitivity. By the use of a dyestuff having a large molar extinction coefficient, the addition amount of the dyestuff can be relatively reduced, which is not only economical but also advantageous from the viewpoint of the physical properties of the photosensitive layer when the dyestuff is used in a lithographic printing plate precursor. Since the sensitivity and resolution of a photosensitive layer and the physical properties of an exposed layer are greatly influenced by the extinction at the wavelength of the light source, the addition amount of the sensitizing dyestuff is determined considering these factors.

These sensitizing dyestuffs can be used in the ratio of from 0.1 to 50 mass% based on the total solids content constituting the photosensitive layer, more preferably from 0.5 to 30 mass%, and especially preferably from 0.8 to 20 mass%.

### Polymerizable compound:

The polymerizable compounds for use in a photosensitive layer in the invention are addition polymerizable compounds having at least one ethylenic unsaturated double bond, and they are selected from the compounds having at least one, preferably two or more, terminal ethylenic unsaturated bond. These compounds are well known in the field of this industry, and they can be used with no particular limitation in the invention. These polymerizable compounds have chemical forms of, e.g., a monomer, a prepolymer, i.e., a dimer, a trimmer, an oligomer, or a mixture and a copolymer of thern. As the examples of monomers and the copolymers thereof, unsaturated carboxylic acids (e.g., acrylic acid, methacrylic acid, itaconic acid, crotonic acid, isocrotonic acid, maleic acid, etc.), and esters and amides of these unsaturated carboxylic acids are exemplified, and preferably esters of unsaturated carboxylic acids and aliphatic polyhydric alcohol compounds, and amides of unsaturated carboxylic acids and aliphatic polyhydric amine compounds are used. Further, the addition reaction products of esters and amides of unsaturated carboxylic acids having a nucleophilic substituent such as a hydroxyl group, an amino group or a mercapto group with monofunctional or polyfunctional isocyanates or epoxies, and the dehydration condensation reaction products with monofunctional or polyfunctional carboxylic acids are also preferably used. Furthermore, the addition reaction products of unsaturated carboxylic esters or amides having an electrophilic substituent such as an isocyanate group or an epoxy group with monofunctional or polyfunctional alcohols, amines or thiols, and the substitution reaction products of unsaturated carboxylic esters or amides having a separable substituent such as a halogen group or a tosyloxy group with monofunctional or polyfunctional alcohols, amines or thiols are also preferably used. As other examples, it is also possible to use compounds in which the unsaturated carboxylic acids are replaced with unsaturated phosphonic acid, styrene, vinyl ether, etc.

The specific examples of the ester monomers of aliphatic polyhydric alcohol compounds and unsaturated carboxylic acids include, as acrylic esters, ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypmpyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate, isocyanuric acid ethylene oxide (EO)-modified triacrylate, polyester acrylate oligomer, etc.

As methacrylic esters, the examples include tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[p-(3-methacryloxy-2-hydroxypropoxy)-phenyl]dimethylmethane, bis[p-(methacryloxyethoxy)phenyl]- dimethylmethane, etc.

As itaconic esters, the examples include ethylene glycol diitaconate, propylene glycol diitaconate, 1,3-butanediol diitaconate, 1,4-butanediol diitaconate, tetramethylene glycol diitaconate, pentaerythritol diitaconate, sorbitol tetraitaconate, etc. As crotonic esters, the examples include ethylene glycol dicrotonate, tetramethylene glycol dicrotonate, pentaerythritol dicrotonate, sorbitol tetradicrotonate, etc. As isocrotonic esters, the examples include ethylene glycol diisocrotonate, pentaerythritol diisocrotonate, sorbitol tetraisocrotonate, etc. As maleic esters, the examples include ethylene glycol dimaleate, triethylene glycol dimaleate, pentaerythritol dimaleate, sorbitol tetramaleate, etc.

As the examples of other esters, e.g., the aliphatic alcohol esters disclosed in JP-B-51-47334 and JP-A-57-196231, the esters having an aromatic skeleton disclosed in JP-A-59- 5240, JP-A-59-5241 and JP-A-2-226149, and the esters containing an amino group disclosed in JP-A-1-165613 are also preferably used in the present invention. The above ester monomers can also be used as mixtures.

Further, the specific examples of the amide monomers of aliphatic polyhydric amine compounds and unsaturated carboxylic acids include methylenebis-acrylamide, methylenebis-methacrylamide, 1,6-hexamethylenebis- acrylamide, 1,6-hexamethylenebis-methacrylamide, diethylenetriaminetris-acrylamide, xylylenebis-acrylamide, xylylenebis-methacrylamide, etc. As the examples of other preferred amide monomers, the monomers having a cyclohexylene structure disclosed in JP-B-54-21726 can be exemplified.

Further, urethane-based addition polymerizable compounds manufactured by the addition reaction of isocyanate and hydroxyl groups are also preferably used. As the specific examples of such compounds, as is disclosed in JP-B-48-41708, a vinyl urethane compound containing two or more polymerizable vinyl groups in one molecule obtained by adding vinyl monomer containing a hydroxyl group represented by the following formula (A) to a polyisocyanate compound having two or more isocyanate groups in one molecule is exemplified.

CH₂=C(R₄)COOCH₂CH(R₅)OH (A)

wherein R₄ and R₅ each represents H or CH₃.

The urethane acrylates disclosed in JP-A-51-37193, JP-B-2-32293, and JP-B-2-16765, and the urethane compounds having an ethylene oxide skeleton disclosed in JP-B-58-49860, JP-B-56-17654, JP-B-62-39417 and JP-B-62-39418 are also preferably used in the invention. In addition, extremely high speed photopolymerizable compositions can be obtained by using addition polymerizable compounds having an amino structure and a sulfide structure in the molecule as disclosed in JP-A-63-277653, JP-A-63-260909 and JP-A-1-105238.

As other examples, the polyfunctional acrylates and methacrylates, such as polyester acrylates, and epoxy acrylates obtained by reacting epoxy resins with (meth)acrylic acids as disclosed in JP-A-48-64183, JP-B-49-43191 and JP-B-52-30490 can be exemplified. The specific unsaturated compounds disclosed in JP-B-46-43946, JP-B-1-40337 and JP-B-1-40336, and the vinylsulfonic acid compounds disclosed in JP-A-2-25493 can also be exemplified. Further, according to cases, the structures containing a perfluoroalkyl group disclosed in JP-A-61-22048 are preferably used. Moreover, the compounds introduced, as photo-curable monomers and oligomers, into Bulletin of Nippon Setchaku Kyokai, Vol. 20, No. 7, pp. 300-308 (1984) can also be used.

The details in usage of these polymerizable compound, e.g., what a structure is to be used, whether the compound is to be used alone or in combination, or what an amount is to be used, can be optionally set up according to the final design of the performances of the lithographic printing plate precursor. For example, the conditions are selected from the viewpoint as follows.

In the point of sensitivity, the structure containing many unsaturated groups per a molecule is preferred and bifunctional or higher functional groups are preferred in many cases. For increasing the strength of an image area, i.e., a hardened film, trifunctional or higher functional groups are preferred, and it is also effective to use different functional numbers and different polymerizable groups (e.g., acrylate, methacrylate, styrene compounds, vinyl ether compounds) in combination to control both speed and strength.

Further, the selection and usage of the polymerizable compounds are important factors for the compatibility with other components (e.g., a binder polymer, a polymerization initiator, a colorant, etc.) in a photosensitive layer and dispersibility, for example, sometimes compatibility can be improved by using a low purity compound or two or more compounds in combination. Further, it is also possible to select a specific structure for the purpose of improving the adhesion property with a support and a protective layer described later.

The polymerizable compounds are used preferably in the proportion of from 5 to 80 mass% based on the total solids content of the photosensitive layer, and more preferably from 25 to 75 mass%. They may be used alone, or two or more compounds may be used in combination. In addition, as for the usage of the polymerizable compound, the structure, composition and addition amount can be properly selected in view of the degree of polymerization hindrance by oxygen, resolution, a fogging property, change in refractive index, surface tackiness, etc. Further, in some cases, a layer constitution and a coating method of undercoat and overcoat may be taken.

### Co-sensitizer:

The sensitivity of a photosensitive layer can be bettered by the addition of certain kinds of additives (hereinafter referred to as co-sensitizers). The mechanism of the function of the co-sensitizers is not clear, but it is supposed to be based on the following chemical processes. That is, it is presumed that various intermediate active seeds (radicals, peroxides, oxidants, reductants, and the like), which are generated in the processes of the photo-reaction initiated by the absorption of light of the photopolymerization initiator system and succeeding addition polymerization reaction, are reacted with a co-sensitizer to thereby generate new active radicals. These compounds are roughly classified into (a) compounds capable of generating active radicals on reduction, (b) compounds capable of generating active radicals on oxidation, and (c) compounds that react with radicals low in activity and convert them to higher radicals, or function as chain transfer agents. However, in many cases common opinion is not established concerning to which group individual compound belongs.

### (a) Compound generating active radicals on reduction:

### Compounds having a carbon-halogen bond:

It is thought that a carbon-halogen bond is cleaved on reduction to generate active radicals. Specifically, e.g., trihalomethyl-s-triazines, trihalomethyl oxadiazoles and the like can be preferably used.

### Compounds having a nitrogen-nitrogen bond:

It is thought that a nitrogen-nitrogen bond is cleaved on reduction to generate active radicals. Specifically, e.g., hexaarylbiimidazoles and the like can be preferably used.

### Compounds having an oxygen-oxygen bond:

It is thought that an oxygen-oxygen bond is cleaved on reduction to generate active radicals. Specifically, e.g., organoperoxides and the like can be preferably used.

### Onium compounds:

It is thought that a carbon-hetero bond and an oxygen-nitrogen bond are cleaved on reduction to generate active radicals. Specifically, e.g., diaryl iodonium salts, triaryl sulfonium salts, N-alkoxy pyridinium (azinium) salts and the like can be preferably used. Ferrocene, iron allene complexs:

These compounds can form active radicals on reduction.

### (b) Compound generating active radicals on oxidation:

### Alkylate complex:

It is thought that a carbon-hetero bond is cleaved by oxidation to thereby generate active radicals. Specifically, e.g., triarylalkyl borates can be preferably used.

### Alkylamine compounds:

It is thought that a C-X bond on the carbon contiguous to nitrogen is cleaved by oxidation to thereby generate active radicals. X preferably represents a hydrogen atom, a carboxyl group, a trimethylsilyl group, a benzyl group, or the like. Specifically, ethanolamines, N-phenylglycines, N-trimethyl- silylmethyl anilines, etc., are exemplified. Sulfur-containing and tin-containing compounds:

Compounds obtained by substituting the nitrogen atoms in the above amines with sulfur atoms and tin atoms can form active radicals by the similar function. It is also known that compounds having an S-S bond show sensitization by the cleavage of the S-S bond.

### α-Substituted methylcarbonyl compounds:

These compounds can form active radicals by the cleavage of a carbonyl-α carbon bond by oxidation. The compounds obtained by substituting the carbonyl with oxime ether have also the similar function. Specifically, 2-alkyl-1-[4-(alkylthio)phenyl]-2-morpholinopronone-1's, and oxime ethers obtained by reacting the above compounds with hydroxylamines and then etherifying N-OH can be exemplified. Sulfinates:

These compounds can form active radicals on reduction. Specifically, sodium arylsulfinate and the like can be exemplified.

### (c) Compounds that react with radicals and convert them to higher active radicals, or function as chain transfer agents:

As the compounds that react with radicals and convert them to higher active radicals, or function as chain transfer agents, compounds having SH, PH, SiH, GeH in the molecules are used. These compounds can donate hydrogen to radical seeds low in activity to thereby generate radicals, or can generate radicals by deprotonation after oxidation. Specifically, 2-mercaptobenzimidazoles and the like can be exemplified.

Many specific examples of these co-sensitizers are disclosed, e.g., in JP-A-9-236913 as additives aiming to improve sensitivity. Some of these compounds are exemplified below, however the invention is not restricted thereto.

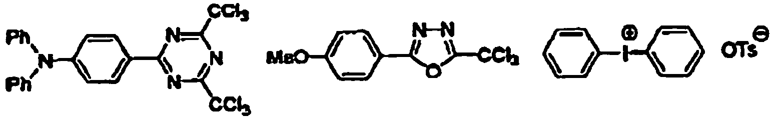

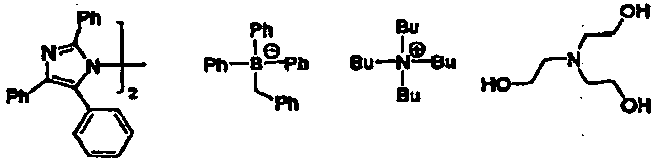

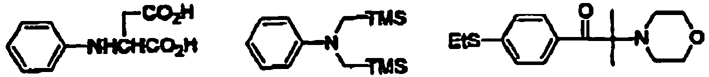

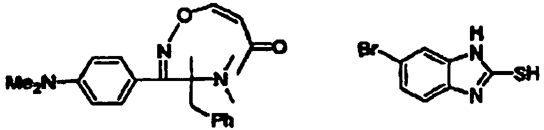

Similarly to the above-described sensitizing dyestuffs, it is also possible to subject these co-sensitizers to various chemical modifications in order to enhance the characteristics of the photosensitive layer of a lithographic printing plate precursor. For example, the methods of bonding with sensitizing dyestuffs and titanocene, addition polymerizable unsaturated compounds and other radical-generating parts, introduction of hydrophilic sites, improvement of compatibility, introduction of substituents for restraining crystal precipitation, introduction of substituents for the purpose of increasing adhesion, and polymerization can be utilized. These co-sensitizers can be used alone or two or more in combination. The use amount is from 0.05 to 100 mass parts per 100 mass parts of the compound having an ethylenic unsaturated double bond, preferably from 1 to 80 mass parts, and more preferably from 3 to 50 mass parts.

### Microcapsule:

For adding the above constitutional components of a photosensitive layer and other constitutional components described later to a photosensitive layer, e.g., a part of the constitutional components can be encapsulated in microcapsules and added to a photosensitive layer as disclosed in JP-A-2001- 277740 and JP-A-2001-277742. In such a case, it is possible to contain the constitutional components in and out of the microcapsules in an arbitrary ratio.

Constitutional components of a photosensitive layer can be microencapsulated by well-known methods. For example, as the manufacturing method of microcapsules, the method making use of coacervation as disclosed in U.S. Patents 2,800,457 and 2,800,458, the interfacial polymerization method as disclosed in U.S. Patent 3,287,154, JP-B-38-19574 and JP-B-42-446, the method by the precipitation of a polymer as disclosed in U.S. Patents 3,418,250 and 3,660,304, the method of using isocyanate polyol wall materials as disclosed in U.S. Patent 3,796,669, the method of using isocyanate wall materials as disclosed in U.S. Patent 3,914,511, the method of using urea-formaldehyde series or urea-formaldehyde-resorcinol series wall materials as disclosed in U.S. Patents 4,001,140, 4,087,376 and 4,089,802, the method of using melamine-formaldehyde resins and hydroxy cellulose wall materials as disclosed in U.S. Patent 4,025,445, the monomer polymerization in situ method as disclosed in JP-B-36-9163 and JP-B-51-9079, the spray drying method as disclosed in British Patent 930,422 and U.S. Patent 3,111,407, and the electrolytic dispersion cooling method as disclosed in British Patents 952,807 and 967,074 can be exemplified, but the invention is by no means restricted to these methods.

The microcapsule walls preferably used in the invention have three dimensional crosslinking and a property of swelling by a solvent. From this point of view, polyurea, polyurethane, polyester, polycarbonate, polyamide, and mixtures of these compounds are preferably used as the microcapsule wall materials, and polyurea and polyurethane are particularly preferred. Compounds having crosslinkable functional groups such as ethylenic unsaturated bonds introducible to the above-described nonaqueous polymers may be introduced into microcapsule walls.

The average particle size of the microscpsules is preferably from 0.01 to 3.0 µm, more preferably from 0.05 to 2.0 µm, and especially preferably from 0.10 to 1.0 µm. With this range of the average particle size, good resolution and aging stability can be obtained. Other photosensitive layer components:

Besides the foregoing constitutional components, a photosensitive layer in the invention can further contain various additives, according to necessity. These additives are described below.

### Surfactant:

In the invention, it is preferred to use a surfactant in a photosensitive layer to accelerate developing property and to improve the conditions of coating surface. As the surfactants, nonionic surfactants, anionic surfactants, cationic surfactants and amphoteric surfactants are used. Surfactants may be used alone, or two or more surfactants may be used in combination.

The nonionic surfactants for use in the invention are not particularly restricted and conventionally well known surfactants can be used, e.g., polyoxyethylene alkyl ethers, polyoxyethylene alkyl phenyl ethers, polyoxyethylene polystyryl phenyl ethers, polyoxyethylene polyoxypropylene alkyl ethers, glycerol fatty acid partial esters, sorbitan fatty acid partial esters, pentaerythritol fatty acid partial esters, propylene glycol monofatty acid esters, sucrose fatty acid partial esters, polyoxyethylene sorbitan fatty acid partial esters, polyoxyethylene sorbitol fatty acid partial esters, polyethylene glycol fatty acid esters, polyglycerol fatty acid partial esters, polyoxyethylenated castor oils, polyoxyethylene glycerol fatty acid partial esters, fatty acid diethanolamides, N,N-bis-2-hydroxyalkylamines, polyoxyethylene alkylamine, triethanolamine fatty acid ester, trialkylamine oxide, polyethylene glycol, and copolymers of polyethylene glycol and polypropylene glycol are exemplified.

The anionic surfactants for use in the invention are not particularly restricted and conventionally well known surfactants can be used, e.g., fatty acid salts, abietates, hydroxyalkanesulfonates, alkanesulfonates, dialkylsulfo- succinates, straight chain alkylbenzenesulfonates, branched chain alkylbenzenesulfonates, alkylnaphthalenesulfonates, alkylphenoxypolyoxyethylenepropylsulfonates, polyoxy- ethylene alkyl sulfophenyl ethers, sodium N-methyl-N-oleyl- taurine, disodium N-alkylsulfosuccinic acid monoamide, petroleum sulfonates, sulfated beef tallow, sulfuric esters of fatty acid alkyl ester, alkylsulfuric esters, polyoxyethylene alkyl ether sulfuric esters, fatty acid monoglyceride sulfuric esters, polyoxyethylene alkyl phenyl ether sulfuric esters, polyoxyethylene styryl phenyl ether sulfuric esters, alkylphosphoric esters, polyoxyethylene alkyl ether phosphoric esters, polyoxyethylene alkyl phenyl ether phosphoric esters, partial saponification products of styrene/maleic anhydride copolymers, partial saponification products of olefin/maleic anhydride copolymer, and naphthalene sulfonate formaldehyde condensation products are exemplified.

The cationic surfactants for use in the invention are not particularly restricted and conventionally well known surfactants can be used, e.g., alkylamine salts, quaternary ammonium salts, polyoxyethyene alkylamine salts, and polyethylene polyamine derivatives are exemplified.

The amphoteric surfactants for use in the invention are not particularly restricted and conventionally well known surfactants can be used, e.g., carboxybetaines, aminocarboxylic acids, sulfobetaines, aminosulfuric esters and imidazolines are exemplified.

In the above surfactants, "polyoxyethylene" can be taken as "polyoxyalkylene" such as polyoxymethylene, polyoxy- propylene, or polyoxybutylene, and these surfactants can also be used in the invention.

As more preferred surfactants, fluorine surfactants containing a perfluoroalkyl group in the molecule are exemplified. As such surfactants, anionic surfactants, e.g., perfluoroalkylcarboxylate, perfluoroalkylsulfonate, and perfluoroalkylphosphate; amphoteric surfactants, e.g., perfluoroalkylbetaine; cationic surfactants, e.g., perfluoroalkyltrimethylammonium salt; and nonionic surfactants, e.g., perfluoroalkylamine oxide, perfluoroalkyl ethylene oxide adducts, oligomers containing a perfluoroalkyl group and a hydrophilic group, oligomers containing a perfluoroalkyl group and a lipophilic group, oligomers containing a perfluoroalkyl group, a hydrophilic group, and a lipophilic group, and urethane containing a perfluoroalkyl group and a lipophilic group are exemplified. Further, the fluorine surfactants disclosed in JP-A-62-170950, JP-A-62- 226143 and JP-A-60-168144 are also preferably used.

Surfactants can be used alone, or two or more surfactants can be used in combination.

Surfactants are preferably used in a photosensitive layer in the proportion of from 0.001 to 10 mass%, and more preferably from 0.01 to 7 mass%.

### Hydrophilic polymer:

For the purpose of improving a developing property and dispersion stability of microcapsules, hydrophilic polymers can be used in the invention.

As the hydrophilic polymers, polymers having a hydrophilic group, e.g., a hydroxyl group, a carboxyl group, a carboxylate group, a hydroxyethyl group, a polyoxyethyl group, a hydroxypropyl group, a polyoxypropyl group, an amino group, an aminoethyl group, an aminopropyl group, an ammonium group, an amido group, a carboxymethyl group, a sulfonic acid group, a phosphoric acid group, or the like are preferably exemplified.

The specific examples of hydrophilic polymers include gum arabic, casein, gelatin, starch derivatives, carboxymethyl cellulose and sodium salt thereof, cellulose acetate, sodium alginate, vinyl acetate-maleic acid copolymers, styrene-maleic acid copolymers, polyacrylic acids and salts thereof, polymethacrylic acids and salts thereof, homopolymers and copolymers of hydroxyethyl methacrylate, homopolymers and copolymers of hydroxyethyl acrylate, homopolymers and copolymers of hydroxypropyl methacrylate, homopolymers and copolymers of hydroxypropyl acrylate, homopolymers and copolymers of hydroxybutyl methacrylate, homopolymers and copolymers of hydroxybutyl acrylate, polyethylene glycols, hydroxypropylene polymers, polyvinyl alcohols, hydrolyzed polyvinyl acetate having a hydrolysis degree of 60 mol% or more, preferably 80 mol% or more, polyvinyl formal, polyvinyl butyral, polyvinylpyrrolidone, homopolymers and copolymers of acrylamide, homopolymers and copolymers of methacrylamide, homopolymers and copolymers of N-methylolacrylamide, polyvinylpyrrolidone, alcohol-soluble nylon, and polyether of 2,2-bis(4-hydroxyphenyl)propane and epichlorohydrin.

The weight average molecular weight of these hydrophilic polymers is preferably 5,000 or more, and more preferably from 10,000 to 300,000. The hydrophilic polymers may be any of a random polymer, a block polymer and a graft polymer.

The content of the binder polymers in a photosensitive layer is preferably in the ratio of 20 mass% or less of the total solids content of the photosensitive layer, and more preferably 10 mass% or less.

### Colorant:

Dyes having large absorption in the visible ray region can be used as the colorants of images in the invention. Specifically, Oil Yellow #101, Oil Yellow #103, Oil Pink #312, Oil Green BG, Oil Blue BOS, Oil Blue #603, Oil Black BY, Oil Black BS, Oil Black T-505 (products of Orient Chemical Industries, Ltd.), Victoria Pure Blue, Crystal Violet (C.I. 42555), Methyl Violet (C.I. 42535), Ethyl Violet, Rhodamine B (C.I. 145170B), Malachite Green (C.I. 42000), Methylene Blue (C.L 52015), and the dyes disclosed in JP-A-62-293247 can be exemplified. In addition, pigments such as phthalocyanine pigments, azo pigments, carbon black and titanium oxide are also preferably used.

These colorants are preferably added to discriminate an image area from a non-image area after image formation. The addition amount of colorants is preferably in the proportion of from 0.01 to 10 mass% of the total solids content of the image-forming materials.

### Printing-out agent:

Compounds that discolor by acids or radicals can be added to a photosensitive layer in the invention for forming a print out images. As such compounds, various dyestuffs, e.g., diphenylmethane, triphenylmethane, thiazine, oxazine, xanthene, anthraquinone, iminoquinone, azo, and azomethine dyestuffs are effectively used.

The specific examples of such dyestuffs include dyes such as Brilliant Green, Ethyl Violet, Methyl Green, Crystal Violet, Basic Fuchsine, Methyl Violet 2B, Quinaldine Red, Rose Bengal, Metanil Yellow, Thymolsulfophthalein, Xylenol Blue, Methyl Orange, Paramethyl Red, Congo Red, Benzopurpurine 4B, α-Naphthyl Red, Nile Blue 2B, Nile Blue A, Methyl Violet, Malachite Green, Parafuchsine, Victoria Pure Blue BOH (manufactured by HODOGAYA CHEMICAL CO., LTD.), Oil Blue #603 (manufactured by Orient Chemical Industries, Ltd.), Oil Pink #312 (manufactured by Orient Chemical Industries, Ltd.), Oil Red 5B (manufactured by Orient Chemical Industries, Ltd.), Oil Scarlet #308 (manufactured by Orient Chemical Industry Co., Ltd.), Oil Red OG (manufactured by Orient Chemical Industries, Ltd.), Oil Red RR (manufactured by Orient Chemical Industries, Ltd.), Oil Green #502 (manufactured by Orient Chemical Industries, Ltd.), Spiron Red BEH Special (manufactured by HODOGAYA CHEMICAL CO., LTD.), m-Cresol Purple, Cresol Red, Rhodamine B, Rhodamine 6G, Sulforhodamine B, Auramine, 4-p-diethylaminophenyliminonaphthoquinone, 2-carboxy-anilino-4-p-diethylaminophenyliminonaphthoquinone, 2-carboxystearylamino-4-p-N,N-bis(hydroxyethyl)amino-phenyliminonaphthoquinone, 1-phenyl-3-methyl-4-p-diethyl- aminophenylimino-5-pyrazolone, and 1-β-naphthyl-4-p-diethylaminophenylimino-5-pyrazolone, and leuco dyes such as p,p',p"-hexamethyltriaminotriphenylmethane (Leuco Crystal Violent), Pergascript Blue SRB (manufactured by Ciga Geigy A.G.).

Besides the above, leuco dyes known as the materials of heat-sensitive paper and pressure-sensitive paper are also preferred. The specific examples of the leuco dyes include Crystal Violet Lactone, Malachite Green Lactone, Benzoyl Leuco Methylene Blue, 2-(N-phenyl-N-methylamino)-6-(N-p-tolyl-N-ethyl)aminofluoran, 2-anilino-3-methyl-6-(N-ethyl-p- toluidino)fluoran, 3,6-dimethoxyfluoran, 3-(N,N-diethyl-amino)-5-methyl-7-(N,N-dibenzylamino)fluoran, 3-(N-cyclohexyl-N-methylamino)-6-methyl-7-anilinofluoran, 3-(N,N-diethylamino)-6-methyl-7-anilinofluoran, 3-(N,N-diethylamino)-6-methyl-7-xylidinofluoran, 3-(N,N-diethyl-amino)-6-methyl-7-chlorofluoran, 3-(N,N-diethylamino)- 6-methoxy-7-aminofluoran, 3-(N,N-diethylamino)-7-(4- chloroanilino)fluoran, 3-(N,N-diethylamino)-7-chlorofluoran, 3-(N,N.diethylamino)-7-benzylaminofluoran, 3-(N,N-diethyl- amino)-7,8-benzofluoran. 3-(N,N-dibutylamino)-6-methyl-7- anilinofluoran, 3-(N,N-dibutylamino)-6-methyl-7-xylidinofluoran, 3-piperidino-6-methyl-7-anilinofluoran, 3-pyrrolidino-6-methyl-7-anilinofluoran, 3,3-bis(1-ethyl-2-methylindol-3-yl)phthalide, 3,3-bis(1-n-butyl-2-methyl- indol-3-yl)phthalide, 3,3-bis(p-dimethylaminophenyl)-6-dimethylaminophthalide, 3-(4-diethylamino-2-ethoxyphenyl)-3-(1-ethyl-2-methylindol-3-yl)-4-phthalide, 3-(4-diethylaminophenyl)-3-(1-ethyl-2-methylindol-3-yl)phthalide, etc.

The dyes that discolor by acids or radicals are preferably added in the proportion of from 0.01 to 10 mass% to the solids content of the photosensitive layer. Polymerization inhibitor:

For the prevention of unnecessary thermal polymerization of a radical polymerizable compound during manufacture or preservation of a photosensitive layer, it is preferred that a small amount of thermal polymerization inhibitor be added to the photosensitive layer in the invention.

As the thermal polymerization inhibitors, e.g., hydroquinone, p-methoxyphenol, di-t-butyl-p-cresol, pyrogallol, t-butylcatechol, benzoquinone, 4,4'-thiobis(3-methyl-6-t-butylphenol), 2,2'-methylenebis(4-methyl-6-t- butylphenol), and N-nitroso-N-phenylhydroxylamine aluminum salt are preferably exemplified.

The addition amount of the thermal polymerization inhibitors is preferably in the proportion of from about 0.01 to about 5 mass% to the total solids content of the photosensitive layer.

### Higher fatty acid derivative, etc.:

For the prevention of the polymerization hindrance due to oxygen, higher fatty acid derivatives, e.g., behenic acid and behenic acid amide, may be added to a photosensitive in the invention and locally exist on the surface of the photosensitive layer in the drying process after coating. The addition amount of the higher fatty acid derivatives is preferably in the proportion of from about 0.1 to about 10 mass% to the total solids content of the photosensitive layer.

### Plasticizer:

A photosensitive layer in the invention may contain a plasticizer. The examples of plasticizers include phthalic esters, e.g., dimethyl phthalate, diethyl phthalate, dibutyl phthalate, diisobutyl phthalate, dioctyl phthalate, octylcapryl phthalate, dicyclohexyl phthalate, ditridecyl phthalate, butylbenzyl phthalate, diisodecyl phthalate, diallyl phthalate, etc.; glycol esters, e.g., dimethyl glycol phthalate, ethyl phthalyl ethyl glycolate, methyl phthalyl ethyl glycolate, butyl phthalyl butyl glycolate, triethylene glycol dicaprylate, etc.; phosphoric esters, e.g., tricresyl phosphate, triphenyl phosphate, etc.; aliphatic dibasic esters, e.g., diisobutyl adipate, dioctyl adipate, dimethyl sebacate, dibutyl sebacate, dioctyl azelate, dibutyl maleate, etc.; and polygycidyl methacrylate, triethyl citrate, glycerol triacetyl ester, butyl laurate, etc.. The content of plasticizers is preferably about 30 mass% or less to the total solids content of the photosensitive layer.

### Inorganic fine particles:

A photosensitive layer in the invention may contain inorganic fine particles for the purposes of increasing the strength of the hardened film in the image area. As the inorganic fine particles, e.g., silica, alumina, magnesium oxide, titanium oxide, magnesium carbonate, calcium alginate and mixtures of these fine particles are preferably used. These inorganic fine particles can be used for strengthening a film and enhancing an interface adhesion property by surface roughening treatment even when they are not light-heat convertible. The average particle size of inorganic fine particles is preferably from 5 nm to 10 µm, and more preferably from 0.5 to 3 µm. With this range of the average particle size, inorganic fine particles are stably dispersed in the photosensitive layer and the film strength of the photosensitive layer can be sufficiently retained, thus a non-image area difficult to be soiled in printing and excellent in hydrophilicity can be formed.

These inorganic fine particles are easily available as commercial products of colloidal silica dispersion and the like.

The content of inorganic fine particles is preferably 20 mass% or less to the total solids content of the photosensitive layer, and more preferably 10 mass% or less. Low molecular weight hydrophilic compound:

For the improvement of a developing property, a photosensitive layer in the invention can contain hydrophilic low molecular weight compounds. As the hydrophilic low molecular weight compounds, water-soluble organic compounds, such as glycols, e.g., ethylene glycol, diethylene glycol, methylene glycol, propylene glycol, dipropylene glycol, tripropylene glycol, etc., and ether or ester derivatives of these glycols, polyhydroxies, e.g., glycerol, pentaerythritol, etc., organic amines, e.g., triethanolamine, diethanolamine, monoethanolamine, etc., and salts thereof, organic sulfonic acids, e.g., toluenesulfonic acid, benzenesulfonic acid, etc., and salts thereof, organic phosphonic acids, e.g., phenylphosphonic acid, etc., and salts thereof, organic carboxylic acids, e.g., tartaric acid, oxalic acid, citric acid, malic acid, lactic acid, gluconic acid, amino acid, etc., and salts thereof, and organic quaternary ammonium salts, e.g., tetraethylamine hydrochloride, etc., are exemplified.

A photosensitive layer in the invention can contain besides the above components, e.g., a co-sensitizer.

### Formation of photosensitive layer:

A photosensitive layer in the invention is formed by coating a coating solution prepared by dispersing or dissolving the above necessary constitutional components in a solvent. As solvents used here, ethylene dichloride, cyclohexanone, methyl ethyl ketone, methanol, ethanol, propanol, ethylene glycol monomethyl ether, 1-methoxy-2-propanol, 2-methoxy- ethyl acetate, 1-methoxy-2-propyl acetate, dimethoxyethane, methyl lactate, ethyl lactate, N,N-dimethylacetamide, N,N-dimethylfommmide, tetramethylurea, N-methylpyrrolidone, dimethyl sulfoxide, sulforan, γ-butyrolactone, toluene, and water are exemplified, but solvents are not limited thereto. These solvents are used alone or as mixture. The concentration of the solid contents of a coating solution is preferably from 1 to 50 mass%.

It is also possible to form a photosensitive layer in the invention by preparing a plurality of coating solutions by dispersing or dissolving the same or different components in the same or different solvents, and repeating the coating and drying a plurality of times.

Although the coating amount of a photosensitive layer (solids content) on a support obtained after coating and drying varies according to uses, it is generally preferably from 0.3 to 3.0 g/m². When the coating amount is in this range, good sensitivity and good film properties of the image-recording layer can be obtained.

Various coating methods can be used. For example, bar coating, rotary coating, spray coating, curtain coating, dip coating, air knife coating, blade coating, and roll coating can be used.

### Protective layer:

For cutting off diffusing invasion of oxygen that hinders polymerization reaction at the time of exposure, it is preferred to provide a protective layer (an oxygen intercept layer) on the photosensitive layer of a lithographic printing plate precursor used in the method of the invention. It is preferred for the protective layer for use in the invention to have oxygen permeability A at 25°C under 1 atm of 1.0 ≦ A ≦ 20 (ml/m²·day). When oxygen permeability A is as low as less than 1.0 (ml/m²·day), unnecessary polymerization reaction occurs during manufacture and preservation, or unnecessary fog and thickening of image lines are generated in image exposure. Contrary to this, when oxygen permeability A is as high as exceeding 20 (ml/m²·day), sensitivity lowers. Oxygen permeability A is more preferably in the range of 1.5 ≦ A ≦ 12 (ml/m²·day), and still more preferably in the range of 2.0 ≦ A ≦ 10.0 (ml/m²·day). The characteristics required of the protective layer are, besides the above oxygen permeability, not substantially hindering the transmission of light used in exposure, being excellent in adhesion with a photosensitive layer, and being capable of removal with ease in the development process after exposure. Protective layers having such characteristics have so far been contrived and disclosed in detail, e.g., in U.S. Patent 3,458,311 and JP-B-55-49729.

As the materials for the protective layer, it is preferred to use, for example, water-soluble polymer compounds relatively excellent in crystallizability. Specifically, water-soluble polymers, e.g., polyvinyl alcohol, vinyl alcohol/vinyl phthalate copolymers, vinyl acetate/vinyl alcohol/vinyl phthalate copolymers, vinyl acetate/crotonic acid copolymers, polyvinylpyrrolidone, acid celluloses, gelatin, gum arabic, polyacrylic acid, and polyacrylamide are exemplified, and these compounds can be used alone or as mixture. Of these materials, when polyvinyl alcohol is used as the main component, the best results can be given to the fundamental characteristics such as the cutting off property of oxygen and the removal by development.

Polyvinyl alcohols for use in the protective layer may be partially substituted with ester, ether or acetal, or may similarly partially contain other copolymer components so long as they contain an unsubstituted vinyl alcohol unit for imparting necessary oxygen-intercepting property and solubility in water. As the specific examples of polyvinyl alcohols, those having a hydrolyzed rate of from 71 to 100 mol% and polymerization repeating units of from 300 to 2,400 are preferably exemplified. Specifically, PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613, and L-8 (each trade names and each manufactured by Kuraray Co., Ltd.) are exemplified, and these polyvinyl alcohols can be used alone or as mixture. The content of polyvinyl alcohol in the protective layer is preferably from 20 to 95 mass%, and more preferably from 30 to 90 mass%.

Known modified polyvinyl alcohols can also be preferably used. As modified polyvinyl alcohols, polyvinyl alcohols of various polymerization degrees randomly having a variety of hydrophilic modified sites such as anionic modified site modified with an anion, e.g., a carboxyl group, a sulfo group, etc., cationic modified site modified with a cation, e.g., an amino group, an ammonium group, etc., a silanol modified site, a thiol modified site, etc.; and polyvinyl alcohols of various polymerization degrees having at polymer chain terminals a variety of modified sites such as ester modified sites of the above anionic modified site, cationic modified site, silanol modified site, thiol modified site, further an alkoxyl modified site, a sulfide modified site, or vinyl alcohol with various organic acids, ester modified sites of the above anionic modified site with alcohols, etc., an epoxy modified site, etc., are exemplified.

As the components to be mixed with polyvinyl alcohol, polyvinyl pyrrolidone and modified polyvinyl pyrrolidone are preferably used in view of oxygen interception and removal by development, and the content in the protective layer is from 3.5 to 80 mass%, preferably from 10 to 60 mass%, and still more preferably from 15 to 30 mass%.

The components of the protective layer (the selection of PVA and the use of additives) and the coating amount are selected taking into consideration fogging characteristic, adhesion and scratch resistance in addition to the oxygen intercepting property and the removal by development. In general, the higher the hydrolyzing rate of the PVA used (the higher the unsubstituted vinyl alcohol unit content in the protective layer) and the thicker the layer thickness, the higher is the oxygen intercepting property, thus advantageous in the point of sensitivity. The molecular weight of the (co)polymer of the above polyvinyl alcohols (PVA) is generally from 2,000 to 10,000,000, and preferably from 20,000 to 3,000,000.

As other components of the protective layer, glycerol and dipropylene glycol corresponding to several mass% can be added to the (co)polymers to provide flexibility, further, anionic surfactants, e.g., sodium alkylsulfate, sodium alkylsulfonate, etc.; amphoteric surfactants, e.g., alkyl- aminocarboxylate, alkylaminodicarboxylate, etc.; and nonionic surfactants, e.g., polyoxyethylene alkyl phenyl ether, etc., can be added to the (co)polymers each in the proportion of several mass%.

The adhesion of the protective layer with an image area and scratch resistance are also extremely important in treating a printing plate, i.e., when a hydrophilic layer comprising water-soluble polymers is laminated on a lipophilic photosensitive layer, layer peeling due to insufficient adhesion is liable to occur, and the peeled part causes such a defect as film hardening failure due to polymerization hindrance by oxygen. Various countermeasures have been proposed for improving the adhesion between a photosensitive layer and a protective layer. For example, it is disclosed in U.S. Patent Application Nos. 292,501 and 44,563 that a sufficient adhesion property can be obtained by mixing from 20 to 60 mass% of an acryl-based emulsion or a water-insoluble vinyl pyrrolidone/vinyl acetate copolymer with a hydrophilic polymer mainly comprising polyvinyl alcohol and laminating the resulting product on a photosensitive layer. Any of these known techniques can be applied to the protective layer of the invention. These coating methods of the protective layer are disclosed in detail, e.g., in U.S. Patent 3,458,311 and JP-B-55-49729.

It is also preferred that the protective layer of a lithographic printing plate precursor said in the method of the invention contains an inorganic laminar compound for the purpose of enhancing the oxygen intercepting property and the protecting property of the photosensitive layer surface.

The inorganic laminar compound is a particle having a thin tabular shape, such as a mica group, e.g., natural mica and synthetic mica represented by formula, A(B, C)₂₋₅D₄O₁₀(OH, F, O)₂ (wherein A represents any of K, Na and Ca, B and C represent any of Fe(II), Fe(III), Mn, Al, Mg and V, and D represents Si or Al), and talc, taeniolite, montmorillonite, saponite, hectorite and zirconium phosphate represented by formula 3MgO·4SiO·H₂O are exemplified.

In the above mica group, the examples of natural micas include muscovite, paragonite, phlogopite, biotite and lepidolite. The examples of synthetic micas include non-swellable micas, e.g., fluorine phlogopite KMg₃(AlSi₃O₁₀)F₂ and potassium tetrasilicate mica KMg_{2.5}(Si₄O₁₀)F₂, etc., and swellable micas, e.g., Na tetrasilicic mica NaMg_{2.5}(Si₄O₁₀)F₂, Na or Li taeniolite (Na, Li)Mg₂Li(Si₄O₁₀)F₂, and montmorillonite based Na or Li hectorite (Na, Li)_{1/8}Mg_{2/5}Li_{1/8}(Si₄O₁₀)F₂, etc. Synthetic smectites are also useful.

Of the above inorganic laminar compounds, fluorine-based swellable micas, which are synthetic inorganic laminar compounds, are preferably used in the invention. That is, these swellable synthetic micas and swellable clay minerals, e.g., montmorillonite, saponite, hectorite, bentonite, etc., have a lamination structure comprising unit crystal lattice layers having a thickness of from 10 to 15 1.10⁻¹⁰m (Ǻ) or so, and metallic atom substitution in the lattice is extremely great as compared with other clay minerals. As a result, there is an insufficient quantity of positive electric charge in the lattice layers, and cations such as Na⁺, Ca²⁺ and Mg^{z+}, are adsorbed among layers to compensate for the insufficiency. The cations intervening lattice layers are called exchangeable cations and they are exchangeable with various cations. Particularly when the cations among layers are Li⁺ and Na⁺, they are small in ionic radius, so that bonding among layer crystal lattices is weak and greatly swelled by water. When shear is applied in that state, the lattices easily cleave and form stable sol in water. Bentonite and swellable synthetic micas have the tendency markedly, so that useful in the invention, and swellable synthetic micas are especially preferably used.

As for the shape of the inorganic laminar compounds for use in the invention, the thickness is the thinner the better from the viewpoint of the control of diffusion, and the plane size is the bigger the better so long as the smoothness of the coated surface and the transmission of actinic rays are not hindered. Accordingly, the aspect ratio of inorganic laminar compounds is preferably 20 or higher, preferably 100 or higher, and especially preferably 200 or higher. The aspect ratio is the ratio of the thickness to the long diameter of a particle, and this can be measured, for example, from the projection drawing of the microphotograph of a particle. The greater the aspect ratio, the greater is the effect obtained.

The average long diameter of the particle of inorganic laminar compounds for use in the invention is from 0.3 to 20 µm, preferably from 0.5 to 10 µm, and especially preferably from 1 to 5 µm. The average thickness of the particle is 0.1 µm or less, preferably 0.05 µm or less, and especially preferably 0.01 µm or less. For instance, of the inorganic laminar compounds, the thickness of swellable synthetic mica, which is a representative compound, is from 1 to 50 nm, and the plane size is from 1 to 20 µm or so.

When the particles of inorganic laminar compounds having such a high aspect ratio are contained in a protective layer, the film strength is improved and the permeation of oxygen and moisture can be effectively prevented, hence the deterioration of the protective layer due to deformation and the like can be restrained. Therefore, even when the lithographic printing plate precursor is preserved under a high moisture condition for a long period of time, the lithographic printing plate precursor is free from the degradation of image-forming property due to the change in moisture, and excellent preservation stability can be ensured.

An inorganic laminar compound contained in a protective layer is preferably in the proportion of from 5/1 to 1/100 in the mass ratio to the amount of the binder used in the protective layer. Even when a plurality of inorganic laminar compounds are used in combination, it is preferred that the total amount of these inorganic laminar compounds be within the above mass ratio.

General methods of dispersing an inorganic laminar compound for use in a protective layer are described. In the first place, from 5 to 10 mass parts of a swellable laminar compound exemplified above as preferred example of an inorganic laminar compound is added to 100 mass parts of water, made thoroughly intimate with water to swell, and then dispersed with a disperser. As the dispersers used here, various kinds of mills of directly applying force mechanically to effect dispersion, high speed stirring type dispersers having great shearing force, and dispersers providing ultrasonic energy of high strength are exemplified. Specifically, a ball mill, a sand grinder mill, a visco mill, a colloid mill, a homogenizer, a dissolver, a POLYTRON, a homomixer, a homoblender, a KD mill, a JET AJTTER, a capillary emulsifier, a liquid siren, an electromagnetic distortion type ultrasonic generator, and an emulsifier having a Poleman whistle are exemplified. The dispersion containing 5 to 10 mass parts of the inorganic laminar compound dispersed by the above method is highly viscous or in a gel state and is conspicuously excellent in preservation stability is. When a protective layer coating solution is prepared using the dispersion, it is preferred to dilute the dispersion with water and stir thoroughly, and then blend with a binder solution.

Well-known additives, e.g., surfactants for increasing a coating property and water-soluble plasticizers for improving physical properties of a film can be added to the protective layer coating solution besides the inorganic laminar compound. As the water-soluble plasticizers, e.g., propionamide, cyclohexanediol, glycerol, sorbitol, etc., are exemplified. Water-soluble (meth)acrylic polymers can also be added. Further, well-known additives for improving the adhesion with a photosensitive layer and the aging stability of a coating solution may be added to the coating solution.

The thus-prepared protective layer coating solution is coated on the photosensitive layer provided on a support and dried to form a protective layer. A coating solvent can be arbitrarily selected in the relationship with the binder. When water-soluble polymers are used, it is preferred to use distilled water and purified water as the coating solvent. The coating method of the protective layer is not particularly restricted and well-known methods, e.g., the coating methods disclosed in U.S. Patent 3,458,311 and JP-B-55-49729 can be used. Specifically, the protective layer is coated with blade coating, air knife coating, gravure coating, roll coating, spray coating, dip coating, or bar coating.

The coating weight of the protective layer is preferably from 0.05 to 10 g/m² in dry weight, when an inorganic laminar compound is used, the coating weight is more preferably from 0.1 to 0.5 g/m², and when an inorganic laminar compound is not used, the coating weight is more preferably from 0.5 to 5 g/m².

### Support:

Supports for use in a lithographic printing plate precursor used in the method of invention are not especially restricted and any supports can be used so long as they are dimensionally stable and plate-like hydrophilic supports. For example, paper, paper laminated with plastics (e.g., polyethylene, polypropylene, polystyrene, etc.), metal plates (e.g., aluminum, zinc, copper, etc.), plastic films (e.g., cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate, polyvinyl acetal, etc.), and paper and plastic films laminated or deposited with the above metals can be exemplified. Preferred supports are a polyester film and an aluminum plate. Above all, aluminum plates, which are dimensionally stable and comparatively inexpensive, are preferred.

Aluminum plates are a pure aluminum plate, alloy plates containing aluminum as a main component and a trace amount of different elements, and aluminum or aluminum alloy thin films laminated with plastics. The examples of different elements contained in aluminum alloys include silicon, iron, manganese, copper, magnesium, chromium, zinc, bismuth, nickel, titanium, etc. The different element content in aluminum alloys is preferably 10 mass% or less. In the invention, a pure aluminum plate is preferred but 100% pure aluminum is difficult to produce from the refining technique, accordingly, an extremely small amount of different elements may be contained. The compositions of aluminum plates used in the invention are not specified, and aluminum plates of conventionally known and commonly used materials can be optionally used.

A support for use in the invention has a thickness of preferably from 0.1 to 0.6 mm, more preferably from 0.15 to 0.4 mm, and still more preferably from 0.2 to 0.3 mm.

Prior to the use of an aluminum plate, it is preferred for the aluminum plate to be subjected to surface treatment, e.g., surface roughening treatment and anodizing treatment. By surface treatment, the improvement of hydrophilicity and the security of the adhesion of a photosensitive layer and a support become easy. Prior to the surface roughening treatment of an aluminum plate, if necessary, degreasing treatment with a surfactant, an organic solvent or an alkaline aqueous solution is carried out to remove the rolling oil on the surface of an aluminum plate.

Surface roughening treatment of the surface of an aluminum plate is performed by various methods, e.g., mechanical surface roughening treatment, electrochemical surface roughening treatment (surface roughening treatment of electrochemically dissolving the surface), and chemical surface roughening treatment (surface roughening treatment of chemically selectively dissolving the surface) are exemplified.

As the method of mechanical surface roughening treatment, well-known methods, e.g., a ball rubbing method, a brush abrading method, a blast abrading method, or a buffing method, can be used.

As the method of electrochemical surface roughening treatment, a method of roughening in an electrolyte containing an acid such as a hydrochloric acid or a nitric acid by alternating current or direct current can be used. Further, a method of using mixed acids can be used as disclosed in JP-A-54-63902.

An aluminum plate subjected to surface roughening treatment is, if necessary, subjected to alkali etching treatment with an aqueous solution of potassium hydroxide or sodium hydroxide and neutralizing treatment and then, if necessary, to anodizing treatment to increase the abrasion resistance of the surface.

Various electrolytes can be used in the anodizing treatment of an aluminum plate for forming porous oxide film, and sulfuric acid, hydrochloric acid, oxalic acid, chromic acid or mixed acid of these acids is generally used. The concentrations of these electrolytes are arbitrarily determined according to the kinds of electrolytes.

Anodizing treatment conditions vary according to electrolytes used and cannot be specified unconditionally, but in general preferably the concentration of an electrolytic solution is from I to 80 mass%, the liquid temperature is from 5 to 70°C, the electric current density is from 5 to 60 A/dm², the voltage is from 1 to 100 V, the electrolytic time is from 10 seconds to 5 minutes. The amount of the anodic oxide film formed is preferably from 1.0 to 5.0 g/m², and more preferably from 1.5 to 4.0 g/m². In this range of the amount of the anodic oxide film, good press life and good scratch resistance of the non-image area of the lithographic printing plate can be obtained.

As the supports for use in the invention, supports subjected to surface treatments as above and having an anodic oxide film may be used as they are, but for further enhancing the adhesion with the upper layer, a hydrophilic property, soiling resistance and a heat insulating property, enlarging treatment of the micro-pores of the anodic oxide film, sealing treatment of the micro-pores, and hydrophilization treatment of the surface by immersion in an aqueous solution containing a hydrophilic compound as disclosed in JP-A-2001-253181 and JP-A-2001-322365 can be arbitrarily performed, if necessary. These enlarging treatment and sealing treatment are of course not restricted to the methods disclosed in the above patents, and any of conventionally known methods can be used.

Besides sealing treatment with steam, the sealing treatment may be sealing treatment with an aqueous solution containing an inorganic fluorine compound, such as treatment with fluorozirconic acid alone, treatment with sodium fluoride, sealing treatment with steam having added thereto lithium chloride, or sealing treatment with hot water.

In particular, sealing treatment with an aqueous solution containing an inorganic fluorine compound, sealing treatment with water vapor, and sealing treatment with hot water are preferred.

As the hydrophilization treatment, alkali metal silicate methods as disclosed in U.S. Patents 2,714,066, 3,181,461, 3,280,734 and 3,902,734 are known. These methods comprise immersion treatment of a support in an aqueous solution of sodium silicate, etc., or electrolytic processing. In addition, a method of treating an aluminum plate with potassium fluorozirconate as disclosed in JP-B-36-22063, and methods of treatment with polyvinylphosphonic acid as disclosed in U.S. Patents 3,276,868, 4,153,461 and 4,689,272 are exemplified.

When a polyester film or the like that is insufficient in a hydrophilic property of surface is used as a support in the invention, it is preferred to coat a hydrophilic layer to make the surface hydrophilic. As the hydrophilic layers, a hydrophilic layer formed by coating a coating solution containing the colloid of oxide or hydroxide of at least one element selected from beryllium, magnesium, aluminum, silicon, titanium, boron, germanium, tin, zirconium, iron, vanadium, antimony and transition metals as disclosed in JP-A-2001-199175, a hydrophilic layer having an organic hydrophilic matrix obtained by the crosslinking or pseudo-crosslinking of an organic hydrophilic polymer as disclosed in JP-A-2002-79772, a hydrophilic layer having an inorganic hydrophilic matrix obtained by sol/gel conversion comprising hydrolysis and condensation reaction of polyalkoxysilane, titanate, zirconate or aluminate, and a hydrophilic layer comprising an inorganic thin film having a surface containing a metallic oxide are preferred. Of these hydrophilic layers, a hydrophilic layer formed by coating a coating solution containing the colloid of oxide or hydroxide of silicon is preferred.

When a polyester film is used as a support in the invention, it is preferred to provide an antistatic layer on the hydrophilic layer side of the support, or on the opposite side to the hydrophilic layer, or on both sides. When an antistatic layer is provided between a support and a hydrophilic layer, the antistatic layer also contributes to the adhesion of the hydrophilic layer and the support. The polymer layers containing the dispersion of metallic oxide fine particles and a matting agent as disclosed in JP-A-2002-79772 can be used as the antistatic layers.

It is preferred that a support for use in the invention has a central line average surface roughness of from 0.10 to 1.2 µm. In this range of the average surface roughness, good adhesion of the support and a photosensitive layer, good press life and good soiling resistance can be obtained.

The color density of a support is preferably from 0.15 to 0.65 in terms of a reflection density value. A good image forming property due to antihalation in the time of image exposure and a good plate-detecting property after development can be obtained when the color density of a support is in this range.

### Undercoat layer.

In a lithographic printing plate precursors used in the method of the invention, it is preferred to provide an undercoat layer of a compound containing a polymerizable group on a support. When an undercoat layer is provided, a photosensitive layer is formed on the undercoat layer. An undercoat layer enhances the adhesion of a support and a photosensitive layer in an exposed area, and assists the peeling of a photosensitive layer from a support in an unexposed area, so that developing property is improved.

As the undercoat layer, specifically the silane coupling agent having an addition polymerizable ethylenic double bond reactive group disclosed in JP-A-10-282679, and the phosphorus compounds having an ethylenic double bond reactive group disclosed in JP-A-2-304441 are preferred. Compounds having a polymerizable group such as a methacrylic group or an allyl group and a support-adsorptive group such as a sulfonic acid group, a phosphoric acid group or a phosphoric ester are especially preferred. Compounds having a hydrophilicity- imparting group, e.g., an ethylene oxide group, in addition to the polymerizable group and the support-adsorptive group can also be exemplified as preferred compounds.

The coating amount of an undercoat layer (solids content) is preferably from 0.1 to 100 mg/m², and more preferably from 1 to 30 mg/m².

### Back coat layer.

After surface treatment of a support or after forming an undercoat layer, if necessary, a back coat can be provided on the back surface of the support.

As the back coat, e.g., coating layers comprising organic polymer compounds as disclosed in JP-A-5-45885, and coating layers comprising metallic oxides obtained by hydrolysis and polycondensation of organic or inorganic metallic compounds as disclosed in JP-A-6-35174 are preferably used. Alkoxy compounds of silicon, e.g., Si(OCH₃)₄, Si(OC₂H₅)₄, Si(OC₃H₇)₄, Si(OC₄H₉)₄, are preferably used for the inexpensiveness and easy availability of the materials.

### Exposure:

In the plate-making method of the invention, a lithographic printing plate precursor is exposed through a transparent original image having line images and dot images, or imagewise exposed by scanning exposure with laser beam according to digital data. As exposure light sources, a carbon arc lamp, a high pressure mercury lamp, a xenon lamp, a metal halide lamp, a fluorescent lamp, a tungsten lamp, a halogen lamp, an ultraviolet laser, a visible ray laser, and an infrared laser are exemplified. Laser beams are especially preferred, and semiconductor lasers emitting rays of wavelengths of from 250 to 420 nm, and solid state lasers and semiconductor lasers emitting infrared rays of wavelength region of from 760 to 1,200 nm are exemplified. When lasers are used, it is preferred to perform imagewise scanning exposure according to digital data. It is preferred to use a multi-beam laser device for expediting exposure.

These lasers are mounted on a so-called plate setter of performing imagewise exposure by computerized control.

In the invention, development process may be carried out immediately after the exposure process, or heat processing step (preheat) may be provided between the development process and the exposure process. The heat processing has the effect of increasing press life and heightening the uniformity of the degree of image hardening in the printing plate, and the conditions of heat processing can be arbitrarily set within the effective range. As heating means, a conventional convection oven, an IR irradiation apparatus, an IR laser, a microwave apparatus, a Wisconsin oven, etc., can be exemplified. Specifically, heat processing can be performed by maintaining the achievable temperature of printing plate at 70 to 150°C for 1 see to 5 min, preferably at 80 to 140°C for 5 sec to I min, and more preferably at 90 to 130°C for 10 to 30 sec. With this range, the above effects can be obtained efficiently and the printing plate can avoid adverse influence such as deformation by heat

At this time, it is preferred that a heat processing means for use in the heat processing step and a developing apparatus for use in the development processing step are connected to each other, and heat processing and development processing are automatically continuously performed. Specifically, this is a plate-making line comprising a plate setter and a developing apparatus connected by a carrying means such as a conveyor. A heat processing means may be present between the plate setter and the development apparatus, alternatively a heating means and a developing apparatus may be integrated as one apparatus.

When a printing plate to be used is susceptible to surrounding right in the work environment, the plate-making line is preferably shielded from light with a cover or a filter. In the absence of heat processing, an exposure means is of course directly connected with a development processing means, and exposure and development are automatically continuously performed.

After finishing development as above and an image is formed, entire exposure is performed with actinic rays, e.g., UV-rays and the like, and hardening of an image area may be accelerated. As the light sources at the time of entire exposure, e.g., a carbon arc lamp, a mercury lamp, a gallium lamp, a metal halide lamp, a xenon lamp, a tungsten lamp, various kinds of laser beams, etc., are exemplified. For obtaining sufficient press life, the quantity of entire exposure is preferably at least 10 mJ/cm² or more, and more preferably 100 mJ/cm² or more.

Heating may be performed simultaneously with the entire exposure, by which further improvement of press life is observed. As the heating apparatus, a conventional convection oven, an IR irradiation apparatus, an IR laser, a microwave apparatus, a Wisconsin oven, etc., can be exemplified. The temperature of the printing plate at this time is preferably from 30 to 150°C, more preferably from 35 to 130°C, and still more preferably from 40 to 120°C.

### EXAMPLE

The invention will be described with reference to examples, wich do not full under the claimed invention, but wich illustrate features thereof in example 1-5, 7 and 8 only a single brush is used in example 6, two brushes are used but rubbing commerces only 1 second after immension.

### Manufacture of support:

For removing the rolling oil on the surface, an aluminum plate having a thickness of 0.3 mm (material 1050) was subjected to degreasing treatment with a 10 mass% sodium alminate aqueous solution at 50°C for 30 seconds, and then the aluminum surface was subjected to brush-graining with three nylon brushes planted with hairs having a hair diameter of 0.3 mm and a suspension of pumice stone and water of a median diameter of 25 µm (the specific gravity: 1.1 g/cm³), and then the surface of the plate was thoroughly washed with water. The plate was immersed in a 25 mass% sodium hydroxide aqueous solution at 45°C for 9 seconds for etching, and washed with water. After water washing, the plate was further immersed in a 20 mass% nitric acid aqueous solution at 60°C for 20 seconds, and followed by washing with water. The etched amount of the surface by graining was about 3 g/m².

In the next place, electrochemical surface roughening treatment was performed continuously by alternating voltage of 60 Hz. The electrolyte at this time was an aqueous solution containing 1 mass% of a nitric acid (containing 0.5 mass% of an aluminum ion) and the liquid temperature was 50°C. As the alternating current electric source waveform, trapezoidal rectangular waveform alternating current was used, the time TP required for the electric current value to reach the peak from 0 was 0.8 msec, the duty ratio was 1/1, and electrochemical surface roughening treatment was performed with a carbon electrode as the counter electrode. Ferrite was used as the auxiliary anode. The electric current density was 30 A/dm² at a peak value of electric current, and 5% of the electric current from the electric source was diverted to the auxiliary anode.

The quantity of electricity in the nitric acid electrolysis was the quantity of electricity of 175 C/dm² in the case where the aluminum plate was the anode.

The aluminum plate was then washed with water.

Subsequently, electrochemical surface roughening treatment of the aluminum plate was performed with an electrolyte containing a 0.5 mass% hydrochloric acid aqueous solution (containing 0.5 mass% of an aluminum ion) at a liquid temperature of 50°C on the condition of the quantity of electricity of 50 C/dm² in the case where the aluminum plate was the anode in the same manner as in the above nitric acid electrolysis. The plate was then subjected to spray washing. The plate was provided with 2.5 g/m² of a direct current anodic oxide film with a 15 mass% sulfuric acid (containing 0.5 mass% of an aluminum ion) as the electrolyte and by the electric current density of 15 A/dm², and then washed and dried. The central line average surface roughness (Ra) of the plate measured with a needle having a diameter of 2 µm was 0.51 µm.

The following undercoat layer coating solution (1) was coated on the plate in a dry coating weight of 10 mg/m² to prepare a support for use in the following test. Undercoat layer coating solution (1):

| | |
|---|---|
| Undercoat compound (1) shown below | 0.017 g |
| Methanol | 9.00 g |
| Water | 1.00 g |

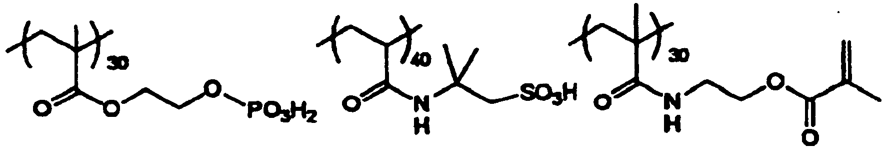

### Undercoat Compound (1)

### Manufacture of lithographic printing plate precursor A:

Image-recording layer coating solution (1) having the composition shown below was coated on the above support having the undercoat layer with bar coating, dried at 100°C for 75 seconds in an oven, whereby an image-recording layer having a dry coating weight of 1.0 g/m² was formed. The protective layer coating solution having the composition shown below was coated on the above-formed image-recording layer in a dry coating weight of 1.0 g/m² with wire a bar coater, and dried at 100°C for 90 seconds in the oven, whereby lithographic printing plate precursor A was obtained.

Image-recording layer coating solution (1) was obtained by mixing photosensitive solution (1) shown below and microcapsule solution (1) shown below immediately before coating.

| Photosensitive solution (1): | |
|---|---|
| Binder polymer (1) (weight average molecular weight: 80,000) | 0.162 g |
| Polymerization initiator (1) shown below | 0.100 g |
| Infrared absorber (1) shown below | 0.020 g |
| Polymerizable compound | 0.385 g |
| (AROMX® M-215, manufactured by TOAGOSEI CO., LTD.) | |
| Fluorine surfactant (1) shown below | 0.044 g |
| Methyl ethyl ketone | 1.091 g |
| 1-Methoxy-2-propanol | 8.609 g |
| Microcapsule solution (1): | |
| Microcapsule (1) synthesized as shown below | 2.640 g |
| Water | 2.425 g |

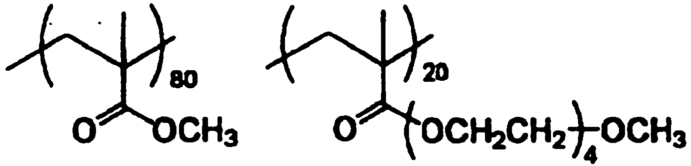

### Binder Polymer (1)

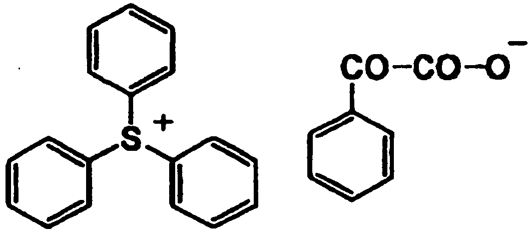

### Polymerization Initiator (1)

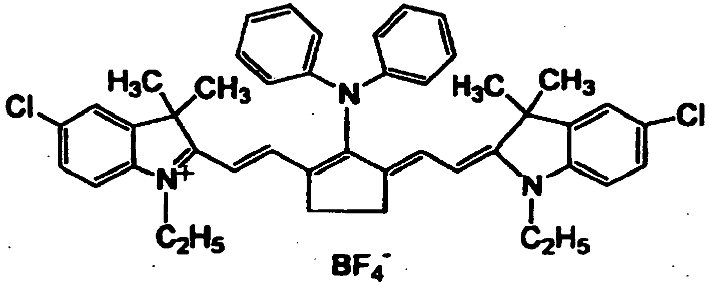

### Infrared Absorber (1)

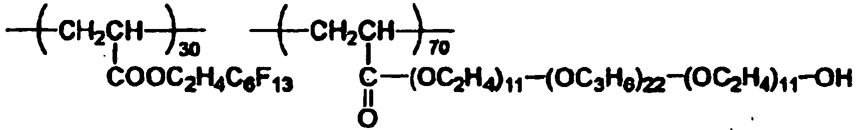

### Fluorine Surfactant (1)

### Synthesis of microcapsule (1):

As the oil phase component, 10 g of the addition product of trimethylolpropane and xylene diisocyanat (Takenate D-110N, manufactured by Mitsui Takeda Chemicals Inc.), 6.00 g of ARONIX® M-215 (manufactured by TOAGOSEI CO., LTD.), and 0.12 g of Pionin® A-41C (manufactured by Takemoto Oil & Fat) were dissolved in 16.67 g of ethyl acetate. As the aqueous phase component, 37.5 g of a 4 mass% aqueous solution of PVA-205® was prepared. The oil phase component and the aqueous phase component were mixed, and emulsified with a homogenizer at 12,000 rpm for 10 minutes. The obtained emulsified product was added to 25 g of distilled water, stirred at room temperature for 30 minutes, and then stirred at 40°C for 2 hours. The concentration of the solids content of the obtained microcapsule solution (1) was diluted to reach 15 mass% with distilled water. The average particle size was 0.2 µm.

### Protective layer coating solution:

| | |
|---|---|
| Water | 88 g |
| Polyvinyl alcohol PVA® 105 (manufactured by Kuraray Co. Ltd.) | 10 g |
| Polyethylene glycol | 2 g |
| (weight average molecular weight: 2,000) | |
| Surfactant shown below | 1 g |

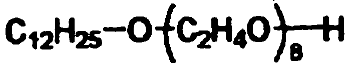

### Surfactant

### Manufacture of lithographic printing plate precursor B:

Image-recording layer coating solution (3) having the composition shown below was coated on the above support having the undercoat layer with bar coating, dried at 100°C for 60 seconds in the oven, whereby an image-recording layer having a dry coating weight of 1.4 g/m² was formed. Protective layer coating solution (1) having the composition shown above was coated on the above-formed iniage-recording layer in a dry coating weight of 0.5 g/m², and dried at 120°C for 1 minute, whereby lithographic printing plate precursor B was obtained.

### Image-recording layer coating solution (3):

| | |
|---|---|
| Binder Polymer (1) shown above | 2.0 g |
| Polymerizable compound | 1.5 g |
| Isocyanuric acid EO-modified triacrylate (ARONIX® M-315, manufactured by TOAGOSEI CO., LTD.) | |
| Compound (1) shown below | 0.15 g |
| Compound (2) shown below | 0.20 g |
| Compound (3) shown below | 0.4 g |
| Ethyl Violet | 0.1 g |
| Thermal polymerization inhibitor N-Nitrosophenylhydroxylamine aluminum salt | 0.1 g |
| Water-soluble fluorine surfactant (1) shown above | 0.02 g |
| Tetraethylamine hydrochloride | 0.06 g |
| 1-Methoxy-2-propanol | 17.5 g |
| Methyl ethyl ketone | 19.0 g |

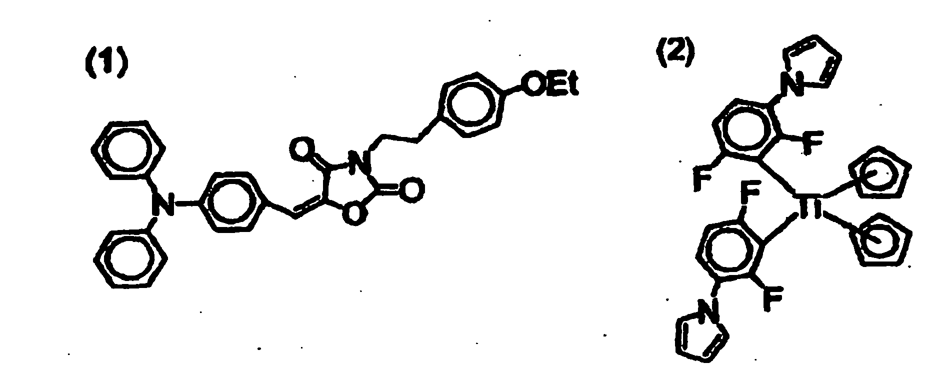

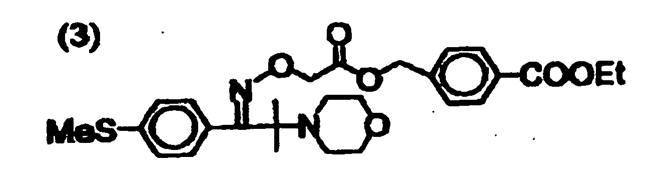

### Manufacture of lithographic printing plate precursor C:

Photosensitive layer coating solution (1) having the composition shown below was coated on the above support having the undercoat layer with bar coating, dried at 70°C for 60 seconds in the oven, whereby an image-recording layer having a dry coating weight of 1.1 g/m² was formed. Protective layer coating solution (1) having the composition shown below was coated on the above-formed image-recording layer in a dry coating weight of 0.75 g/m² with bar coating, and dried at 125°C for 70 seconds, whereby lithographic printing plate precursor C was obtained.

### Photosensitive layer coating solution (1):

| | |
|---|---|
| Binder polymer (1) shown below (weight average molecular weight: 80,000) | 0.54 g |
| Polymerizable compound | 0.40 g |
| Isocyan acid EO-modified triacrylate (ARONIX® M-315, manufactured by TOAGOSEI CO., LTD.) | |
| Polymerizable compound ethoxylated trimethylolpropane triacrylate (SR9035, manufactured by Nippon Kayaku Co., Ltd., EO addition molar number: 15, molecular weight: 1,000) | 0.08 g |
| Sensitizing dyestuff (1) shown below | 0.06 g |
| Polymerization initiator (2) shown below | 0.18 g |
| Chain transfer agent (1) | 0.07 g |
| Dispersion of ε-phthalocyanine pigment (pigment: 15 mass parts, dispersant: binder polymer (1), 10 mass parts, solvent: cyclohexanone/methoxypropyl acetate/1-methoxy-2-propanol = 15/20/40 (in mass parts)) | 0.40 g |
| Thermal polymerization inhibitor N-Nitrosophenylhydroxylamine aluminum salt | 0.01 g |
| Water-soluble fluorine surfactant (1) shown below | 0.001 g |
| Polyoxyethylene-polyoxypropylene condensation product (Pluronic® L44, manufactured by Asahi Denka Co., Ltd.) | 0.04 g |
| Tetraethylamine hydrochloride | 0.01 g |
| 1-Methoxy-2-propanol | 3.5 g |
| Methyl ethyl ketone | 8.0 g |

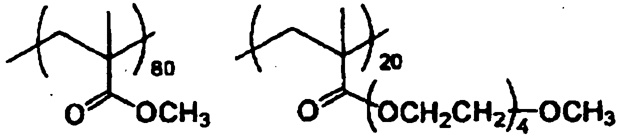

### Binder Polymer (1)

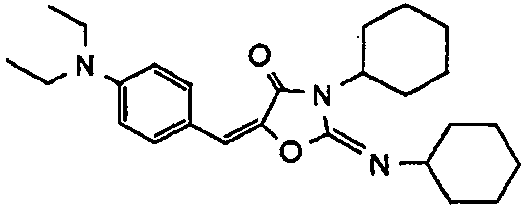

### Sensitizing Dyestuff (1)

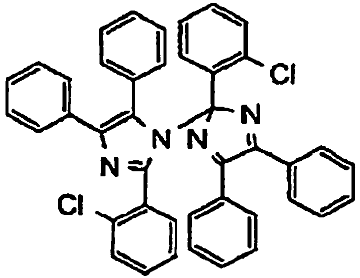

### Polymerization Initiator (2)

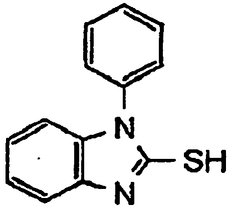

### Chain Transfer Agents (1)

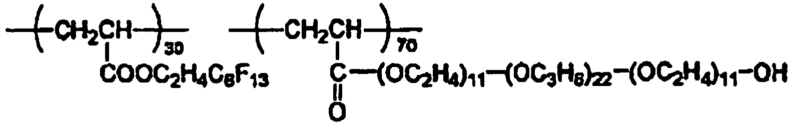

### Fluorine Surfactant (1)

### Protective layer coating solution (1):

| | |
|---|---|
| Polyvinyl alcohol (degree of saponification: 98 mol%, degree of polymerization: 500) | 40 g |
| Polyvinyl pyrrolidone (weight average molecular weight: 50,000) | 5 g |
| Poly(vinylpyrrolidone/vinyl acetate (1/1)), (weight average molecular weight: 70,000) | 0.5 g |
| Surfactant (EMALEX® 710, manufactured by Nihon Emulsion Co., Ltd.) | 0.5 g |
| Water | 950 g |

Oxygen permeability of the protective layer measured by the following condition was 3.8 ml/(m²·day·atom).

### Measurement of oxygen permeability:

A sample for test was prepared by coating an oxygen intercepting layer on the surface of a photographic paper having a thickness of about 200 µm both surfaces of which were coated with polyethylene in a thickness of about 20 µm in the same manner as in the coating on the photo-polymerizable layer and dried. The oxygen permeability of the photographic paper measured in advance was about 700 ml/(m²·day·atom) on the following measuring condition, which was a value sufficiently negligible on measurement of oxygen permeability in the oxygen intercepting layer.

The oxygen permeability (ml/(m²·day·atom)) of the obtained sample was measured with OX-TRAN® 2/20 (manufactured by MOCON Inc:) according to the test method of air permeability described in JIS K7126B and ASTM D3985, on the condition of 25°C 60% RH.

### Manufacture of aqueous solution:

Aqueous solution 1 was manufactured. The unit was g, and the pH of aqueous solution 1 was 4.3.

| | |
|---|---|
| Water | 8,970 g |
| Anionic surfactant (shown below) | 400 g |
| 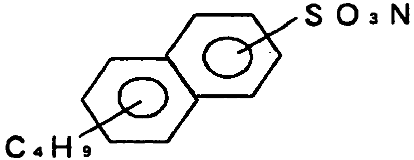 | |
| Gum arabic | 150 g |
| Potato starch modified by enzyme | 400 g |
| Sodium salt of dioctylsulfosuccinate | 50 g |
| Ammonium primary phosphate | 10 g |
| Citric acid | 10 g |
| EDTA-4-sodium salt | 10 g |

### 2. Evaluation of plate-making (evaluation of developing property)

The obtained lithographic printing plate precursor A was subjected to image exposure with Trendsetter 3244VX (manufactured by Creo Products Incorporated) loading a water-cooling type 40 W infrared semiconductor laser on the conditions of output of 9 W, external drum rotating speed of 210 rpm, and resolution of 2,400 dpi. Lithographic printing plate precursor B was subjected to image exposure with a 405 nm semiconductor laser of output of 30 mW, on the condition of energy density of 0.5 mJ/cm² and resolution of 2,400 dpi.

Lithographic printing plate precursors A and B were development processed with an automatic developing processor as shown in Fig. 1. The liquid temperature of aqueous solution 107 was maintained at 25°C, and the driving speed of carrying rollers was set so that the passing time required for lithographic printing plate precursors A and B to be carried in from carrying roller pair 108 at the entrance of developing tank 106 until being carried out from carrying roller pair 108 at the exit of developing tank 106 was 12 seconds. A member turning on the rotation axis was used as rubbing member 112 and the direction of rotation was set so as to drive in the forward direction to the carrying direction. The outside diameter of rubbing member 112 was ϕ50 mm. Lithographic printing plate precursors A and B carried out from developing tank 106 were dried with a drier not shown.

In Table 1 are shown the state of contamination in the processors and the states of generation of scum on the printing plates by the developing system in Example 1 of the invention where a reservoir of an aqueous solution was provided and the lithographic printing plate precursor was subjected to immersion processing, and by the conventional horizontal transporting system where a reservoir was not provided.

**TABLE 1**

| Evaluation of Processing by Development Type (running processing test) | | | |
|---|---|---|---|
| | Development Type | Contamination in Processor | Generation of Scum on Printing Plate |
| Example 1 | Immersion type | A | A |
| Comparative Example 1 | Horizontal transporting type | B | B |

| | | | |
|---|---|---|---|
| Contamination in Processor A: No Contamination, B: Contamination Generation of Scum on Printing Plate A: No Scum, B: Scum | | | |

It can be seen from the results shown in Table 1 that the inside of the processor was not contaminated according to immersion system of Example 1 and scum were not generated on the plate. Contrary to this, contamination in the processor and generation of scum were inferior. This results were also the same in the case where lithographic printing plate precursor C was used.

Table 2 shows the test results with respect to the time required from the immersion in the aqueous solution until rubbing with the brush, the rubbing position with the brush, and the developability of the lithographic printing plate precursor in immersion type developing system in Example 1 of the invention provided with a reservoir.

Example 2 was a case where the time required from the lithographic printing plate precursor was immersed in the aqueous solution until rubbing with the brush was performed was set at 5 sec, Example 3 was a case where the time required until rubbing was set at 2 sec, Example 4 was the same with Example 3 but it was a case where the aqueous solution was contacted with the lithographic printing plate precursor with spray tube 1 before immersion, and Comparative Example 2 was a case where the time required until rubbing with the brush was shortened to 1 sec. Brush used was one in every case, and the installed position was the center of the bottom of the reservoir. In Example 5, the time until rubbing with the brush was 3.5 sec and the position of the brush was changed from the center of the bottom to the latter half point in the carrying direction of the lithographic printing plate precursor. In Comparative Example 3, the time until rubbing with the brush was 1 sec, and the position of the brush was changed from the center of the bottom to the first half point in the carrying direction of the lithographic printing plate precursor.

In Example 6, two brushes were used. The first brush was installed at the first half point in the carrying direction of the lithographic printing plate precursor from the center of the bottom, accordingly the time until rubbing with the brush was 1 sec, and the second brush was installed at the latter half point in the carrying direction of the lithographic printing plate precursor from the center of the bottom, accordingly the time until rubbing with the brush was 3 sec.

**TABLE 2**

| Processing conditions in immersion development processing and Performance in Practice | | | | |
|---|---|---|---|---|
| | Time from Immersion in Aqueous Solution to Rubbing with Brush | Position of Brush | Contact with Aqueous Solution with Spray Tube 1 before Immersion | Rest Results |
| Example 2 | 5 sec | Center | No | A: Good |
| Example 3 | 2 sec | Center | No | B: Allowable |
| Example 4 | 2 sec | Center | Yes | A: Good |
| Comparative Example 2 | 1 sec | Center | No | C: Development Defect |
| Example 5 | 3.5 sec | Latter | No | A: Good |
| Comparative Example 3 | 1 sec | Former | No | C: Development Defect |
| Example 6 | Two brushes (former brush, 1 sec/latter brush, 3 sec) | Former/Latter | No | A: Good |

It is seen from the results in Table 2 that the time until rubbing with a brush is effective for development, and a satisfactory result cannot be obtained with 1 second. Therefore, it is preferred to set the position of a brush at the center of the bottom of the reservoir, or at the latter half point in the carrying direction of the lithographic printing plate precursor for taking the time of 2 sec or more from the immersion to rubbing with a brush. Further, by bringing a lithographic printing plate precursor into contact with an aqueous solution before immersion, development processing can be further effectively performed. This results were also the same in the case where lithographic printing plate precursor C was used.

Table 3 shows the rest results on the adhesion of scum on the plate in the case where the aqueous solution was additionally sprayed on the lithographic printing plate precursor with spray tube 2 after immersion was finished in the immersion type development system in Example 3 of the invention where a reservoir was provided. That is, Example 3 was a case where the time from the lithographic printing plate precursor was immersed in the aqueous solution until rubbing with the brush was performed was set at 3 sec, Example 7 was the same with Example 3 but it was a case where a fresh solution was sprayed on the lithographic printing plate precursor with spray tube 2 after immersion, and Example 8 was a case where a fatigued solution which was the same as the solution in the reservoir was with spray tube 2. This results were also the same in the case where lithographic printing plate precursor C was used.

**TABLE 3**

| Evaluation of Processing with or without Spray 2 (processing test with a fatigued solution) | | | |
|---|---|---|---|
| | Spray after Immersion | Sprayed Solution | Adhesion of Scum |
| Example 7 | Yes | Fresh | A |
| Example 8 | Yes | Fatigued (same with the solution in reservoir) | B |
| Example 3 | No | - | C (allowable) |

| | | | |
|---|---|---|---|
| A: Adhesion of scum is considerably prevented. B: Adhesion of scum is prevented. C: Adhesion of scum is allowable. | | | |

It can be understood from the results in Table 3 that Example 3 was allowable in adhesion of scum, but the adhesion could be considerably prevented by the spraying of the fresh solution (almost fresh) from spray tube 2 after immersion according to Example 7, and adhesion could be prevented according to Example 8, although not so much as in Example 7.

This results were also the same in the case where lithographic printing plate precursor C was used.

### Confirmation of printing plate performance by preheating:

The invention is also effective in the plate-making method where preheating is introduced. A plate-making method having a preheat process is described below. As test 1 and test 2, lithographic printing plate precursors A to C were used, and the obtained results were the same.

### Preheat test 1:

After image exposure, a lithographic printing plate precursor was put in an oven within 30 seconds, and the entire surface of the lithographic printing plate precursor was heated by blowing hot air at 110°C and retained for 15 seconds. After that, each lithographic printing plate precursor was subjected to the above image exposure, development and printing except that development was performed within 30 seconds from preheating.

As for Examples 1 to 7, the effect of the invention could be sufficiently obtained as a result of applying preheating (refer to Table 4).

Further, in the systems providing preheating, sensitivity became 0.05 mJ/cm², and safelight aptitude was good without generating fog.

### Preheat test 2:

A plate-making method of providing a heating unit in the rear of the exposure unit is described.

Lithographic printing plate precursor (1) was subjected to image exposure with Violet semiconductor laser plate setter Vx9600 (loading InGaN system semiconductor laser, emission 405 nm ± 10 nm /output 30 mW, manufactured by Fuji Film Electronic Imaging Ltd.). Plain dot of 35% was imaged by the quantity of printing plate exposure of 0.09 mJ/cm² and the resolution of the image of 2,438 dpi with FM screen (TAFFETA® 20, manufactured by Fuji Photo Film Co., Ltd.). The lithographic printing plate precursor after exposure was imagewise exposed and, within 30 seconds, subjected to development processing with an automatic developing processor LP1250PLX (manufactured by Fuji Photo Film Co., Ltd.). The automatic developing processor consisted in order of heating unit/washing unit/developing unit/rinsing unit/finishing unit, and heating condition in the heating unit was 100°C, 10 seconds. All the tanks of washing unit, developing unit, rinsing unit, and finishing unit were charged with the developing solution. The temperature of the developing solution was 28°C, and the lithographic printing plate was carried at carrying rate of 110 cm/min. After that, the above development and printing were performed.

Similarly to the results of preheat test 1, the effect of the invention was obtained even when preheat was provided, and sensitivity became 0.05 mJ/cm² by performing heating treatment. Safelight aptitude was good without generating fog.

After development, the non-image area and the image area of the lithographic printing plate were visually observed. The photosensitive layer in the non-image area was completely removed and uniform plain dots were formed (processing property). When the lithographic printing plate was used in printing according to the above printing condition, good printed matter containing uniform plain dots and free from soiling of the non-image area was obtained (printing property). (Refer to Table 4.)

**TABLE 4**

| Result of Experiment in Case of Using Pre-heat | | | | | |
|---|---|---|---|---|---|
| Mode of Development | Mode of Preheat | Contamination in Processor | Adhesion of Scum on Plate | Processing Property | Printing Property |
| Example 1 | Test 2 | No Contamination | No Adhesion | Good | Good |
| Example 2 | Test 2 | No Contamination | No Adhesion | Good | Good |
| Example 3 | Test 2 | No Contamination | No Adhesion | Good | Good |
| Example 4 | Test 2 | No Contamination | No Adhesion | Good | Good |
| Example 5 | Test 2 | No Contamination | No Adhesion | Good | Good |
| Example 6 | Test 2 | No Contamination | No Adhesion | Good | Good |
| Example 7 | Test 2 | No Contamination | No Adhesion | Good | Good |
| Example 1 | Test 1 | No Contamination | No Adhesion | Good | Good |
| Example 2 | Test 1 | No Contamination | No Adhesion | Good | Good |
| Example 4 | Test 1 | No Contamination | No Adhesion | Good | Good |
| Example 6 | Test 1 | No Contamination | No Adhesion | Good | Good |
| Example 7 | Test 1 | No Contamination | No Adhesion | Good | Good |

As can be seen from the results in Table 4, by performing development with an aqueous solution having pH 4.3 as aqueous solution 107, the image-recording layers in the non-image area of both of lithographic printing plate precursors A and B were completely removed and good developing property was obtained in every of Examples 1 to 7.). When these lithographic printing plated were used in printing, good printed matter containing uniform plain dots good printed matters could be obtained.

The invention can manufacture a lithographic printing plate of constant quality and not causing the problems of contamination in an automatic developing processor and generation of scum. The invention can also provide a manufacturing method and a manufacturing apparatus of the lithographic printing plate capable of realizing running cost down by the reduction of the replenishing amount of an aqueous solution and the amount of waste solution by the simplification of system, and further, which is also environmentally advantageous.

## Claims

1. A method of manufacturing a lithographic printing plate, which comprises:
(i) imagewise exposing a lithographic printing plate precursor (LPPP) comprising
- a support and
- a radical polymerizable image-recording layer containing a hydrophobic binder polymer, a polymerization initiator and a polymerizable compound;
(ii) immersing the exposed LPPP in a development processing tank that has a reservoir (R) of a first aqueous solution (S1) having a pH of 4-8; and
(iii) after the lapse of ≥ 2 s after step (ii), removing the non-image area of the image-recording layer by rubbing the non-image area with at least one rubbing member including at least two rubbing brushes immersed in the reservoir (R); and
(iv) performing a desensitizing treatment simultaneously with step (iii).

2. The method of claim 1, wherein step (iii) is carried out at least at intermediate or a latter half of a time when the LPPP is immersed in the reservoir (R).

3. The method of claim 1 or 2, wherein the surface of the LPPP having the image-recording layer is contacted with the first solution (S1) prior to the immersion in the reservoir (R).

4. The method of any of claims 1-3, wherein the LPPP coming from the reservoir (R) after the immersion development processing is sprayed with a second aqueous solution (S2) which is less fatigued than the first solution (S1) used in immersion treatment wherein the second solution (S2) is either fresh replenisher for the first solution (S1) or is the first solution (S1) containing some fresh replenisher.

5. The method of any of claims 1-4, wherein the first solution (S1) contains at least a nonionic surfactant and/or an anionic surfactant in a concentration of ≥ 1 wt.-%.

6. The method of claim 5, wherein the first solution (S1) contains a water-soluble polymer.

7. The method of any of claims 1-6, wherein the image-recording layer further comprises microcapsules encapsulating at least a part of the components contained in this layer.

8. The method of any of claims 1-7, wherein the LPPP is imagewise exposed with laser emitting ray in the wavelength range of 760-1,200 nm.

9. The method of any of claims 1-7, wherein the LPPP is imagewise exposed with laser emitting ray in the wavelength range of 250-420 nm.

10. The method of any of claims 1-9, wherein the first solution (S1) is an aqueous solution containing a surfactant and a water-soluble polymer.

11. The method of any of claims 1-10, wherein the hydrophobic binder polymer is an acrylic resin having a polyoxyethyl group.

12. The method of any of claims 1-11, wherein the LPPP further comprises on the support an undercoat layer containing a compound having a support-adsorptive group and a polymerizable group.

## Patentansprüche

1. Verfahren zur Herstellung einer Lithographiedruckplatte, welches umfasst:
(i) bildweises Belichten eines Lithographiedruckplattenvorläufers (LPPP), umfassend
- einen Träger und
- eine radikalisch polymerisierbare Bildaufzeichnungsschicht, die ein hydrophobes Bindepolymer, einen Polymerisationsinitiator und eine polymerisierbare Verbindung enthält;
(ii) Eintauchen des belichteten LPPP in einen Entwicklungsverarbeitungstank, der ein Reservoir (R) einer ersten wässrigen Lösung (S1) mit einem pH-Wert von 4 bis 8 aufweist; und
(iii)nach dem Ablauf von ≥ 2 s nach dem Schritt (ii), Entfernen des Nicht-Bildbereichs der Bildaufzeichnungsschicht durch Reiben des Nicht-Bildbereichs mit zumindest einem Reibeelement, umfassend mindestens 2 Reibebürsten, die in das Reservoir (R) eingetaucht sind; und
(iv) Durchführen einer Desensibilisierungsbehandlung simultan mit dem Schritt (iii).

2. Verfahren gemäß Anspruch 1, worin der Schritt (iii) zumindest zur Mitte oder in der späteren Hälfte der Zeit durchgeführt wird, wenn der LPPP in das Reservoir (R) eingetaucht ist.

3. Verfahren gemäß Anspruch 1 oder 2, worin die Oberfläche des LPPP, die die Bildaufzeichnungsschicht aufweist, vor dem Eintauchen in das Reservoir (R) in Kontakt mit der ersten Lösung (S1) gebracht wird.

4. Verfahren gemäß irgendeinem der Ansprüche 1 bis 3, worin der LPPP, der nach der Eintauch-Entwicklungsverarbeitung aus dem Reservoir (R) kommt, mit einer zweiten wässrigen Lösung (S2) besprüht wird, die weniger aufgebraucht ist als die erste Lösung (S1), die in der Eintauchbehandlung verwendet wird, worin die zweite Lösung (S2) entweder eine frische Nachfülllösung für die erste Lösung (S1) oder die erste Lösung (S1), die teilweise etwas frische Nachfülllösung enthält, ist.

5. Verfahren gemäß irgendeinem der Ansprüche 1 bis 4, worin die erste Lösung (S1) mindestens ein nichtionisches Tensid und/oder ein anionisches Tensid in einer Konzentration von ≥ 1 Gewicht% enthält.

6. Verfahren gemäß Anspruch 5, worin die erste Lösung (S1) ein wasserlösliches Polymer enthält.

7. Verfahren gemäß irgendeinem der Ansprüche 1 bis 6, worin die Bildaufzeichnungsschicht ferner Mikrokapseln umfasst, die mindestens einen Teil der Komponenten einkapseln, die in dieser Schicht enthalten sind.

8. Verfahren gemäß irgendeinem der Ansprüche 1 bis 7, worin der LPPP bildweise mit einem Laser belichtet wird, der Strahlen im Wellenlängenbereich von 760 bis 1.200 nm emittiert.

9. Verfahren gemäß irgendeinem der Ansprüche 1 bis 7, worin der LPPP bildweise mit einem Laser belichtet wird, der Strahlen im Wellenlängenbereich von 250 bis 420 nm emittiert.

10. Verfahren gemäß irgendeinem der Ansprüche 1 bis 9, worin die erste Lösung (S1) eine wässrige Lösung ist, die ein Tensid und ein wasserlösliches Polymer enthält.

11. Verfahren gemäß irgendeinem der Ansprüche 1 bis 10, worin das hydrophobe Bindepolymer ein Acrylharz mit einer Polyoxyethylgruppe ist.

12. Verfahren gemäß irgendeinem der Ansprüche 1 bis 11, worin der LPPP ferner auf dem Träger eine Unterzugsschicht umfasst, die eine Verbindung mit einer an den Träger absorptiven Gruppe und einer polymerisierbaren Gruppe enthält.

## Revendications

1. Procédé de fabrication d'une plaque d'impression lithographique, qui comprend:
(i) l'exposition sous forme d'image d'un précurseur de plaque d'impression lithographique (LPPP) comprenant
- un support et
- une couche d'enregistrement d'image polymérisable par voie radicalaire contenant un polymère liant hydrophobique, un initiateur de polymérisation et un composé polymérisable;
(ii) l'immersion du précurseur de plaque d'impression lithographique dans une cuve de développement qui a un réservoir (R) d'une première solution aqueuse (S1) ayant un pH de 4-8; et
(iii) après l'écoulement de ≥ 2 s après l'étape (ii), l'élimination de la zone sans image de la couche d'enregistrement d'image en frottant la zone sans image avec au moins un membre de frottement comportant au moins deux brosses de frottement immergées dans le réservoir (R); et
(iv) la réalisation d'un traitement de désensibilisation simultanément avec l'étape (iii).

2. Le procédé de la revendication 1, dans lequel l'étape (iii) est effectuée au moins à un temps intermédiaire ou dans la deuxième moitié d'un temps lorsque le précurseur de plaque d'impression lithographique est immergé dans le réservoir (R).

3. Le procédé de la revendication 1 ou 2, dans lequel la surface du précurseur de plaque d'impression lithographique est mise en contact avec la première solution (S1) avant l'immersion dans le réservoir (R).

4. Le procédé de l'une quelconque des revendications 1 à 3, dans lequel le précurseur de plaque d'impression lithographique venant du réservoir (R) après l'immersion de développement est pulvérisé avec une seconde solution aqueuse (S2) qui est moins fatiguée que la première solution (S1) utilisée dans le traitement d'immersion dans laquelle la deuxième solution (S2) est soit du régénérateur frais pour la première solution (S1), ou est la première solution (S1) contenant du régénérateur frais.

5. Le procédé de l'une quelconque des revendications 1-4, dans lequel la première solution (S1) contient au moins un tensioactif non ionique et/ou un tensioactif anionique dans une concentration de ≥ 1 % en poids.

6. Le procédé de la revendication 5, dans lequel la première solution (S1) contient un polymère soluble dans l'eau.

7. Le procédé de l'une quelconque des revendications 1-6, dans lequel la couche d'enregistrement d'image comprend en outre des microcapsules encapsulant au moins une partie des composants contenus dans cette couche.

8. Le procédé de l'une quelconque des revendications 1-7, dans lequel le précurseur de plaque d'impression lithographique est exposé sous forme d'image avec un laser émettant un rayon dans le domaine de longueur d'onde de 760-1200 nm.

9. Le procédé de l'une quelconque des revendications 1-7, dans lequel le précurseur de plaque d'impression lithographique est exposé sous forme d'image avec un laser émettant un rayon dans un domaine de longueur d'onde de 250-420 nm.

10. Le procédé de l'une quelconque des revendications 1-9, dans lequel la première solution (S1) est une solution aqueuse contenant un tensioactif et un polymère soluble dans l'eau.

11. Le procédé de l'une quelconque des revendications 1-10, dans lequel le polymère liant hydrophobique est une résine acrylique ayant un groupe polyoxyéthyle.

12. Le procédé de l'une quelconque des revendications 1-11, dans lequel le précurseur de plaque d'impression lithographique comprend en outre sur le support une couche de sous-revêtement contenant un composé ayant un groupe support-absorbant et un groupe polymérisable.
